(19)

**Europäisches Patentamt**
**European Patent Office**
**Office européen des brevets**

(11) **EP 4 778 899 A2**

(12) **EUROPEAN PATENT APPLICATION**

(43) Date of publication:
**22.07.2026 Bulletin 2026/30**

(21) Application number: **26181331.5**

(22) Date of filing: **05.12.2023**

(51) International Patent Classification (IPC):
***C03C 17/30*** *(2006.01)*

(52) Cooperative Patent Classification (CPC):
**C03C 17/002; C03C 17/245; C03C 17/30;**
C03C 2217/213; C03C 2217/76; C03C 2218/151;
C03C 2218/32

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**

(30) Priority: **08.12.2022 US 202263431065 P**
**15.11.2023 US 202363598993 P**

(62) Document number(s) of the earlier application(s) in
accordance with Art. 76 EPC:
**23837889.7 / 4 630 380**

(71) Applicant: **Corning Incorporated**
**Corning, New York 14831 (US)**

(72) Inventors:
- **ADIB, Kaveh**
  **Corning, 14830 (US)**
- **BELLMAN, Robert Alan**
  **Ithaca, 14850 (US)**
- **BROWN, Philip Simon**
  **Big Flats, 14814 (US)**

- **CHANG, Theresa**
  **Painted Post, 14870 (US)**
- **MAHONEY FAHEY, Christine Marie**
  **Corning, 14830 (US)**
- **MASTROPIETRO, Dean Joseph**
  **Corning, 14830 (US)**
- **PRICE, James Joseph**
  **Corning, 14830 (US)**
- **YUAN, Shu**
  **Horseheads, 14845 (US)**

(74) Representative: **Elkington and Fife LLP**
**Prospect House**
**8 Pembroke Road**
**Sevenoaks, Kent TN13 1XR (GB)**

Remarks:
This application was filed on 27.05.2026 as a
divisional application to the application mentioned
under INID code 62.

(54) **COATED ARTICLES WITH AN ANTI-FINGERPRINT COATING OR SURFACE-MODIFYING LAYER AND METHODS OF MAKING THE SAME**

(57) Coated articles are described herein that include a surface-modifying layer that is fluorine-free. In aspects, the surface-modifying layer comprises a partial silica-like network having a ratio of Si-O-Si bonds to Si atoms in the anti-fingerprint coating from about 2 to about 3. Additionally or alternatively, the surface-modifying layer further comprises an alkyl silane at the exterior surface and bonded to a Si-O group in the silica-like network. Methods include evaporating a functionalized polyhedral oligomeric silsesquioxane onto a first major surface. Methods include impinging an ion beam on the first major surface. Alternatively, methods include disposing and heating a solution comprising a polysilazane or a polyhedral oligomeric silsesquioxane on a first major surface. In aspects, methods include reacting material at the first major surface with a alkyl silane.

FIG. 1

## Description

### CLAIM OF PRIORITY

This application claims the benefit of priority under 35 U.S.C. § 119 of U.S. Provisional Application No. 63/598,993 filed November 15, 2023 and claims the benefit of priority under 35 U.S.C. § 119 of U.S. Provisional Application No. 63/431,065 filed December 8, 2022. The entire contents of each of these applications are hereby incorporated herein by reference for all purposes.

### FIELD

The present disclosure relates generally to coated articles with a surface-modifying layer (e.g., an anti-fingerprint coating) and methods of making the same and, more particularly, to coated articles comprising a surface-modifying layer (e.g., an anti-fingerprint coating) that is fluorine-free and methods of making coated articles.

### BACKGROUND

Glass, glass-ceramic, and ceramic materials are commonly used in various consumer electronic products including display devices, for example, liquid crystal displays (LCDs), electrophoretic displays (EPD), organic light-emitting diode displays (OLEDs), plasma display panels (PDPs), or the like. For example, chemically strengthened glass is favored for many touch-screen products, including cell phones, music players, e-book readers, notepads, tablets, laptop computers, automatic teller machines, and other similar devices. Many of these glass, glass-ceramic, and ceramic materials are also employed in displays and display devices of consumer electronic products that do not have touch-screen capability but are prone to direct human contact, including desktop computers, laptop computers, elevator screens, equipment displays, and others. Glass, glass-ceramic, and ceramic materials are often treated to provide aesthetic and functional characteristics based on the enduse application of the material. For example, anti-reflective, anti-glare, and anti-fingerprint treatments are common treatments used on materials used in touch-screen products.

The durability of some types of treatments, such as an anti-fingerprint coating, can be limited, especially when used in combination with other treatments, for example an anti-reflective coating. Material choices for anti-fingerprint treatments and/or an easy-to-clean (ETC) treatments typically rely on the ability of the treatment materials on the surface to repel material, for example, such as water, dust, and environmental debris including sebum, oils, and proteins. Anti-fingerprint and/or ETC treatments experience wear over time, such as from repeated touching, swiping, cleaning, etc. during use that can affect the ability of the surface of the anti-fingerprint and/or ETC treatment to maintain the ability to repel material. It is known to use fluorinated silanes, for example fluoroethersilanes, which can bind to the surface as a monolayer or multilayer, to form coatings with a thickness from 2 nm to 5 nm. Once this nanoscale coating is abraded away, the surface no longer exhibits repellant properties.

Consequently, there is a need for a new surface-modifying layer (e.g., anti-fingerprint coating) that can be used with glass, glass-ceramic, and/or ceramic articles with improved abrasion resistance and/or that can be used in conjunction with other treatments, for example, an anti-reflective coating. This need and others are addressed by the present disclosure.

### SUMMARY

There are set forth herein coated articles, surface-modifying layers (e.g., anti-fingerprint coatings), and methods of making the same. The surface-modifying layer (e.g., anti-fingerprint coating) can reduce a visibility and/or color shift associated with disposing a fingerprint thereon. Providing a low total surface energy (including a low dispersive surface energy and/or a low polar surface energy) of the surface-modifying layer (e.g., anti-fingerprint coating) can enable oils (e.g., fingerprint oil) to be dispersed across the anti-fingerprint surface (e.g., oleophilic), which can decrease a visibility and/or a color shift associated with fingerprints. For example, providing an alkyl silane can reduce a surface energy (e.g., total, dispersive, polar) of the surface-modifying layer (e.g., anti-fingerprint coating), which can enable the surface-modifying layer (e.g., anti-fingerprint coating) to be oleophilic. Providing a low hexadecane contact angle (e.g., about 30° or less) and/or a low diiodomethane contact angle (e.g., about 60° or less) can reduce the visibility and/or color shift associated with fingerprints by enabling fingerprint oil to be dispersed across the surface-modifying (e.g., anti-fingerprint coating) rather than beading up into pronounced droplets. Providing a high water contact angle (e.g., about 100° or more) can enhance the removal of aqueous material (e.g., water droplets, sweat droplets) from the surface-modifying (e.g., anti-fingerprint coating). Consequently, the surface-modifying (e.g., anti-fingerprint coating) can be hydrophobic and oleophilic.

Providing a surface-modifying layer (e.g., an anti-fingerprint coating) in accordance with the aspects of the disclosure can exhibit good abrasion resistance (e.g., an abraded water contact angle of about 90° or more after 2,000 cycles, 3,000 cycles, and/or 3,500 cycles in a Steel Wool Abrasion Test, a cheesecloth-abraded water contact angle of about 90° after 200,000 cycles in a Cheesecloth Abrasion Test), for example, maintaining a hydrophobic and/or oleophilic character. The surface-modifying layer (e.g., anti-fingerprint coating) can exhibit good adhesion to the surface that is disposed on, for example, a surface of a substrate or an optical stack. Providing a thickness of the surface-modifying layer (e.g., anti-fingerprint coating) from about 100 nm to 600 nm or from 1 nm to 75 nm can increase a durability of the surface-modifying layer (e.g., anti-fingerprint coating).

In aspects, forming the surface-modifying layer (e.g., anti-fingerprint coating) can comprise evaporating a functionalized POSS onto a substrate and impinging the substrate with an ion beam. Properties of the coating can be controlled by the discharge current of the ion beam. For a KRI EH-400 End-Hall ion source in a Angstrom Evovac chamber operating at 100V, providing a discharge current of about 0.25 A or more can facilitate the formation of the coating, for example, producing an ion beam with sufficient energy to cause the functionalized POSS to react with other functionalized POSS and/or the first major surface of the substrate at an appreciable rate (e.g., compared to lower discharge currents). Providing a discharge current of about 1 A or less to the ion beam source facilitates deposition of a condensed POSS material. The ion beam discharge can facilitate condensation of the functionalized POSS converting at least a portion of the cage structure of the functionalized POSS to a partial Si-O-Si network. Functionalized POSS is evaporated and subjected to ion beam to create partially condensed silica-like network at or near room temperature. Alternatively, the substrate that the thermally evaporated functionalized POSS condenses on and the ion beam impinges can be heated. Substrate temperature during POSS deposition is 250°C or less, 200°C or less, 100°C or less, or preferably 50°C or less. Alternatively, the partially condensed structure could be heated 400°C to 700°C to create a dense, high modulus silica-like network, but that would lead to poor abrasion performance. Consequently, providing a maximum temperature (e.g., through the evaporating of the functionalized POSS, impingement with the ion-beam, and subsequent functionalization with a silane) of about 250°C or less (e.g., about 220°C or less, about 200°C or less, about 180°C or less, or about 160°C or less) to obtain the surface-modifying layer (e.g., anti-fingerprint coating) with good abrasion resistance.

The surface-modifying layer (e.g., anti-fingerprint coating) can be formed by treating the partially condensed silica-like network with an alkyl silane, which can be done in-situ (i.e., in the same chamber as the POSS deposition) or in a second chamber. The partially condensed silica-like network can be exposed to vapors of the alkyl silane at elevated temperature (e.g., from about 100°C to about 200°C). Before treatment with the silane (e.g., alkyl silane), the partially condensed silica-like network can optionally be subjected to plasma activation of the surface in an O2, air, or Ar plasma. Silane evaporation can be at atmospheric pressure or under reduced pressure. Alternatively, the silane can be applied to the partially condensed silica-like network as a solution (e.g., dip coating). Plasma activation can be performed at atmospheric pressure or under reduced pressure. Reacting an initial coating with a methoxy silane, a chlorosilane, a trialkoxy silane, a trichlorosilane, or combinations thereof (e.g., dichloromethyoxy silane, chlorodithmethoxy silane) silane can ensure that the silane is well-bonded to the initial coating and enable low surface energy (e.g., total surface energy or about 30 mN/m or less, polar surface energy of about 5 mN/m or less).

As discussed below in the Examples, it has been discovered that surface-modifying layers (e.g., anti-fingerprint coatings) in accordance with the present disclosure having an elastic modulus from about 9 GPa to about 41 GPa possess unexpectedly improved abrasion resistance. Providing a partial silica-like network can enable the surface-modifying layer (e.g., anti-fingerprint coating) to be stiff (e.g., elastic modulus of about 9 GPa or more) while remaining flexible enough to withstand abrasion. Also, as demonstrated by the results of the Steel Wool Abrasion Test, the Rubber Abrasion Test, and the Cheesecloth Abrasion Test, the surface-modifying layer (e.g., anti-fingerprint coatings) of the present disclosure can withstand abrasion and maintain good contact angles. Providing a fluorine-free surface-modifying layer (e.g., fluorine-free anti-fingerprint coating) can be cheaper to produce and/or more environmentally friendly.

The substrate can comprise a glass-based, a glass-ceramic, and/or ceramic-based material, which can provide good dimensional stability, good impact resistance, and/or good puncture resistance. The glass-based, glass-ceramic, and/or ceramic-based substrate can comprise one or more compressive stress regions, which can further provide increased impact resistance and/or increased puncture resistance.

Some example aspects of the disclosure are described below with the understanding that any of the features of the various aspects may be used alone or in combination with one another.

Aspect 1. A coated article comprising:

a substrate comprising a first major surface;
an anti-fingerprint coating disposed on the first major surface, the anti-fingerprint coating comprising an exterior surface of the coated article, the anti-fingerprint coating comprising a thickness from about 10 nanometers to about 600 nanometers, the anti-fingerprint coating comprises a partial silica-like network having a ratio of Si-O-Si bonds to Si atoms in the anti-fingerprint coating is from about 2 to about 3, and the anti-fingerprint coating is fluorine-free.

Aspect 2. The coated article of aspect 1, wherein the anti-fingerprint coating comprises a refractive index ranging from about 1.38 to about 1.55.

Aspect 3. The coated article of any one of aspects 1-2, wherein the anti-fingerprint coating comprises an elastic modulus ranging from about 9 GigaPascals to about 70 GigaPascals.

Aspect 4. The coated article of any one of aspects 1-3, wherein the anti-fingerprint coating further comprises an alkyl silane at the exterior surface and bonded to Si-O groups in the anti-fingerprint coating.

Aspect 5. The coated article of aspect 4, wherein the alkyl silane comprises a $C_4$-$C_{34}$ alkyl group.

Aspect 6. The coated article of any one of aspects 4-5, wherein the alkyl silane comprises an iso-octylsilane, a dodecylsilane, an octadecylsilane, or combinations thereof.

Aspect 7. The coated article of any one of aspects 4-5, wherein the anti-fingerprint coating further comprises nitrogen atoms bonded to silicon atoms.

Article 8. The coated article of any one of aspects 1-7, wherein the anti-fingerprint coating comprises either silicon hydrides or silanols.

Aspect 9. The coated article of any one of aspects 1-8, further comprising an anti-reflective coating positioned between the anti-fingerprint coating and the substrate.

Aspect 10. The coated article of any one of aspects 1-8, further comprising a gradient coating comprising a refractive index gradient positioned between the anti-fingerprint coating and the substrate.

Aspect 11. The coated article of any one of aspects 1-10, wherein the anti-fingerprint coating comprises a diiodomethane contact angle of about 60° or more.

Aspect 12. The coated article of any one of aspects 1-11, wherein the anti-fingerprint coating comprises an abraded water contact angle of about 90° after being abraded for 2,000 cycles in a Steel Wool Abrasion Test.

Aspect 13. The coated article of any one of aspects 1-12, wherein the anti-fingerprint coating comprises a water contact angle of about 100° or more.

Aspect 14. The coated article of any one of aspects 1-13, wherein the anti-fingerprint coating wets hexadecane or comprises a hexadecane contact angle of about 30° or less.

Aspect 15. The coated article of any one of aspects 1-14, wherein the anti-fingerprint coating comprises a polar surface energy of about 3 milliNewtons per meter (mN/m) or less.

Aspect 16. The coated article of any one of aspects 1-15, wherein the anti-fingerprint coating comprises a total surface energy of about 30 milliNewtons per meter (mN/m) or less.

Aspect 17. The coated article of any one of aspects 1-16, wherein the anti-fingerprint coating comprises a cheesecloth-abraded water contact angle of about 90° or more after being subjected to 200,000 cycles in a Cheesecloth Abrasion Test.

Aspect 18. The coated article of any one of aspects 1-17, wherein the substrate comprises a glass-based material, a glass-ceramic material, or a ceramic-based material. In exemplary aspects, the glass-based material, the glass-ceramic material, or the ceramic-based material is transparent, colored transparent, opaque, colored opaque, translucent, or colored translucent.

Aspect 19. A coated article comprising:

a substrate comprising a first major surface; and
an anti-fingerprint coating disposed on the first major surface, the anti-fingerprint coating comprising an exterior surface of the coated article, the anti-fingerprint coating comprises a thickness from about 10 nanometers to about 600 nanometers, the anti-fingerprint coating comprising a partial silica-like network and either silicon hydrides or silanols, and the anti-fingerprint coating is fluorine-free.

Aspect 20. The coated article of aspect 19, wherein the anti-fingerprint coating comprises an elastic modulus ranging from about 9 GigaPascals to about 70 GigaPascals.

Aspect 21. The coated article of any one of aspects 19-20, wherein the anti-fingerprint coating comprises a refractive index from about 1.38 to about 1.55.

Aspect 22. The coated article of any one of aspects 19-21, wherein the anti-fingerprint coating further comprises nitrogen atoms bonded to silicon atoms.

Aspect 23. The coated article of any one of aspects 19-22, wherein the anti-fingerprint coating further comprises an alkyl silane at the exterior surface and bonded to Si-O groups in the anti-fingerprint coating.

Aspect 24. The coated article of aspect 23, wherein the alkyl silane comprises a $C_4$-$C_{34}$ alkyl group.

Aspect 25. The coated article of any one of aspects 23-24, wherein the alkyl silane comprises an iso-octylsilane, a dodecylsilane, an octadecylsilane, or combinations thereof.

Aspect 26. The coated article of any one of aspects 19-25, further comprising an anti-reflective coating positioned between the anti-fingerprint coating and the substrate.

Aspect 27. The coated article of any one of aspects 19-26, further comprising a gradient coating comprising a refractive index gradient positioned between the anti-fingerprint coating and the substrate.

Aspect 28. The coated article of any one of aspects 19-27, wherein the anti-fingerprint coating comprises a diiodomethane contact angle of about 60° or more.

Aspect 29. The coated article of any one of aspects 19-28, wherein the anti-fingerprint coating comprises an abraded water contact angle of about 90° after being abraded for 2,000 cycles in a Steel Wool Abrasion Test.

Aspect 30. The coated article of any one of aspects 19-29, wherein the anti-fingerprint coating comprises a water contact angle of about 100° or more.

Aspect 31. The coated article of any one of aspects 19-30, wherein the anti-fingerprint coating wets hexadecane or comprises a hexadecane contact angle of about 30° or less.

Aspect 32. The coated article of any one of aspects 19-31, wherein the anti-fingerprint coating comprises a polar surface energy of about 3 milliNewtons per meter (mN/m) or less.

Aspect 33. The coated article of any one of aspects 19-32, wherein the anti-fingerprint coating comprises a total surface energy of about 30 milliNewtons per meter (mN/m) or less.

Aspect 34. The coated article of any one of aspects 19-33, wherein the anti-fingerprint coating comprises a cheesecloth-abraded water contact angle of about 90° or more after being subjected to 200,000 cycles in a Cheesecloth Abrasion Test.

Aspect 35. The coated article of any one of aspects 19-34, wherein the anti-fingerprint coating further comprises at least one of:

about 50% to about 90% of silicon atoms are in a silica-like network; or
a ratio of Si-O-Si bonds to Si atoms is from about 2 to about 3.

Aspect 36. The coated article of any one of aspects 19-35, wherein the substrate comprises a glass-based material, a glass-ceramic material, or a ceramic-based material. In exemplary aspects the glass-based material, the glass-ceramic material, or the ceramic-based material is transparent, colored transparent, opaque, colored opaque, translucent, or colored translucent.

Aspect 37. A method of forming a coated article comprising:

evaporating a functionalized polyhedral oligomeric silsesquioxane onto a first major surface of a substrate;
impinging an ion beam on the first major surface of the substrate, the impinging occurs in a chamber comprising a chamber pressure ranging from about $10^{-4}$ Pascal to about 1 Pascal, and the impinging coverts from about 50% to about 90% of the silicon atoms in a cage structure of the functionalized polyhedral oligomeric silsesquioxane to a partial Si-O-Si network; and then
reacting material at the first major surface of the substrate with an alkyl silane to form an anti-fingerprint coating, the alkyl silane comprising 4 or more carbons.

Aspect 38. The method of aspect 37, wherein the functionalized polyhedral oligomeric silsesquioxane is at least partially functionalized by at least one alkene comprising from 2 to 8 carbons.

Aspect 39. The method of aspect 38, wherein the functionalized polyhedral oligomeric silsesquioxane is completely functionalized by alkenes comprising from 2 to 8 carbons.

Aspect 40. The method of any one of aspects 37-38, wherein the functionalized polyhedral oligomeric silsesquioxane is at least partially functionalized by an alkyl group or an aromatic group.

Aspect 41. The method of any one of aspects 37-40, wherein the reacting comprises heating the alkyl silane at a temperature of about 80°C to about 250°C for a period of time from about 10 minutes to about 8 hours.

Aspect 42. The method of any one of aspects 37-41, wherein the alkyl silane comprises iso-octyltrimethoxysilane, dodecyltrimethoxysilane, octadecyltrimethoxysilane, or combinations thereof.

Aspect 43. The method of any one of aspects 37-41, wherein the silane is a trimethoxysilane, a triethoxysilane, a trichlorosilane, a dichloromethoxy silane, or a chlorodimethoxysilane.

Aspect 44. The method of any one of aspects 37-43, wherein the evaporating the functionalized polyhedral oligomeric silsesquioxane and the impinging occur simultaneously.

Aspect 45. The method of any one of aspects 37-44, wherein the ion beam comprises ions of argon or oxygen.

Aspect 46. The method of any one of aspects 37-45, wherein the anti-fingerprint coating comprises from about 50% to about 90% of silicon atoms in a silica-like network.

Aspect 47. The method of any one of aspects 37-46, wherein a ratio of Si-O-Si bonds to Si atoms is from about 2 to about 3.

Aspect 48. The method of any one of aspects 37-47, wherein the anti-fingerprint coating comprises an abraded water contact angle of about 90° after being abraded for 2,000 cycles in a Steel Wool Abrasion Test.

Aspect 49. The method of any one of aspects 37-48, wherein the anti-fingerprint coating comprises a thickness from about 10 nanometers to about 600 nanometers.

Aspect 50. The method of any one of aspects 37-49, wherein the anti-fingerprint coating comprises a refractive index ranging from about 1.38 to about 1.55.

Aspect 51. The method of any one of aspects 37-50, wherein the anti-fingerprint coating comprises an elastic modulus ranging from about 9 GigaPascals to about 70 GigaPascals.

Aspect 52. The method of any one of aspects 37-51, wherein the anti-fingerprint coating comprises a total surface energy of about 30 milliNewtons per meter (mN/m) or less.

Aspect 53. The method of any one of aspects 37-52, wherein the anti-fingerprint coating comprises a dispersive surface energy of about 30 milliNewtons per meter (mN/m) or less.

Aspect 54. The method of any one of aspects 37-53, wherein the anti-fingerprint coating comprises a polar surface energy of about 3 milliNewtons per meter (mN/m) or less.

Aspect 55. The method of any one of aspects 37-54, wherein the anti-fingerprint coating comprises a water contact angle of about 100° or more.

Aspect 56. The method of any one of aspects 37-55, wherein the anti-fingerprint coating comprises a cheesecloth-abraded water contact angle of about 90° or more after being subjected to 200,000 cycles in a Cheesecloth Abrasion Test.

Aspect 57. The method of any one of aspects 37-56, wherein the anti-fingerprint coating comprises a surface roughness Ra of about 1 nm or less.

Aspect 58. The method of any one of aspects 37-57, wherein the anti-fingerprint coating is fluorine-free.

Aspect 59. The method of any one of aspects 37-58, wherein the substrate comprises a glass-based material, a glass-ceramic material, or a ceramic-based material. In exemplary aspects, the glass-based material, the glass-ceramic material, or the ceramic-based material is transparent, colored transparent, opaque, colored opaque, translucent, or colored translucent).

Aspect 60. The method of any one of aspects 37-59, further comprising an anti-reflective coating positioned between the anti-fingerprint coating and the substrate.

Aspect 61. The method of any one of aspects 37-59, further comprising a gradient coating comprising a refractive index gradient positioned between the anti-fingerprint coating and the substrate.

Aspect 62. A method of forming a coated articled comprising:

disposing a solution over a first major surface of a substrate, the solution comprising a polysilazane or a polyhedral oligomeric silsesquioxane;

heating the solution at a temperature from about 150°C to about 400°C for a period of time from about 5 minutes to about 120 minutes; and

reacting material at the first major surface of the substrate with an alkyl silane to form an anti-fingerprint coating, the alkyl silane comprising 4 or more carbons.

Aspect 63. The method of aspect 62, wherein a concentration of the polysilazane or the polyhedral oligomeric silsesquioxane ranges from about 0.2 wt% to about 25 wt%.

Aspect 64. The method of any one of aspects 62-63, wherein the temperature ranges from about 150°C to about 250°C.

Aspect 65. The method of any one of aspects 62-64, wherein the reacting comprises heating the alkyl silane at a temperature of about 80°C to about 250°C for a period of time from about 10 minutes to about 8 hours.

Aspect 66. The method of any one of aspects 62-65, wherein the alkyl silane comprises iso-octyltrimethoxysilane, dodecyltrimethoxysilane, octadecyltrimethoxysilane, or combinations thereof.

Aspect 67. The method of any one of aspects 62-66, wherein the silane is a trimethoxysilane, a triethoxysilane, a trichlorosilane, a dichloromethoxy silane, or a chlorodimethoxysilane.

Aspect 68. The method of any one of aspects 62-67, wherein the anti-fingerprint coating comprises a diiodomethane contact angle of about 60° or more.

Aspect 69. The method of any one of aspects 62-68, wherein the anti-fingerprint coating wets hexadecane or comprises a hexadecane contact angle of about 30° or less.

Aspect 70. The method of any one of aspects 62-69, wherein the heating forms the anti-fingerprint coating as a partial silica-like network and either silicon hydrides or silanols.

Aspect 71. The method of any one of aspects 62-70, wherein heating forms the anti-fingerprint coating comprising at least one of:

about 50% to about 90% of silicon atoms are in a silica-like network; or
a ratio of Si-O-Si bonds to Si atoms is from about 2 to about 3.

Aspect 72. The method of any one of aspects 62-71, wherein the anti-fingerprint coating comprises a thickness from about 10 nanometers to about 600 nanometers.

Aspect 73. The method of any one of aspects 62-72, wherein the anti-fingerprint coating comprises a refractive index from about 1.38 to about 1.55.

Aspects 74. The method of any one of aspects 62-73, wherein the anti-fingerprint coating comprises an elastic modulus ranging from about 9 GigaPascals to about 70 GigaPascals.

Aspect 75. The method of any one of aspects 62-74, wherein the anti-fingerprint coating comprises a total surface energy of about 30 milliNewtons per meter (mN/m) or less.

Aspect 76. The method of any one of aspects 62-75, wherein the anti-fingerprint coating comprises a dispersive surface energy of about 30 milliNewtons per meter (mN/m) or less.

Aspect 77. The method of any one of aspects 62-76, wherein the anti-fingerprint coating comprises a polar surface energy of about 3 milliNewtons per meter (mN/m) or less.

Aspect 78. The method of any one of aspects 62-77, wherein the anti-fingerprint coating comprises a water contact angle of about 100° or more.

Aspect 79. The method of any one of aspects 62-78, wherein the anti-fingerprint coating comprises a cheesecloth-abraded water contact angle of about 90° or more after being subjected to 200,000 cycles in a Cheesecloth Abrasion Test.

Aspect 80. The method of any one of aspects 62-79, wherein the anti-fingerprint coating comprises a surface roughness Ra of about 1 nm or less.

Aspect 81. The method of any one of aspects 62-80, wherein the anti-fingerprint coating is fluorine-free.

Aspect 82. The method of any one of aspects 62-81, wherein the substrate comprises a glass-based material, a glass-ceramic material, or a ceramic-based material. In exemplary aspects, the glass-based material, the glass-ceramic material, or the ceramic-based material is transparent, colored transparent, opaque, colored opaque, translucent, or colored translucent.

Aspect 83. The method of any one of aspects 62-82, further comprising an anti-reflective coating positioned between the anti-fingerprint coating and the substrate.

Aspect 84. The method of any one of aspects 62-83, further comprising a gradient coating comprising a refractive index gradient positioned between the anti-fingerprint coating and the substrate.

Aspect 85. The method of any one of aspects 37-84, wherein the anti-fingerprint coating further comprises nitrogen atoms bonded to silicon atoms.

Aspect 86. A coated article comprising:

a substrate comprising a first major surface;
an anti-fingerprint coating disposed on the first major surface, the anti-fingerprint coating comprising an exterior surface of the coated article, the anti-fingerprint coating comprising a thickness from about 10 nanometers to about 600 nanometers, the anti-fingerprint coating comprises a partial silica-like network having a ratio of Si-O-Si bonds to Si atoms in the anti-fingerprint coating is from about 2 to about 3, the anti-fingerprint coating is fluorine-free, and the anti-fingerprint coating further comprises an alkyl silane at the exterior surface and bonded to Si-O groups in the anti-fingerprint coating.

Aspect 87. A method of forming a coated article comprising:

evaporating a functionalized polyhedral oligomeric silsesquioxane onto a first major surface of a substrate;
impinging an ion beam on the first major surface of the substrate, the impinging occurs in a chamber comprising a chamber pressure ranging from about $10^{-4}$ Pascal to about 1 Pascal, and the impinging converts from about 50% to about 90% of the silicon atoms in the functionalized polyhedral oligomeric silsesquioxane from a cage structure to a network of Si-O-Si bonds; and then
reacting material at the first major surface of the substrate with an alkyl silane to form an anti-fingerprint coating, the alkyl silane comprising 4 or more carbons.

Aspect 88. A method of forming a coated articled comprising:

disposing a solution over a first major surface of a substrate, the solution comprising a polysilazane or a polyhedral oligomeric silsesquioxane;
heating the solution at a temperature from about 150°C to about 400°C for a period of time from about 5 minutes to about 120 minutes; and
reacting material at the first major surface of the substrate with an alkyl silane to form an anti-fingerprint coating, the alkyl silane comprising 4 or more carbons.

Aspect 89. The coated article of any one of aspects 1-36, wherein the anti-fingerprint coating exhibits a rubber abrasion water contact angle of about 100° or more after being subjected to 5,000 cycles in a Rubber Abrasion Test.

Aspect 90. The coated article of any one of aspects 1-36 or 89 inclusive, further comprising an optical stack positioned between the anti-fingerprint coating and the substrate, wherein the optical stack comprises an anti-reflective coating, a band-pass filter coating, an edge neutral mirror, a beam splitter coating, a multi-layer high-reflectance coating, or an edge filter coating.

Aspect 91. The coated article of aspect 90, wherein the optical stack has a thickness from about 10 nanometers to about 10 micrometers.

Aspect 92. The coated article of aspect 91, wherein the thickness of the optical stack is from about 50 nanometers to about 5 micrometers.

Aspect 93. The coated article of aspect 91, wherein the thickness of the optical stack is from about 50 nanometers to about 500 nanometers.

Aspect 94. The coated article of any one of aspects 90-93, wherein the optical stack comprises a scratch resistant layer, and wherein the scratch resistant layer has a thickness from 0.05 micrometers to 3 micrometers.

Aspect 95. The coated article of any one of aspects 90-94, wherein the coated article including the optical stack and the anti-fingerprint coating exhibits a hardness of 8 GigaPascals or greater measured by a Berkovich Indenter Hardness test.

Aspect 96. The coated article of aspect 95, wherein the coated article including the optical stack and the anti-fingerprint coating exhibits the hardness of 12 GigaPascals or greater measured by the Berkovich Indenter Hardness test.

Aspect 97. The coated article of any one of aspects 90-96, wherein the optical stack comprises one or more of a silicon-containing oxide, a silicon-containing nitride, a silicon-containing oxynitride, and $Nb_2O_5$.

Aspect 98. The coated article of any one of aspects 90-97, wherein the optical stack comprises two or more layers with different refractive indices including at least a first low refractive index (low RI) layer and a second high refractive index (high RI) layer, an absolute value of a difference between the first low RI layer and the second high RI layer is 0.2 or more, and further wherein the optical stack comprises one or more of a silicon-containing oxide, a silicon-containing nitride, a silicon-containing oxynitride, and $Nb_2O$.

Aspect 99. The coated article of any one of aspects 1-36 or 89-98, wherein the substrate is a textured substrate.

Aspect 100. The coated article of any one of aspects 1-36 or 89-99 inclusive, wherein the alkyl silane comprises an iso-octyl alkyl group, a dodecyl alkyl group, an octadecyl alkyl group, or combinations thereof.

Aspect 101. A coated article comprising:

a substrate comprising a first major surface;
an alkyl silane over the first major surface, the alkyl silane comprising an exterior surface of the coated article, the alkyl silane comprising a thickness from about 1 nanometer to about 75 nanometers, and the alkyl silane is fluorine-free.

Aspect 102. The coated article of aspect 101, wherein the alkyl silane comprises a $C_4$-$C_{34}$ alkyl group.

Aspect 103. The coated article of aspect 101, wherein the alkyl silane comprises an iso-octyl alkyl group, a dodecyl alkyl group, an octadecyl alkyl group, or combinations thereof.

Aspect 104. The coated article of aspect 101, wherein the alkyl silane comprises an octadecyl alkyl group.

Aspect 105. The coated article of any one of aspects 101-105, wherein the exterior surface exhibits a water contact angle of 100° or more.

Aspect 106. The coated article of aspect 105, wherein the exterior surface exhibits the water contact angle from 102° to 110°.

Aspect 107. The coated article of any one of aspects 101-106, wherein the exterior surface exhibits a diiodomethane contact angle of about 60° or more.

Aspect 108. The coated article of any one of aspects 101-107, wherein the exterior surface exhibits a coefficient of friction of 0.25 or less.

Aspect 109. The coated article of any one of aspects 101-108, wherein the alkyl silane comprises a polar surface energy of about 3 milliNewtons per meter (mN/m) or less.

Aspect 110. The coated article of any one of aspects 101-109, wherein the alkyl silane comprises a total surface energy of about 30 milliNewtons per meter (mN/m) or less.

Aspect 111. The coated article of any one of aspects 101-110, wherein the alkyl silane comprises a cheesecloth-abraded water contact angle of about 90° or more after being subjected to 200,000 cycles in a Cheesecloth Abrasion Test.

Aspect 112. The coated article of any one of aspects 101-111, wherein the alkyl silane exhibits a rubber abrasion water contact angle of about 100° or more after being subjected to 5,000 cycles in a Rubber Abrasion Test.

Aspect 113. The coated article of any one of aspects 101-112, further comprising an optical stack positioned between the alkyl silane and the substrate, wherein the optical stack comprises an anti-reflective coating, a band-pass filter coating, an edge neutral mirror, a beam splitter coating, a multi-layer high-reflectance coating, or an edge filter coating.

Aspect 114. The coated article of aspect 113, wherein the optical stack has a thickness from about 10 nanometers to about 10 micrometers.

Aspect 115. The coated article of aspect 114, wherein the thickness of the optical stack is from about 50 nanometers to about 5 micrometers.

Aspect 116. The coated article of aspect 114, wherein the thickness of the optical stack is from about 50 nanometers to about 500 nanometers.

Aspect 117. The coated article of any one of aspects 113-116, wherein the optical stack comprises a scratch resistant layer, and wherein the scratch resistant layer has a thickness from 0.05 micrometers to 3 micrometers.

Aspect 118. The coated article of any one of aspects 113-117, wherein the coated article including the optical stack and the alkyl silane exhibits a hardness of 8 GigaPascals or greater measured by a Berkovich Indenter Hardness test.

Aspect 119. The coated article of aspect 118, wherein the coated article including the optical stack and the alkyl silane exhibits the hardness of 12 GigaPascals or greater measured by the Berkovich Indenter Hardness test.

Aspect 120. The coated article of any one of aspects 113-119, wherein the optical stack comprises one or more of a silicon-containing oxide, a silicon-containing nitride, a silicon-containing oxynitride, and $Nb_2O_5$.

Aspect 121. The coated article of any one of aspects 113-120, wherein the optical stack comprises two or more layers with different refractive indices including at least a first low refractive index (low RI) layer and a second high refractive index (high RI) layer, an absolute value of a difference between the first low RI layer and the second high RI layer is 0.2 or more, and further wherein the optical stack comprises one or more of a silicon-containing oxide, a silicon-containing nitride, a silicon-containing oxynitride, and $Nb_2O$.

Aspect 122. The coated article of any one of aspects 101-121, wherein the substrate is a textured substrate.

Aspect 123. The coated article of any one of aspects 101-122, wherein the substrate comprises a glass-based material, a glass-ceramic material, or a ceramic-based material.

Aspect 124. The coated article according to aspect 123, wherein the glass-based material, the glass-ceramic material, or the ceramic-based material is transparent, colored transparent, opaque, colored opaque, translucent, or colored translucent.

Aspect 125. The method of any one of aspects 37-85, wherein the alkyl silane comprises an iso-octyl alkyl group, a dodecyl alkyl group, an octadecyl alkyl group, or combinations thereof.

Aspect 126. The method of any one of aspects 37-85 or 125 inclusive, wherein the surface-modifying layer exhibits a rubber abrasion water contact angle of about 100° or more after being subjected to 5,000 cycles in a Rubber Abrasion Test.

Aspect 127. The method of any one of aspects 37-85 or 125-126 inclusive, further comprising an optical stack positioned between the surface-modifying layer and the substrate, wherein the optical stack comprises an antireflective coating, a band-pass filter coating, an edge neutral mirror, a beam splitter coating, a multi-layer high-reflectance coating, or an edge filter coating.

Aspect 128. The method of aspect 127, wherein the optical stack has a thickness from about 10 nanometers to about 10 micrometers.

Aspect 129. The method of aspect 128, wherein the thickness of the optical stack is from about 50 nanometers to about 5 micrometers.

Aspect 130. The method of aspect 128, wherein the thickness of the optical stack is from about 50 nanometers to about 500 nanometers.

Aspect 131. The method of any one of aspects 125-130, wherein the optical stack comprises a scratch resistant layer, and wherein the scratch resistant layer has a thickness from 0.05 micrometers to 3 micrometers.

Aspect 132. The method of any one of aspects 125-131, wherein the coated article including the optical stack and the surface-modifying layer exhibits a hardness of 8 GigaPascals or greater measured by a Berkovich Indenter Hardness test.

Aspect 133. The method of aspect 132, wherein the coated article including the optical stack and the surface-modifying layer exhibits the hardness of 12 GigaPascals or greater measured by the Berkovich Indenter Hardness test.

Aspect 134. The method of any one of aspects 125-133, wherein the optical stack comprises one or more of a silicon-containing oxide, a silicon-containing nitride, a silicon-containing oxynitride, and $Nb_2O_5$.

Aspect 135. The method of any one of aspects 125-134, wherein the optical stack comprises two or more layers with different refractive indices including at least a first low refractive index (low RI) layer and a second high refractive index (high RI) layer, an absolute value of a difference between the first low RI layer and the second high RI layer is 0.2 or more, and further wherein the optical stack comprises one or more of a silicon-containing oxide, a silicon-containing nitride, a silicon-containing oxynitride, and $Nb_2O$.

Aspect 136. The method of any one of aspects 37-85 or 125-135, wherein the substrate is a textured substrate.

Aspect 137. A method of forming a coated article comprising:

reacting material at a first major surface of a substrate with an alkyl silane to form surface-modifying layer, the alkyl silane comprising an alkyl group with 4 or more carbons, wherein the surface-modifying layer exhibits a water contact angle of 100° or more.

Aspect 138. The method of aspect 137, wherein the alkyl group comprises an iso-octyl alkyl group, a dodecyl alkyl group, an octadecyl alkyl group, or combinations thereof.

Aspect 139. The method of aspect 137, wherein the alkyl group comprises an octadecyl alkyl group.

Aspect 140. The method of any one of aspects 137-139, wherein the alkyl silane comprises iso-octyltrimethoxysilane, dodecyltrimethoxysilane, octadecyltrimethoxysilane, or combinations thereof.

Aspect 141. The method of any one of aspects 137-140, wherein the silane is a trimethoxysilane, a triethoxysilane, a trichlorosilane, a dichloromethoxy silane, or a chlorodimethoxysilane.

Aspect 142. The method of any one of aspects 137-141, wherein the exterior surface exhibits a water contact angle of 100° or more.

Aspect 143. The method of aspect 142, wherein the exterior surface exhibits the water contact angle from 102° to 110°.

Aspect 144. The method of any one of aspects 137-143, wherein the exterior surface exhibits a diiodomethane contact angle of about 60° or more.

Aspect 145. The method of any one of aspects 137-144, wherein the exterior surface exhibits a coefficient of friction of 0.25 or less.

Aspect 146. The method of any one of aspects 137-145, wherein the surface-modifying layer comprises a polar surface energy of about 3 milliNewtons per meter (mN/m) or less.

Aspect 147. The method of any one of aspects 137-146, wherein the surface-modifying layer comprises a total surface energy of about 30 milliNewtons per meter (mN/m) or less.

Aspect 148. The method of any one of aspects 137-147, wherein a thickness of the surface-modifying layer is from 1 nanometer to 75 nanometers.

Aspect 149. The coated article of any one of aspects 137-148, wherein the surface-modifying layer comprises a cheesecloth-abraded water contact angle of about 90° or more after being subjected to 200,000 cycles in a Cheesecloth Abrasion Test.

Aspect 150. The coated article of any one of aspects 137-149, wherein the surface-modifying layer exhibits a rubber abrasion water contact angle of about 100° or more after being subjected to 5,000 cycles in a Rubber Abrasion Test.

Aspect 151. The coated article of any one of aspects 137-150, further comprising an optical stack positioned between the surface-modifying layer and the substrate, wherein the optical stack comprises an anti-reflective coating, a band-pass filter coating, an edge neutral mirror, a beam splitter coating, a multi-layer high-reflectance coating, or an edge filter coating.

Aspect 152. The coated article of aspect 151, wherein the optical stack has a thickness from about 10 nanometers to about 10 micrometers.

Aspect 153. The coated article of aspect 152, wherein the thickness of the optical stack is from about 50 nanometers to about 5 micrometers.

Aspect 154. The coated article of aspect 152, wherein the thickness of the optical stack is from about 50 nanometers to about 500 nanometers.

Aspect 155. The coated article of any one of aspects 151-154, wherein the optical stack comprises a scratch resistant layer, and wherein the scratch resistant layer has a thickness from 0.05 micrometers to 3 micrometers.

Aspect 156. The coated article of any one of aspects 151-155, wherein the coated article including the optical stack and the surface-modifying layer exhibits a hardness of 8 GigaPascals or greater measured by a Berkovich Indenter Hardness test.

Aspect 157. The coated article of aspect 156, wherein the coated article including the optical stack and the surface-modifying layer exhibits the hardness of 12 GigaPascals or greater measured by the Berkovich Indenter Hardness test.

Aspect 158. The coated article of any one of aspects 151-157, wherein the optical stack comprises one or more of a silicon-containing oxide, a silicon-containing nitride, a silicon-containing oxynitride, and $Nb_2O_5$.

Aspect 159. The coated article of any one of aspects 151-158, wherein the optical stack comprises two or more layers with different refractive indices including at least a first low refractive index (low RI) layer and a second high refractive index (high RI) layer, an absolute value of a difference between the first low RI layer and the second high RI layer is 0.2 or more, and further wherein the optical stack comprises one or more of a silicon-containing oxide, a silicon-containing nitride, a silicon-containing oxynitride, and $Nb_2O$.

Aspect 160. The coated article of any one of aspects 137-159, wherein the substrate is a textured substrate.

Aspect 161. The coated article of any one of aspects 137-160, wherein the substrate comprises a glass-based material, a glass-ceramic material, or a ceramic-based material.

Aspect 162. The coated article according to aspect 161, wherein the glass-based material, the glass-ceramic material, or the ceramic-based material is transparent, colored transparent, opaque, colored opaque, translucent, or colored translucent.

Aspect 163. A coated article comprising:

a substrate comprising a first major surface;

a surface-modifying layer disposed over the first major surface, the surface-modifying layer comprising an exterior surface of the coated article, the surface-modifying layer comprising a thickness from about 10 nanometers to about 600 nanometers, the surface-modifying layer comprises a partial silica-like network having a ratio of Si-O-Si bonds to Si atoms in the surface-modifying layer is from about 2 to about 3, the surface-modifying layer is fluorine-free, and the surface-modifying layer further comprises an alkyl silane at the exterior surface and bonded to Si-O groups in the surface-modifying layer.

Aspect 164. The coated article of aspect 163, wherein the surface-modifying layer comprises a refractive index ranging from about 1.38 to about 1.55.

Aspect 165. The coated article of any one of aspects 163-164, wherein the surface-modifying layer comprises an elastic modulus ranging from about 9 GigaPascals to about 70 GigaPascals.

Aspect 166. The coated article of any one of aspects 163-165, wherein the alkyl silane comprises a $C_4$-$C_{34}$ alkyl group.

Aspect 167. The coated article of any one of aspects 163-166, wherein the alkyl silane comprises an iso-octyl alkyl group, a dodecyl alkyl group, an octadecyl alkyl group, or combinations thereof.

Aspect 168. The coated article of any one of aspects 163-167, wherein the surface-modifying layer further comprises nitrogen atoms bonded to silicon atoms.

Aspect 169. The coated article of any one of aspects 163-168, wherein the surface-modifying layer comprises either silicon hydrides or silanols.

Aspect 170. The coated article of any one of aspects 163-169, wherein the surface-modifying layer exhibits a diiodomethane contact angle of about 60° or more.

Aspect 171. The coated article of any one of aspects 163-170, wherein the surface-modifying layer exhibits a water contact angle of about 100° or more.

Aspect 172. The coated article of any one of aspects 163-171, wherein the surface-modifying layer wets hexadecane or exhibits a hexadecane contact angle of about 30° or less.

Aspect 173. The coated article of any one of aspects 163-172, wherein the surface-modifying layer comprises a polar surface energy of about 3 milliNewtons per meter (mN/m) or less.

Aspect 174. The coated article of any one of aspects 163-173, wherein the surface-modifying layer comprises a total surface energy of about 30 milliNewtons per meter (mN/m) or less.

Aspect 175. The coated article of any one of aspects 163-174, wherein the surface-modifying layer exhibits an abraded water contact angle of about 90° after being abraded for 2,000 cycles in a Steel Wool Abrasion Test.

Aspect 176. The coated article of any one of aspects 163-175, wherein the surface-modifying layer exhibits a cheesecloth-abraded water contact angle of about 90° or more after being subjected to 200,000 cycles in a Cheesecloth Abrasion Test.

Aspect 177. The coated article of any one of aspects 163-176, wherein the surface-modifying layer exhibits a rubber abrasion water contact angle of about 100° or more after being subjected to 5,000 cycles in a Rubber Abrasion Test.

Aspect 178. The coated article of any one of aspects 163-177, further comprising an anti-reflective coating positioned between the surface-modifying layer and the substrate.

Aspect 179. The coated article of any one of aspects 163-177, further comprising a gradient coating comprising a refractive index gradient positioned between the surface-modifying layer and the substrate.

Aspect 180. The coated article of any one of aspects 163-177, further comprising an optical stack positioned between the surface-modifying layer and the substrate, wherein the optical stack comprises an anti-reflective coating, a band-pass filter coating, an edge neutral mirror, a beam splitter coating, a multi-layer high-reflectance coating, or an edge filter coating.

Aspect 181. The coated article of aspect 180, wherein the optical stack has a thickness from about 10 nanometers to about 10 micrometers.

Aspect 182. The coated article of aspect 181, wherein the thickness of the optical stack is from about 50 nanometers to about 5 micrometers.

Aspect 183. The coated article of aspect 181, wherein the thickness of the optical stack is from about 50 nanometers to about 500 nanometers.

Aspect 184. The coated article of any one of aspects 180-182, wherein the optical stack comprises a scratch resistant layer, and wherein the scratch resistant layer has a thickness from 0.05 micrometers to 3 micrometers.

Aspect 185. The coated article of any one of aspects 180-183, wherein the coated article including the optical stack and the surface-modifying layer exhibits a hardness of 8 GigaPascals or greater measured by a Berkovich Indenter Hardness test.

Aspect 186. The coated article of aspect 185, wherein the coated article including the optical stack and the surface-modifying layer exhibits the hardness of 12 GigaPascals or greater measured by the Berkovich Indenter Hardness test.

Aspect 187. The coated article of any one of aspects 180-186, wherein the optical stack comprises one or more of a silicon-containing oxide, a silicon-containing nitride, a silicon-containing oxynitride, and $Nb_2O_5$.

Aspect 188. The coated article of any one of aspects 180-187, wherein the optical stack comprises two or more layers with different refractive indices including at least a first low refractive index (low RI) layer and a second high refractive index (high RI) layer, an absolute value of a difference between the first low RI layer and the second high RI layer is 0.2 or more, and further wherein the optical stack comprises one or more of a silicon-containing oxide, a silicon-containing nitride, a silicon-containing oxynitride, and $Nb_2O$.

Aspect 189. The coated article of any one of aspects 163-188, wherein the substrate is a textured substrate.

Aspect 190. The coated article of any one of aspects 163-189, wherein the substrate comprises a glass-based material, a glass-ceramic material, or a ceramic-based material.

Aspect 191. The coated article according to aspect 190, wherein the glass-based material, the glass-ceramic material, or the ceramic-based material is transparent, colored transparent, opaque, colored opaque, translucent, or colored translucent.

Aspect 192. A method of forming a coated article comprising:

evaporating a functionalized polyhedral oligomeric silsesquioxane onto a first major surface of a substrate; impinging an ion beam on the first major surface of the substrate, the impinging occurs in a chamber comprising a chamber pressure ranging from about $10^{-4}$ Pascal to about 1 Pascal, and the impinging converts from about 50% to about 90% of the silicon atoms in the functionalized polyhedral oligomeric silsesquioxane from a cage structure to a network of Si-O-Si bonds; and then reacting material at the first major surface of the substrate with an alkyl silane to form an surface-modifying layer, the alkyl silane comprising 4 or more carbons.

Aspect 193. The method of aspect 192, wherein the functionalized polyhedral oligomeric silsesquioxane is at least partially functionalized by at least one alkene comprising from 2 to 8 carbons.

Aspect 194. The method of aspect 193, wherein the functionalized polyhedral oligomeric silsesquioxane is completely functionalized by alkenes comprising from 2 to 8 carbons.

Aspect 195. The method of any one of aspects 192-194, wherein the functionalized polyhedral oligomeric silsesquioxane is at least partially functionalized by an alkyl group or an aromatic group.

Aspect 196. The method of any one of aspects 192-195, wherein the reacting comprises heating the alkyl silane at a temperature of about 80°C to about 250°C for a period of time from about 10 minutes to about 8 hours.

Aspect 197. The method of any one of aspects 192-196, wherein the alkyl silane comprises an iso-octyl alkyl group, a dodecyl alkyl group, an octadecyl alkyl group, or combinations thereof.

Aspect 198. The method of any one of aspects 192-197, wherein the silane is a trimethoxysilane, a triethoxysilanes, a trichlorosilane, a dichloromethoxy silane, or a chlorodimethoxysilane.

Aspect 199. The method of any one of aspects 192-198, wherein the evaporating the functionalized polyhedral oligomeric silsesquioxane and the impinging occur simultaneously.

Aspect 200. The method of any one of aspects 192-199, wherein the evaporating the functionalized polyhedral oligomeric silsesquioxane comprises an evaporation rate from about 0.01 nanometers per second (nm/s) to about 0.2 nm/s.

Aspect 201. The method of any one of claims 192-200, wherein the ion beam comprises ions of argon or oxygen.

Aspect 202. The method of any one of aspects 192-201, wherein a ratio of Si-O-Si bonds to Si atoms is from about 2 to about 3.

Aspect 203. The method of any one of aspects 192-202, wherein the surface-modifying layer comprises an abraded water contact angle of about 90° after being abraded for 2,000 cycles in a Steel Wool Abrasion Test.

Aspect 204. The method of any one of aspects 192-203, wherein the surface-modifying layer comprises a thickness from about 10 nanometers to about 600 nanometers.

Aspect 205. The method of any one of aspects 192-204, wherein the surface-modifying layer comprises a refractive index ranging from about 1.38 to about 1.55.

Aspect 206. The method of any one of aspects 192-205, wherein the surface-modifying layer comprises an elastic modulus ranging from about 9 GigaPascals to about 70 GigaPascals.

Aspect 207. The method of any one of aspects 192-206, wherein the surface-modifying layer comprises a total surface energy of about 30 milliNewtons per meter (mN/m) or less.

Aspect 208. The method of any one of aspects 192-207, wherein the surface-modifying layer comprises a polar surface energy of about 3 milliNewtons per meter (mN/m) or less.

Aspect 209. The method of any one of aspects 192-208, wherein the surface-modifying layer comprises a water contact angle of about 100° or more.

Aspect 210. The method of any one of aspects 192-209, wherein the surface-modifying layer comprises a cheesecloth-abraded water contact angle of about 90° or more after being subjected to 200,000 cycles in a Cheesecloth Abrasion Test.

Aspect 211. The coated article of any one of aspects 192-210, wherein the surface-modifying layer exhibits a rubber abrasion water contact angle of about 100° or more after being subjected to 5,000 cycles in a Rubber Abrasion Test.

Aspect 212. The method of any one of aspects 192-211, wherein the surface-modifying layer comprises a surface roughness Ra of about 1 nm or less.

Aspect 213. The method of any one of aspects 192-212, wherein the surface-modifying layer is fluorine-free.

Aspect 214. The method of any one of aspects 192-213, further comprising an optical stack positioned between the surface-modifying layer and the substrate, wherein the optical stack comprises an anti-reflective coating, a band-pass filter coating, an edge neutral mirror, a beam splitter coating, a multi-layer high-reflectance coating, or an edge filter coating.

Aspect 215. The method of aspect 214, wherein the optical stack thickness is from about 10 nanometers to about 10 micrometers.

Aspect 216. The method of aspect 215, wherein the optical stack comprises scratch resistant layer, and the scratch resistant layer has a thickness from 0.05 micrometers to 3 micrometers.

Aspect 217. The method of any one of aspects 214-216, wherein the optical stack comprises one or more of a silicon-containing oxide, a silicon-containing nitride, and/or a silicon-containing oxynitride.

Aspect 218. The method of any one of aspects 214-217, wherein the optical stack two or more layers with different refractive indices, a first low RI layer and a second high RI layer, wherein the absolute value of a difference between the first low RI layer and the second high RI layer is 0.2 or more, and further wherein the optical stack comprises one or more of a silicon-containing oxide, a silicon-containing nitride, and/or a silicon-containing oxynitride.

Aspect 219. The method of any one of aspects 214-218, wherein the substrate comprises a glass-based material, a glass-ceramic material, or a ceramic-based material.

**BRIEF DESCRIPTION OF THE DRAWINGS**

The above and other features and advantages of aspects of the present disclosure are better understood when the following detailed description is read with reference to the accompanying drawings, in which:

**FIGS. 1 and 2A-2C** are schematic views of exemplary coated articles according to aspects;
**FIG. 3** is a schematic plan view of an example consumer electronic device according to aspects;
**FIG. 4** is a schematic perspective view of the example consumer electronic device of **FIG. 3;**
**FIG. 5** schematically illustrates a functionalized polyhedral oligomeric silsesquioxane (POSS) compound;
**FIG. 6** schematically illustrates a reaction of polysilazane (PHPS);
**FIGS. 7-8** are flow charts illustrating example methods of making coated articles in accordance with aspects of the disclosure;
**FIG. 9** schematically illustrates a step(s) in methods of making a coated article comprising evaporating a functionalized POSS and impinging an ion beam on a first major surface of a substrate;
**FIG. 10** schematically illustrates a step in methods of making a coated article comprising reacting material at the first major surface with a functionalized silane;
**FIG. 11** schematically illustrates a step in methods of making a coated article comprising disposing a solution over a first major surface of a substrate;
**FIG. 12** schematically illustrates a step in methods of making a coated article comprising heating the solution on the first major surface;
**FIG. 13** schematically illustrates transmittance (%) on the vertical axis (y-axis) as a function of optical wavelength on the horizontal axis (x-axis) for Examples A-B and Comparative Examples AA-CC;
**FIG. 14** schematically illustrates refractive index (left-side vertical axis - y-axis on the left) and extinction coefficient (right-side vertical axis - x-axis on the right) as a function of optical wavelength on the horizontal axis (x-axis) for Examples A-B;
**FIG. 15** schematically illustrates infrared (IR) absorption spectra for Examples A-C and Comparative Example CC as normalized absorbance on the vertical axis (y-axis) as a function of wavenumber (cm$^{-1}$) on the horizontal axis (x-axis);

**FIGS. 16-17** schematically illustrate intensity (vertical axis - y-axis) of charge to charge ratios (horizontal axis - x-axis) from secondary-ion mass spectrometry (SIMS) for Examples A-B and Comparative Example CC;

**FIG. 18** schematically illustrates surface compositions (in atom% on the vertical axis - y-axis) as determined by X-ray photoelectron spectroscopy (XPS) for Examples A-B and Comparative Example CC;

**FIGS. 19-20** schematically illustrate the intensity (vertical axis - y-axis) of binding energy distributions (horizontal axis - x-axis) as determined by XPS for Examples A-B and Comparative Example CC;

**FIG. 21** schematically illustrates the intensity (vertical axis - y-axis) of a $^{29}Si$ chemical shift (horizontal axis - x-axis) measured using solid-state nuclear magnetic resonance (NMR) (SS-NMR) for Example B;

**FIG. 22** schematically illustrates water contact angles (°) (vertical axis - y-axis) in a Steel Wool Abrasion Test for Examples D-E, G-H, and Comparative Examples EE and HH with points after 0 cycles, 2000 cycles, and 3500 cycles;

**FIG. 23** schematically illustrates a relationship between an elastic modulus (GigaPascals (GPa) on the vertical axis (y-axis) and cure temperature (°C) on the horizontal axis (x-axis) for polysilazane materials;

**FIG. 24** schematically illustrates water contact angles (°) (vertical axis - y-axis) in a Steel Wool Abrasion Test for Examples D and J and Comparative Example II;

**FIG. 25** schematically illustrates water contact angles (°) (vertical axis - y-axis) in a Rubber Abrasion Test as function of the number of abrasion cycles (horizontal axis - x-axis) for Examples K-N;

**FIG. 26** schematically illustrates water contact angles (°) (vertical axis - y-axis) in Steel Wool Abrasion Test as function of the number of abrasion cycles (horizontal axis - x-axis) for Examples K and M;

**FIG. 27** schematically illustrates infrared (IR) absorption spectra for Examples O-S with the horizontal axis (x-axis) corresponding to wavenumber (cm$^{-1}$) and the vertical axis (y-axis) corresponding to normalized absorbance;

**FIG. 28** schematically illustrates a hydroxyl ratio on the vertical axis (y-axis) as a function of deposition rate in A/s on the horizonal axis (x-axis) for Examples O-S;

**FIG. 29** schematically illustrates molar ratios of hydrogen to silicon (vertical axis - y-axis) as measured by dynamic secondary-ion mass spectrometry (D-SIMS) for Examples 1-10 and Comparative Examples JJ-KK; and

**FIG. 30** schematically illustrates the water contact angles (vertical axis - y-axis) every 100,000 cycles in the Cheesecloth Abrasion Test for Examples 11-12.

Throughout the disclosure, the drawings are used to emphasize certain aspects. As such, it should not be assumed that the relative size of different regions, portions, and substrates shown in the drawings are proportional to its actual relative size, unless explicitly indicated otherwise.

## DETAILED DESCRIPTION

Aspects will now be described more fully hereinafter with reference to the accompanying drawings in which example aspects are shown. Whenever possible, the same reference numerals are used throughout the drawings to refer to the same or like parts.

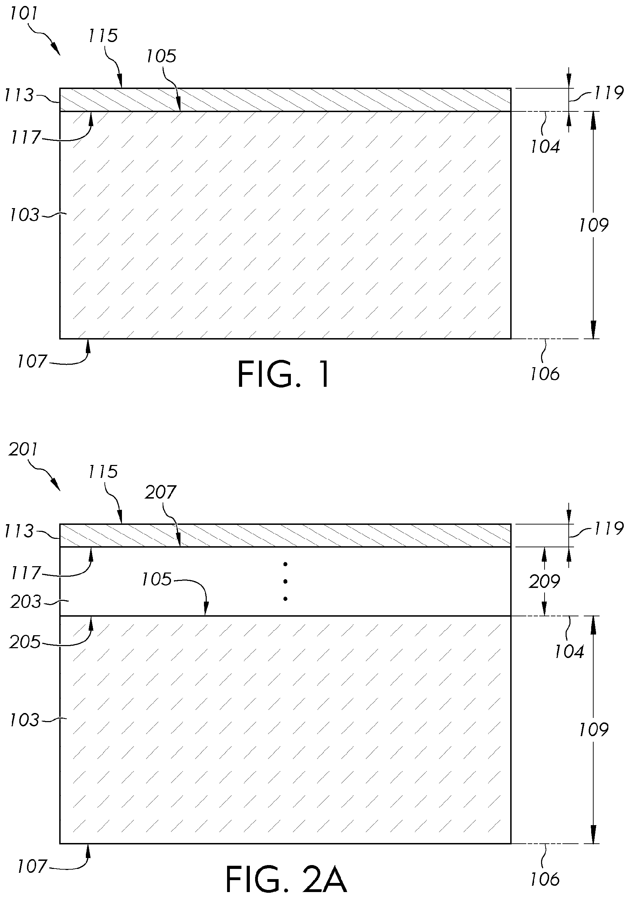

**FIGS. 1 and 2A-2C** illustrate views of a coated article **101, 201, 211, or 221** comprising a surface-modifying layer (e.g., an anti-fingerprint coating **113**) disposed over a substrate **103** in accordance with aspects of the disclosure. Unless otherwise noted, a discussion of features of aspects of one surface-modifying layer (e.g., anti-fingerprint coating) or coated article can apply equally to corresponding features of any aspects of the disclosure. For example, identical part numbers throughout the disclosure can indicate that, in some aspects, the identified features are identical to one another and that the discussion of the identified feature of one aspect, unless otherwise noted, can apply equally to the identified feature of any of the other aspects of the disclosure.

As shown in **FIGS. 1 and 2A-2C,** the substrate **103** comprises a first major surface **105** and a second major surface **107** opposite the first major surface **105**. As shown, the first major surface **105** can extend along a first plane **104,** and/or the second major surface **107** can extend along a second plane **106**. In aspects, as shown, the second plane **106** can be parallel to the first plane **104**. As used herein, a substrate thickness **109** is defined between the first major surface **105** and the second major surface **107** as a distance between the first plane **104** and the second plane **106**. In aspects, the substrate thickness **109** can be about 10 micrometers ($\mu$m) or more, about 25 $\mu$m or more, about 40 $\mu$m or more, about 60 $\mu$m or more, about 70 $\mu$m or more, about 80 $\mu$m or more, about 90 $\mu$m or more, about 100 $\mu$m or more, about 125 $\mu$m or more, about 150 $\mu$m or more, about 200 $\mu$m or more, about 300 $\mu$m or more, about 2 millimeters (mm) or less, about 1 mm or less, about 800 $\mu$m or less, about 500 $\mu$m or less, about 300 $\mu$m or less, about 200 $\mu$m or less, about 180 $\mu$m or less, or about 160 $\mu$m or less. In aspects, the substrate thickness **109** can range from about 10 $\mu$m to about 2 mm, from about 25 $\mu$m to about 2 mm, from about 40 $\mu$m to about 2 mm, from about 60 $\mu$m to about 2 mm, from about 70 $\mu$m to about 2 mm, from about 70 $\mu$m to about 1 mm, from about 70 $\mu$m to about 800 $\mu$m, from about 80 $\mu$m to about 500 $\mu$m, from about 90 $\mu$m 500 $\mu$m, from about 100 $\mu$m to about 200 $\mu$m, from about 125 $\mu$m to about 200 $\mu$m, from about 150 $\mu$m to about 200 $\mu$m, from about 150 $\mu$m to about 160 $\mu$m, or any range or subrange therebetween. Alternatively, the substrate thickness **109** can be from about 1 millimeter (mm) to about 5 mm, from about 1 mm to about 3 mm, or any range or subrange therebetween.

The substrate **103** can comprise a glass-based material, a glass-ceramic material, and/or a ceramic-based material having a pencil hardness of 8H or more, for example, 9H or more. As used herein, pencil hardness is measured using ASTM D 3363-20 with standard lead graded pencils. Providing a glass-based material, a glass-ceramic material, and/or a ceramic-based material as the substrate can enhance puncture resistance and/or impact resistance. As used herein, "glass-based" includes both glasses and glass-ceramics, wherein glass-ceramics have one or more crystalline phases and an amorphous, residual glass phase. A glass-based material (e.g., glass-based substrate) may comprise an amorphous material (e.g., glass) and optionally one or more crystalline materials (e.g., ceramic). Exemplary glass-based materials may be an alkali-free glass and/or comprise a low content of alkali metals (e.g., $R_2O$ of about 10 mol% or less, wherein $R_2O$ comprises $Li_2O$ $Na_2O$, and $K_2O$). As used herein, "ceramic-based" includes both ceramics and glass-ceramics, wherein glass-ceramics have one or more crystalline phases and an amorphous, residual glass phase. In aspects, ceramic-based materials can comprise one or more oxides, nitrides, oxynitrides, carbides, borides, and/or silicides. Throughout the disclosure, an elastic modulus (e.g., Young's modulus) of the substrate **103** is measured using ISO 527-1:2019. In aspects, the substrate **103** can comprise an elastic modulus ranging from about 10 GPa to about 100 GPa, from about 40 GPa to about 100 GPa, from about 60 GPa to about 100 GPa, from about 60 GPa to about 80 GPa, from about 80 GPa to about 100 GPa, or any range or subrange therebetween.

In aspects, the substrate **103** can be optically transparent. As used herein, "optically transparent" or "optically clear" means an average transmittance of 70% or more in the wavelength range of 400 nm to 750 nm through a 1.0 mm thick piece of a material. In aspects, an "optically transparent material" or an "optically clear material" may have an average transmittance of 75% or more, 80% or more, 85% or more, or 90% or more, 91% or more, 92% or more, 94% or more, 96% or more in the wavelength range of 400 nm to 750 nm through a 1.0 mm thick piece of the material. The average transmittance in the wavelength range of 400 nm to 700 nm is calculated by measuring the transmittance of whole number wavelengths from about 400 nm to about 700 nm and averaging the measurements.

In some aspects, the substrate **103,** in addition to being transparent, can also be colored transparent, opaque, colored opaque, translucent, or colored translucent. As used herein "opaque" and "translucent" can mean as follows: opacity is the measure of impenetrability to visible light. An opaque object is neither transparent (allowing all light to pass through) nor translucent (allowing some light to pass through). When light strikes an interface between two substances, in general some may be reflected, some absorbed, some scattered, and the rest transmitted. An opaque substance transmits very little light, and therefore reflects, scatters, or absorbs most of it. Opacity depends on the frequency of the light being considered. For instance, some kinds of glass, while transparent in the visual range, are largely opaque to ultraviolet light. Further, the colored transparent, colored opaque, and colored translucent can be anyone of a variety of colors including, for example, black, white, green, yellow, pink, red, blue, orange, purple, brown etc..

In aspects, the coated article **101, 201, 211, or 221** comprising a glass-based substrate, a glass-ceramic substrate, and/or a ceramic-based substrate can comprise one or more compressive stress regions. In aspects, a compressive stress region may be created by chemically strengthening. Chemically strengthening may comprise an ion exchange process, where ions in a surface layer are replaced by-or exchanged with-larger ions having the same valence or oxidation state. Methods of chemically strengthening will be discussed later. Without wishing to be bound by theory, chemically strengthening the substrate **103** can enable good impact resistance, good puncture resistance, and/or enable small bend radii, for example, with the compressive stress from the chemical strengthening counteracting bend-induced tensile stress on the outermost surface of the substrate. A compressive stress region may extend into a portion of the first portion and/or the second portion for a depth called the depth of compression (DOC). As used herein, depth of compression means the depth at which the stress in the chemically strengthened substrates and/or portions described herein changes from compressive stress to tensile stress. Depth of compression may be measured by a surface stress meter or a scattered light polariscope (SCALP, wherein values reported herein were made using SCALP-5 made by Glasstress Co., Estonia) depending on the ion exchange treatment and the thickness of the article being measured. Where the stress in the substrate and/or portion is generated by exchanging potassium ions into the substrate, a surface stress meter, for example, the FSM-6000 (Orihara Industrial Co., Ltd. (Japan)), is used to measure depth of compression. Unless specified otherwise, compressive stress (including surface CS) is measured by surface stress meter (FSM) using commercially available instruments, for example the FSM-6000, manufactured by Orihara. Surface stress measurements rely upon the accurate measurement of the stress optical coefficient (SOC), which is related to the birefringence of the glass. Unless specified otherwise, SOC is measured according to Procedure C (Glass Disc Method) described in ASTM standard C770-16, entitled "Standard Test Method for Measurement of Glass Stress-Optical Coefficient," the contents of which are incorporated herein by reference in their entirety. Where the stress is generated by exchanging sodium ions into the substrate, and the article being measured is thicker than about 400 $\mu$m, SCALP is used to measure the depth of compression and central tension (CT). Where the stress in the substrate and/or portion is generated by exchanging both potassium and sodium ions into the substrate and/or portion, and the article being measured is thicker than about 400 $\mu$m, the depth of compression and CT are measured by SCALP. Without wishing to be bound by theory, the exchange depth of sodium may indicate the depth of compression while the exchange depth of potassium ions may indicate a change in the magnitude of the compressive stress (but not the change in stress from compressive to tensile). The refracted near-field (RNF; the RNF method is described in U.S. Patent No. 8,854,623, entitled "Systems and methods for measuring a profile characteristic of a glass sample", which is incorporated herein by reference in its entirety) method also may be used to derive a graphical representation of the stress profile. When the RNF method is utilized to derive a graphical representation of the stress profile, the maximum central tension value provided by SCALP is utilized in the RNF method. The graphical representation of the stress profile derived by RNF is force balanced and calibrated to the maximum central tension value provided by a SCALP measurement. As used herein, "depth of layer" (DOL) means the depth that the ions have exchanged into the substrate and/or portion (e.g., sodium, potassium). Throughout the disclosure, DOL is measured in accordance with ASTM C-1422. Without wishing to be bound by theory, a DOL is usually greater than or equal to the corresponding DOC. Through the disclosure, when the maximum central tension cannot be measured directly by SCALP (as when the article being measured is thinner than about 400 $\mu$m) the maximum central tension can be approximated by a product of a maximum compressive stress and a depth of compression divided by the difference between the thickness of the substrate and twice the depth of compression, wherein the compressive stress and depth of compression are measured by FSM.

In aspects, the substrate **103** may comprise a first compressive stress region at the first major surface **105** that can extend to a first depth of compression from the first major surface **105.** In aspects, the substrate **103** may comprise a second compressive stress region at the second major surface **107** that can extend to a second depth of compression from the second major surface **107.** In aspects, the first depth of compression and/or the second depth of compression as a percentage of the substrate thickness **109** can be about 5% or more, about 10% or more, about 12% or more, about 15% or more, about 17% or more, about 30% or less, about 25% or less, about 22% or less, about 20% or less, about 17% or less, or about 15% or less. In aspects, the first depth of compression and/or the second depth of compression as a percentage of the substrate thickness **109** can range from about 5% to about 30%, from about 10% to about 25%, from about 10% to about 22%, from about 12% to about 20%, from about 12% to about 17%, from about 15% to about 17%, or any range or subrange therebetween. In aspects, the first depth of compression and/or the second depth of compression can be about 1 $\mu$m or more, about 10 $\mu$m or more, about 15 $\mu$m or more, about 20 $\mu$m or more, about 25 $\mu$m or more, about 30 $\mu$m or more, about 200 $\mu$m or less, about 150 $\mu$m or less, about 100 $\mu$m or less, about 60 $\mu$m or less, about 45 $\mu$m or less, about 30 $\mu$m or less, or about 20 $\mu$m or less. In aspects, the first depth of compression and/or the second depth of compression can range from about 1 $\mu$m to about 200 $\mu$m, from about 1 $\mu$m to about 150 $\mu$m, from about 10 $\mu$m to about 100 $\mu$m, from about 15 $\mu$m to about 600 $\mu$m, from about 20 $\mu$m to about 45 $\mu$m, from about 20 $\mu$m to about 30 $\mu$m, or any range or subrange therebetween. By providing a first portion comprising a first glass-based, glass-ceramic, and/or ceramic-based portion comprising a first depth of compression and/or a second depth of compression from about 1% to about 30% of the first thickness, good impact and/or puncture resistance can be enabled.

In aspects, the first compressive stress region can comprise a maximum first compressive stress, and/or the second compressive stress region can comprise a maximum second compressive stress. In further aspects, the maximum first compressive stress and/or the maximum second compressive stress can be about 100 MegaPascals (MPa) or more, about 300 MPa or more, 400 MPa or more, about 500 MPa or more, about 600 MPa or more, about 700 MPa or more, about 1,500 MPa or less, about 1,200 MPa or less, about 1,000 MPa or less, or about 800 MPa or less. In further aspects, the maximum first compressive stress and/or the maximum second compressive stress can range from about 100 MPa to about 1,500 MPa, from about 100 MPa to about 1,200 MPa, from about 300 MPa to about 1,200 MPa, from about 300 MPa to about 1,000 MPa, from about 400 MPa to about 1,000 MPa, from about 500 MPa to about 1,000 MPa, from about 600 MPa to about 900 MPa, from about 700 MPa to about 800 MPa, or any range or subrange therebetween. By providing a maximum first compressive stress and/or a maximum second compressive stress from about 100 MPa to about 1,500 MPa, good impact and/or puncture resistance can be enabled.

In aspects, the substrate **103** may comprise a tensile stress region. The tensile stress region can be positioned between the first compressive stress region and the second compressive stress region. In aspects, the tensile stress region can comprise a maximum tensile stress. In further aspects, the maximum first stress can be about 10 MPa or more, about 20 MPa or more, about 30 MPa or more, about 100 MPa or less, about 80 MPa or less, or about 60 MPa or less. In further aspects, the maximum tensile stress can range from about 10 MPa to about 100 MPa, from about 10 MPa to about 80 MPa, from about 10 MPa to about 60 MPa, from about 20 MPa to about 100 MPa, from about 20 MPa to about 80 MPa, from about 20 MPa to about 60 MPa, from about 30 MPa to about 100 MPa, from about 30 MPa to about 80 MPa, from about 30 MPa to about 60 MPa, or any range or subrange therebetween. Providing a maximum tensile stress from about 10 MPa to about 100 MPa can enable good impact and/or puncture resistance.

As used herein, if a first layer and/or component is described as "disposed over" a second layer and/or component, other layers may or may not be present between the first layer and/or component and the second layer and/or component. Furthermore, as used herein, "disposed over" does not refer to a relative position with reference to gravity. For example, a first layer and/or component can be considered "disposed over" a second layer and/or component, for example, when the first layer and/or component is positioned underneath, above, or to one side of a second layer and/or component. As used herein, a first layer and/or component described as "bonded to" a second layer and/or component means that the layers and/or components are bonded to each other, either by direct contact and/or bonding between the two layers and/or components or via an adhesive layer. As used herein, a first layer and/or component described as "contacting" or "in contact with" a second layer and/or components refers to direct contact and includes the situations where the layers and/or components are bonded to each other. As used herein, a first layer and/or component described as "disposed on" a second layer and/or component means that the layers do not have any other layers therebetween other than an optional layer of a coupling agent or are bonded together. Consequently, a first layer disposed over a second layer may further be disposed on, in contact with, and/or bonded to the second layer.

In aspects, as shown in **FIGS. 2A-2C,** the coated article **201, 211, or 221** can comprise an optical stack **203** comprising a third major surface **205** disposed on the first major surface **105** of the substrate **103.** As shown, the optical stack **203** can comprise a fourth major surface **207** opposite the third major surface **205** with a stack thickness **209** defined therebetween. In aspects, the stack thickness **209** can be about 10 nanometers (nm) or more, about 50 nm or more, about 100 nm or more, about 300 nm or more, about 500 nm or more, about 700 nm or more, about 1 $\mu$m or more, about 10 $\mu$m or less, about 5 $\mu$m or less, about 2 $\mu$m or less, or about 1 $\mu$m or less. aspects, the stack thickness **209** can range from about 10 nm to about 10 $\mu$m, from about 50 nm to about 5 $\mu$m, from about 100 nm to about 2 $\mu$m, from about 300 nm to about 1 $\mu$m, from about 500 nm to about 1 $\mu$m, or any range or subrange therebetween. In exemplary aspects, the stack thickness **209** can range from 10 nm to 10 $\mu$m, from 50 nm to 5 $\mu$m, or from 50 nm to 500 nm.

In further aspects, the optical stack **203** can comprise an antireflective (AR) coating, a band-pass filter coating, an edge neutral mirror, a beam splitter coating, a multi-layer high-reflectance coating, and/or an edge filter coating. For example, the anti-reflective coating of the optical stack **203** can be positioned between the surface-modifying layer (e.g., anti-fingerprint coating **113)** and the substrate **103.** In even further aspects, the optical stack **203** (e.g., anti-reflective coating) can comprise two or more layers with differing refractive index values, for example, with a first low refractive index (RI) from about 1.3 to about 1.6 and a second high refractive index (RI) from about 1.6 to about 3.0. In still further aspects, the two or more layers of the optical stack **203** can form an alternative set of layers, for example, 2 sets or more, 3 sets or more, 5 sets or more, or 10 sets or more, for example, from 2 to 15 periods, from 2 to 10 periods, from 2 to 12 periods, from 3 to 8 periods, from 3 to 6 periods, or any range or subrange therebetween.

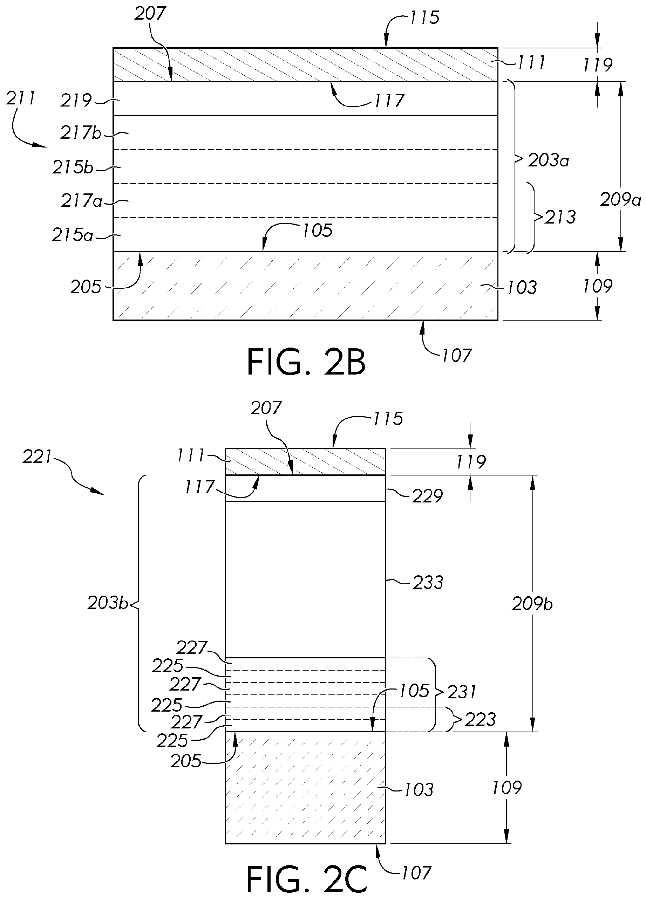

In aspects, as shown in **FIG. 2B,** the coated article **211** comprises optical stack **203a** comprising a plurality of a silicon-containing oxide, a silicon-containing nitride, and/or a silicon-containing oxynitride layers. For example, the optical stack **203a** can be an anti-reflective coating. As shown, the optical stack **203a** can comprise one or more periods **213** comprising two or more layers with different refractive indices, for example, a first low RI layer **215a** and a second high RI layer **217a.** For example, the optical stack **203a** shown in **FIG. 2B** has 2 periods **213** comprising first low RI layers **215a and 215b** (L)and a second high RI layers **217a and 217b** (H) that alternate in the following sequence of layers: L/H/L/H, although H/L/H/L could be provided in other aspects. An absolute value of a difference between the first low RI layer **215a** and a second high RI layer **217a** can be about 0.01 or more, about 0.05 or more, about 0.1 or more, or even 0.2 or more. Exemplary materials for the first low RI layer **215a** include $SiO_2$, $Al_2O_3$, $GeO_2$, $SiO_2$, $AlO_xN_y$, $SiO_xN_y$, $Si_uAl_vO_xN_y$, MgO, and $MgAl_2O_4$. Exemplary materials for the second high RI layer **217a** include $Si_uAl_vO_xN_y$, AlN, oxygen-doped $SiN_x$, $SiN_x$, $Si_3N_4$, $AlO_xN_y$, $SiO_xN_y$, $Ta_2O_5$, $Nb_2O_5$, $HfO_2$, $TiO_2$, $ZrO_2$, $Y_2O_3$, $ZrO_2$, $Al_2O_3$, and diamond-like carbon. The oxygen content of the materials for the high RI layer(s) 130B may be minimized, especially in $SiN_x$ or $AlN_x$ materials. The foregoing materials may be hydrogenated up to about 30% by weight. As used herein, it is to be understood that the subscripts (e.g., "u," "v," "x," "y," and "z") range from greater than 0 to 1, where the subscripts sum to 1 to represent an "atomic fraction formula." *See,* for example: (i) Charles Kittel, Introduction to Solid State Physics, seventh edition, John Wiley & Sons, Inc., NY, 1996, pp. 611-627; (ii) Smart and Moore, Solid State Chemistry, An introduction, Chapman & Hall University and Professional Division, London, 1992, pp. 136-151; and (iii) James F. Shackelford, Introduction to Materials Science for Engineers, Sixth Edition, Pearson Prentice Hall, New Jersey, 2005, pp. 404-418.The balance of the material (i.e., 1 minus the sum of the subscripts) is the first atom (e.g., $SiN_x$ with x = 0.57 actually corresponds to $Si_{0.43}N_{0.57}$, which is the same as $Si_3N_4$). Also, the sum of all subscripts is greater than 0.

In aspects, the optical stack **203a** can include the antireflective structure, antireflective coating, or outer optical film described in U.S. Patent No. 10,948,629, issued March 16, 2021, U.S. Published Application No. 2022/0011468, and/or WIPO Publication WO 2022/125846, which are incorporated by reference in their entirety. In aspects, as shown in **FIG. 2B,** the optical stack **203a** can comprise a capping layer **219.** In further aspects, the capping layer **219** can comprise a low refractive index material, which can be the same material as the first low RI layer **215a.** In further aspects, the capping layer **219** can comprise a silicon-containing oxide (e.g., silicon dioxide), a silicon-containing nitride (e.g., an oxide-doped silicon nitride, silicon nitride, etc.), and a silicon-containing oxynitride (e.g., silicon oxynitride). An exemplary aspect of the capping layer is silicon dioxide ($SiO_2$). In aspects, as shown, the layer of the optical stack **203** closest to the substrate **103** can be a low index layer (i.e., first low RI layer **215a)** and the layer closest to the surface-modifying layer (e.g., anti-fingerprint coating **113)** can be a low index layer (e.g., capping layer **219).** An exemplary combination of materials for the optical stack is $SiO_2$ for the first low RI layer, silicon nitride (e.g., $Si_3N_4$, $SiN_x$) or silicon oxynitride ($SiO_xN_y$) for the second high RI layer, and silicon dioxide ($SiO_2$) for the capping layer.

In aspects, the coated article **211** can comprise a stack thickness **209a** corresponding to a physical thickness of the optical stack **203a** in a range from about 50 nm to less than 500 nm, from about 75 nm to about 490 nm, from about 100 nm to about 180 nm, from about 125 nm to about 475 nm, from about 150 nm to about 450 nm, from about 175 nm to about 425 nm, from about 200 nm to about 400 nm, from about 225 nm to about 375 nm, from about 250 nm to about 350 nm, from about 250 nm to about 340 nm, or any range or subrange therebetween. As used herein, the term "optical thickness" is determined by (n*d), where "n" refers to the RI of the sub-layer and "d" refers to the physical thickness of the layer. In aspects, at least one layer in the optical stack **203a** can have an optical thickness from about 2 nm to about 200 nm, from about 10 nm to about 100 nm, from about 15 nm to about 90 nm, from about 50 nm to about 80 nm, or any range or subrange therebetween. In further aspects, the first low RI layers **215a and 215b** in periods **213** in the optical stack **203** can be within or more of the ranges mentioned in the previous sentence. In aspects, a combined physical thickness of the second high RI layers **217a and 217b** can be about 90 nm or more, about 100 nm or more, about 120 nm or more, about 130 nm or more, about 150 nm or more, or less than 500 nm. For example, the combined physical thickness of the second high RI layers **217a and 217b** can range from about 90 nm to less than 500 nm, from about 100 nm to about 300 nm, from about 120 nm to about 200 nm, or any range or subrange therebetween. In aspects, the combined physical thickness of the second high RI layers **217a and 217b** as a percentage of the physical thickness of the stack thickness **209a** can be about 30% or more, about 35% or more, about 40% or more, or about 45% or more, for example, ranging from about 35% to about 75%, from about 40% to about 65%, from about 45% to about 55%, or any range or subrange therebetween.

In aspects, the optical stack **203a** of the coated article **211** can comprise a residual stress of less than about +50 MPa (tensile) to about -1000 MPa (compression). In some implementations of the article 100, the anti-reflective coating is characterized by a residual stress from about -50 MPa to about -1000 MPa (compression), or from about -75 MPa to about -800 MPa (compression). Unless otherwise noted, residual stress in the anti-reflective coating is obtained by measuring the curvature of the substrate **103** before and after deposition of the anti-reflective coating, and then calculating residual film stress according to the Stoney equation according to principles known and understood by those with ordinary skill in the field of the disclosure.

In aspects, the optical stack **203a** and/or the coated article **211** may exhibit a visible photopic average reflectance of about 1% or less, about 0.9% or less, about 0.8% or less, about 0.7% or less, about 0.6% or less, about 0.5% or less, about 0.4% or less, about 0.3% or less, or about 0.2% or less, over the optical wavelength regime. These photopic average reflectance values may be exhibited at incident illumination angles in the range from about 0° to about 20°, from about 0° to about 40°, or from about 0° to about 60°. As used herein, "photopic average reflectance" mimics the response of the human eye by weighting the reflectance versus wavelength spectrum according to the human eye's sensitivity. Photopic average reflectance may also be referred to as the luminance, or tristimulus Y value of reflected light, according to known conventions, for example CIE color space conventions. The photopic average reflectance ($R_p$) is defined as the spectral reflectance, $R(\lambda)$, multiplied by the illuminant spectrum, $I(\lambda)$, and the CIE's color matching function, $\overline{y}(\lambda)$, related to the eye's spectral response:

$$\langle R_p \rangle = \int_{380\ nm}^{720\ nm} R(\lambda) \times I(\lambda) \times \overline{y}(\lambda)\, d\lambda \,.$$

Further, the article exhibits a CIE a* value, in reflectance, from about -10 to +2 and a CIE b* value, in reflectance, from -10 to +2, the CIE a* and CIE b* values each measured on the optical film structure at a normal incident illumination angle. In aspects, the optical stack **203a** and/or the coated article **211** can exhibit a photopic average light transmission of about 90% or greater, 92% or greater, 94% or greater, 96% or greater, or 98% or greater, over the optical wavelength regime. In some embodiments, the optical stack **203a** and/or the coated article **211** exhibits an average light transmission of about 87% or greater, 88% or greater, 89% or greater, 90% or greater, 91% or greater, 92% or greater, 93% or greater, 94% or greater, or 95% or greater, over the optical wavelength regime in the infrared spectrum from 800 nm to 1000 nm, from 900 nm to 1000 nm, or from 930 nm to 950 nm. In aspects, the optical stack **203a** and/or the coated article **211** can exhibit a hardness of 8 GPa or greater measured at an indentation depth of about 100 nm or a maximum hardness of 9 GPa or greater measured over an indentation depth range from about 100 nm to about 500 nm, the hardness and the maximum hardness measured by a Berkovich Indenter Hardness Test (as defined below).

In aspects, as shown in **FIG. 2B,** the coated article **211** comprises optical stack **203a** comprising an optical film **231,** a scratch-resistant layer **233,** and an optional capping layer **229.** In aspects, the optical stack **203b** can include the scratch resistant coating, anti-reflective coating, and/or optical film structure described in U.S. Patent No. 9,328,016, issued May 3, 2016, U.S. Patent No. 9,684,097, issued June 20, 2017, U.S. Patent No. 9,703,011, issued July 11, 2017, U.S. Patent No. 9,079,802, issued July 14, 2015, U.S. Patent No. 9,726,786, issued August 8, 2017, U.S. Patent No. 10,416,352, issued September 17, 2019, which are incorporated by reference in their entirety. For example, the optical stack **203b** can be an anti-reflective coating and/or a scratch-resistant coating.

In further aspects, as shown in **FIG. 2C,** the optical film **130** of the optical stack **203b** can comprise one or more periods **223** comprising two or more layers with different refractive indices, for example, a first low RI layer **225** and a second high RI layer **227.** For example, the optical stack **203b** shown in **FIG. 2C** has 3 periods **223** forming the optical film **231** with alternating first low RI layers **225** and second high RI layers **227.** In even further aspects, the optical film **231** can comprise any number of periods, for example, within one or more of the ranges discussed above for the optical stack **203a.** An absolute value of a difference between the first low RI layers **225** and the second high RI layers **227** can be about 0.01 or more, about 0.05 or more, about 0.1 or more, or even 0.2 or more. In further aspects, the first low RI layers **225** can comprise any of the materials discussed above for the first low RI layer **215a,** for example, silicon dioxide ($SiO_2$). In further aspects, the second high RI layers **227** can comprise any of the materials discussed above for the second high RI layer **217a,** for example, $SiO_xN_y$. In further aspects, a layer of the first low RI sub-layers **225** and/or the second high RI sub-layers **227** can comprise an optical thickness (n*d) in the range from about 2 nm to about 200 nm, from about 10 nm to about 100 nm, from about 15 nm to about 100 nm, or any range or subrange therebetween. In even further aspects, all of the layers in the optical film **130** or all of the second high RI layers in the optical film **130** can have an optical thickness within one or more of the ranges mentioned in the previous sentence. In further aspects, a layer of the first low RI sub-layers **225** and/or the second high RI sub-layers **227** can comprise a physical thickness from about 10 nm to about 800 nm, from about 10 nm to about 500 nm, from about 10 nm to about 300 nm, from about 10 nm to about 200 nm, from about 20 nm to about 100 nm, or any range or subrange therebetween. In further aspects, the optical stack **203** and/or any one or of the layers or sections therein (e.g., optical film **231,** a scratch-resistant layer **233,** an optional capping layer **229**) may exhibit an extinction coefficient (at a wavelength of about 400 nm) of about $10^{-4}$ or less.

In further aspects, as shown in **FIG. 2C,** the scratch-resistant layer **233** can include an inorganic carbide, nitride, oxide, diamond-like material, or combination of these. Examples of suitable materials for the scratch-resistant layer **233** include metal oxides, metal nitrides, metal oxynitride, metal carbides, metal oxycarbides, and/or combinations thereof combination thereof. Exemplary metals include B, Al, Si, Ti, V, Cr, Y, Zr, Nb, Mo, Sn, Hf, Ta and W. Specific examples of materials that may be utilized in the scratch-resistant layer **233** may include $Al_2O_3$, AlN, $AlO_xN_y$, $Si_3N_4$, $SiO_xN_y$, $Si_uAl_vO_xN_y$, diamond, diamond-like carbon, $Si_xC_y$, $Si_xO_yC_z$, $ZrO_2$, $TiO_xN_y$, or combinations thereof. In even further aspects, the scratch-resistant layer **233** can comprise the same material as the second high RI layers **227,** for example, $SiO_xN_y$. In even further aspects, a physical thickness of the scratch-resistant layer and/or the optical stack can be from about 0.05 $\mu$m to about 3 $\mu$m, from about 0.1 $\mu$m to about 3 $\mu$m, from about 0.2 $\mu$m to about 3 $\mu$m, from about 0.3 $\mu$m to about 2.2 $\mu$m, from about 0.5 $\mu$m to about 2.1 $\mu$m, from about 1 $\mu$m to about 2.1 $\mu$m, from about 1.8 $\mu$m to about 2.1 $\mu$m, or any range or subrange therebetween. In exemplary aspects, a physical thickness of the scratch-resistant layer can be from 0.05 $\mu$m to 3 $\mu$m, from 0.3 $\mu$m to 2.2 $\mu$m, or from 1 $\mu$m to 2.1 $\mu$m. The scratch-resistant layer **233** and/or the optical stack **203b** may exhibit a hardness of about 8 GPa or greater, about 10 GPa or greater, about 13 GPa or greater, or about 17 GPa or greater, as measured by the Berkovich Indenter Hardness Test (as described below).

Although not shown, it is to be understood that the scratch-resistant layer can be sandwiched by portions of the optical film. For example, 3 or more periods can be positioned between the scratch-resistant layer and the substrate while 2 or more periods can be positioned between the scratch-resistant layer and the surface-modifying layer (e.g., anti-fingerprint coating).

In further aspects, as shown in **FIG. 2C,** the optical stack **203b** can comprise capping layer **229** disposed over (e.g., disposed on) the scratch-resistant layer. In even further aspects, the capping layer **229** can include a low refractive index material, such as $SiO_2$, $Al_2O_3$, $GeO_2$, $SiO_2$, $AlO_xN_y$, $SiO_xN_y$, $Si_uAl_vO_xN_y$, MgO, $MgF_2$, $BaF_2$, $CaF_2$, $DyF_3$, $YbF_3$, $YF_3$, or $CeF_3$. In further aspects, the capping layer **229** can comprise the same material as the first high RI layers **225,** for example, $SiO_2$. In further aspects, a thickness of the capping layer **229** can be from about 10 nm to about 120 nm, from about 20 nm to about 115 nm, from about 50 nm to about 110 nm, from about 80 nm to about 110 nm, from about 90 nm to about 105 nm, or any range or subrange therebetween. The capping layer **229** may exhibit an intrinsic hardness in the range from about 7 GPa to about 10 GPa, as measured by the Berkovich Indenter Hardness Test (as measured on the surface of a layer of the same material of the capping layer, formed in the same manner, but having a thickness of about 1 micrometer or greater).

In further aspects, a stack thickness **209b** corresponding to a physical thickness of the optical stack **203b** can range from about 0.5 $\mu$m to about 3 $\mu$m, from about 1 $\mu$m to about 3 $\mu$m, from about 1.2 $\mu$m to about 3 $\mu$m, from about 1.5 $\mu$m to about 3 $\mu$m from about 2 $\mu$m to about 2.6 $\mu$m, or any range or subrange therebetween. In further aspects, the optical stack **203b** can exhibit an average light reflectance of about 0.5% or less, about 0.25% or less, about 0.1% or less, or even 0.05% or less over the optical wavelength regime. In further aspects, the optical stack **203b** can exhibit an average transmittance or average reflectance having an average oscillation amplitude of about 5 percentage points or less over the optical wavelength regime. In further aspects, the optical stack **203b** may exhibit an average light transmission of 80% or greater, 82% or greater, 85% or greater, 90% or greater, 90.5% or greater, 91% or greater, 91.5% or greater, 92% or greater, 92.5% or greater, 93% or greater, 93.5% or greater, 94% or greater, 94.5% or greater, or 95% or greater.

The optical stack **203, 203a, or 203b** may be formed using various deposition methods, for example, vacuum deposition techniques, chemical vapor deposition (e.g., plasma enhanced chemical vapor deposition (PECVD), low-pressure chemical vapor deposition, atmospheric pressure chemical vapor deposition, and plasma-enhanced atmospheric pressure chemical vapor deposition), physical vapor deposition (e.g., reactive or nonreactive sputtering or laser ablation), thermal or e-beam evaporation and/or atomic layer deposition. Liquid-based methods may also be used, for example, printing, spraying, or slot coating. Where vacuum deposition is utilized, inline processes may be used to form the optical stack **203, 203a, or 203b** in one deposition run. In aspects, the vacuum deposition can be made by a linear PECVD source. In aspects, the optical stack **203, 203a, or 203b** can be prepared using a sputtering process (e.g., a reactive sputtering process), chemical vapor deposition (CVD) process, plasma-enhanced chemical vapor deposition process, or some combination of these processes. In aspects, the optical stack **203a or 203b** comprising low RI layer(s) **215a, 215b, or 225** and high RI layer(s) **217a, 217b, or 227** can be prepared according to a reactive sputtering process. According to some embodiments, optical stack **203a or 203b** (including low RI layer **215a, 215b, or 225,** high RI layer **217a, 217b, or 227** and capping layer **219 or 229)** can be fabricated using a metalmode, reactive sputtering in a rotary drum coater. The reactive sputtering process conditions were defined through careful experimentation to achieve the desired combinations of hardness, refractive index, optical transparency, low color, and controlled film stress.

In further aspects, the optical stack **203** can comprise a gradient coating comprising a refractive index gradient. For example, the gradient coating of the optical stack **203** can be positioned between the surface-modifying layer (e.g., anti-fingerprint coating **113)** and the substrate **103.** In even further aspects, the refractive index gradient can span a range of refractive index values of about 0.2 or more, about 0.3 or more, about 0.4 or more, about 1 or less, about 0.8 or less, about 0.6 or less, or about 0.5 or less, for example, from about 0.2 to about 1, from about 0.3 to about 0.8, from about 0.4 to about 0.6, or any range or subrange therebetween. In even further aspects, the gradient coating can comprise a concentration gradient of one or more of oxygen, nitrogen, and/or silicon. It should be understood, however, that other functional coatings may be provided in the optical stack **203** to achieve predetermined optical properties of the coated article **201, 211, or 221.**

According to one or more aspects, an anti-reflective coating can be used in combination with an anti-glare (AG) surface. Anti-glare surface treatments can impact the performance of anti-reflective coatings. Thus, selection of the proper anti-glare surface can be important for optimal performance, particularly in difficult use environments, such as vehicle interiors. In such environments, it may be beneficial for anti-glare surfaces on a cover glass to have the minimum sparkle and provide the appropriate anti-glare effect and tactile while meeting a required Contrast Ratio (CR) under sunlight. For example, a sample can be prepared with a chemically etched Ultra-Low Sparkle (ULS) AG surface on a glass substrate made of Corning® Gorilla® Glass with an anti-reflective coating according to embodiments of this disclosure, and an easy-to-clean (ETC) coating to provide stable color appearance with wide-viewing angles to facilitate on sunlight viewability.

Anti-glare surfaces can be prepared on a Corning® Gorilla® Glass substrate by using a chemical etching method that enables ultra-low sparkle performance suitable for high resolution display up to 300 pixels per inch (PPI). Anti-glare glass optical properties can be analyzed, including with and without contributions from specular reflection (i.e., specular component excluded (SCE) or specular component included (SCI)), transmission haze, gloss, distinctness of image (DOI), and sparkle. Further information regarding these properties and how these measurement are made can be found in (1) C. Li and T. Ishikawa, Effective Surface Treatment on the Cover Glass for Auto-Interior Applications, SID Symposium Digest of Technical Papers Volume 1, Issue 36.4, pp. 467 (2016); (2) J. Gollier, G.A. Piech, S.D. Hart, J.A. West, H. Hovagimian, E.M. Kosik Williams, A. Stillwell and J. Ferwerda, Display Sparkle Measurement and Human Response, SID Symposium Digest of Technical Papers Volume 44, Issue 1 (2013); and (3) J. Ferwerda, A. Stillwell, H. Hovagimian and E.M. Kosik Williams, Perception of sparkle in anti-glare display screen, Journal of the SID, Vol 22, Issue 2 (2014), the contents of which are incorporated herein by reference.

The balance of the five metrics of SCE/SCI (see previous paragraph), transmission haze, gloss, distinctness of image (DOI), and sparkle is important for maximizing the benefits of an anti-glare for display readability, tactility on the glass surface, and the aesthetic appearance of high-performance touch displays in applications such as vehicle interiors. Sparkle is a micro-scattering interaction of the anti-glare surface with LCD pixels to create bright spots degrading image quality, especially at high resolution. The sparkle effect can be characterized using the method of the Pixel Power Deviation with reference (PPDr) to examine the sparkle effect on different resolution displays. For example, ultra-low sparkle anti-glare glass with less than 1% PPDr will have invisible sparkle effect on a display of less than 300 pixels per-inch (PPI). However, up to 4% PPDr may be acceptable depending on the contents of display, based on the preference of the end-user. In vehicular or automotive interior settings, about 120 PPI to about 300 PPI is acceptable, and displays over 300 PPI have diminishing value.

In aspects, the substrate **103** and/or an anti-glare surface of the optical stack **203, 203a, and/or 203b** can comprise a textured surface, for example, having particulates, a mechanically roughened surface, and/or a chemically roughened surface. In further aspects, the anti-glare and/or textured surface can be formed by treating the corresponding surface with an anti-glare treatment. Exemplary aspects of anti-glare treatments include chemical or physical surface treatment to form irregularities and/or etching the surface (e.g., with hydrofluoric acid) to create an etched region exhibiting anti-glare properties.

Throughout the disclosure, hardness of the optical stack is measured using the "Berkovich Indenter Hardness Test." As used herein, the "Berkovich Indenter Hardness Test" measures the hardness of a material by indenting the surface (e.g., fourth major surface **207)** with a diamond Berkovich indenter to form an indent to an indentation depth in the range from about 50 nm to about 1000 nm (or the entire thickness of the optical stack **203, 203a, or 203b,** whichever is less) and measuring the hardness from this indentation at various points along the entire indentation depth range, along a specified segment of this indentation depth (e.g., in the depth range from about 100 nm to about 500 nm), or at a particular indentation depth (e.g., at a depth of 100 nm, at a depth of 500 nm, etc.) generally using the methods set forth in Oliver, W.C. and Pharr, G. M., "An improved technique for determining hardness and elastic modulus using load and displacement sensing indentation experiments", J. Mater. Res., Vol. 7, No. 6, 1992, 1564-1583; and Oliver, W.C. and Pharr, G.M., "Measurement of Hardness and Elastic Modulus by Instrument Indentation: Advances in Understanding and Refinements to Methodology", J. Mater. Res., Vol. 19, No. 1, 2004, 3-20. Further, when hardness is measured over an indentation depth range (e.g., in the depth range from about 100 nm to about 500 nm), the results can be reported as a maximum hardness within the specified range, wherein the maximum is selected from the measurements taken at each depth within that range. As used herein, "hardness" and "maximum hardness" both refer to as-measured hardness values, not averages of hardness values. Similarly, when hardness is measured at an indentation depth, the value of the hardness obtained from the Berkovich Indenter Hardness Test is given for that particular indentation depth.

The optical stack **203, 203a or 203b,** if present, can comprise a hardness of greater than about 8 GPa, by the Berkovich Indenter Hardness Test at an indentation depth of about 100 nm. The optical stack **203** may exhibit a hardness of about 8 GPa or greater, about 9 GPa or greater, about 10 GPa or greater, about 11 GPa or greater, about 12 GPa or greater, about 13 GPa or greater, about 14 GPa or greater, or about 15 GPa or greater by the Berkovich Indenter Hardness Test at an indentation depth of about 100 nm. For example, the optical stack **203 or 203a,** including the surface-modifying layer (e.g., anti-fingerprint coating **113),** as described herein, may exhibit a hardness of about 8 GPa or greater, about 10 GPa or greater or about 12 GPa or greater, by the Berkovich Indenter Hardness Test at an indentation depth of about 100 nm. In aspects, the optical stack **203 or 203b** can exhibit a hardness ranging from about 8 GPa to about 30 GPa, from about 10 GPa to about 25 GPa, from about 12 GPa to about 20 GPa, from about 16 GPa to about 20 GPa, or any range or subrange therebetween. Such measured hardness values may be exhibited by the optical stack **203, 203a, or 203b** and/or the coated article **101, 201, 211, or 221** over an indentation depth of about 50 nm or greater or about 100 nm or greater (e.g., from about 100 nm to about 300 nm, from about 100 nm to about 400 nm, from about 100 nm to about 500 nm, from about 100 nm to about 600 nm, from about 200 nm to about 300 nm, from about 200 nm to about 400 nm, from about 200 nm to about 500 nm, or from about 200 nm to about 600 nm). Similarly, maximum hardness values of about 8 GPa or greater, about 9 GPa or greater, about 10 GPa or greater, about 11 GPa or greater, about 12 GPa or greater, about 13 GPa or greater, about 14 GPa or greater, or about 15 GPa or greater by the Berkovich Indenter Hardness Test may be exhibited by the optical stack **203** and/or the coated article **101, 201, 211, or 221** over an indentation depth of about 50 nm or greater or about 100 nm or greater (e.g., from about 100 nm to about 300 nm, from about 100 nm to about 400 nm, from about 100 nm to about 500 nm, from about 100 nm to about 600 nm, from about 200 nm to about 300 nm, from about 200 nm to about 400 nm, from about 200 nm to about 500 nm, or from about 200 nm to about 600 nm).

As shown in **FIGS. 1 and 2A-2C,** the coated article **101, 201, 221, or 221** comprises the surface-modifying layer (e.g., anti-fingerprint coating **113**) disposed over the first major surface **105** of the substrate **103.** The surface-modifying layer (e.g., anti-fingerprint coating **113**) comprises an inner surface **117** facing the first major surface **105** of the substrate **103.** In aspects, as shown in **FIG. 1,** the surface-modifying layer (e.g., anti-fingerprint coating **113**) (e.g., inner surface **117**) can be disposed on and/or bonded to the first major surface **105** of the substrate **103.** In aspects, as shown in **FIGS. 1 and 2A-2C,** the surface-modifying layer (e.g., anti-fingerprint coating **113**) comprises an exterior surface **115** that forms an exterior surface of the coated article **101, 201, 211, or 221.** Consequently, a user would interact with the coated article **101, 201, 211, or 221** by, for example, touching the exterior surface **115** or viewing an image through the exterior surface **115.** An anti-fingerprint thickness **119** is defined as an average distance between the inner surface **117** and the exterior surface **115.** In aspects, the anti-fingerprint thickness **119** can be about 10 nm or more, about 20 nm or more, about 50 nm or more, about 100 nm or more, about 200 nm or more, about 600 nm or less, about 500 nm or less, about 400 nm or less, about 350 nm or less, or about 300 nm or less. In aspects, the anti-fingerprint thickness **119** can range from about 10 nm to about 600 nm, from about 20 nm to about 500 nm, from about 50 nm to about 400 nm, from about 100 nm to about 350 nm, from about 200 nm to about 300 nm, or any range or subrange therebetween. The anti-fingerprint thickness **119** is determined from a cross-sectional scanning electron microscope (SEM) image.

Throughout the disclosure, "surface-modifying layer" refers to a layer that is characterized by changing a physical property or other behavior of the coated article. For example, a surface-modifying layer can modify one or more of a water contact angle, an oleic contact angle, a visibility of a fingerprint (e.g., simulated fingerprint), and/or an ability to remove a fingerprint (e.g., by wiping).

In aspects, the surface-modifying layer can be an anti-fingerprint coating. Throughout the disclosure, a surface-modifying layer is an "anti-fingerprint" coating if the coating on a substrate can reduce the visibility of, reduce a color shift of, and/or reduce droplet formation of fingerprint oil disposed thereon relative to the substrate without the coating. As used herein, the visibility of a fingerprint refers to an absolute value of a difference in brightness (e.g., CIELAB L* value) for a portion of the anti-fingerprint coating with the fingerprint oil and another portion of the anti-fingerprint coating without the fingerprint oil. As used herein, the color shift of the substrate refers to a difference in measured color as $\sqrt{(a_1^* - a_2^*)^2 + (b_1^* - b_2^*)^2}$, where a* refers to CIELAB a* values, b* refers to CIELAB b* values, subscript 1 refers to a portion of the anti-fingerprint coating without fingerprint oil, and subscript 2 refers to a portion of the anti-fingerprint coating with fingerprint oil. An anti-fingerprint coating can reduce droplet formation, which can increase a visibility and/or color shift of fingerprint oil, by being oleophilic, as defined below. Additionally, the anti-fingerprint coating can enable the removal of aqueous material (e.g., water droplets, sweat droplets) from the coating, for example, by being hydrophobic, as defined below. In further aspects, the anti-fingerprint coating can exhibit an (e.g., as-formed) water contact angle from 90° to 120°, an (e.g., as-formed) oleic acid contact angle of 40° or less, and a coefficient of friction of 0.25 or less. In further aspects, the easy-to-clean coating can be substantially free and/or free of fluorine. In aspects, a diiodomethane contact angle of an anti-fingerprint coating (e.g., as-formed) can be about 60° or more, about 62° or more, about 65° or more, about 80° or less, about 75° or less, about 73° or less, or about 70° or less. In aspects, a diiodomethane contact angle of an anti-fingerprint coating (e.g., as-formed) can range from about 60° to about 80°, from about 62° to about 75°, from about 65° to about 72°, or any range or subrange therebetween. In aspects, an anti-fingerprint coating can be oleophilic. In aspects, a hexadecane contact angle and/or an oleic acid contact angle of an anti-fingerprint coating (e.g., as-formed) can be about 45° or less, about 40° or less, about 30° or less, about 25° or less, about 20° or less, or the anti-fingerprint coating can wet hexadecane and/or oleic acid. In further aspects, the anti-fingerprint coating (e.g., as formed) wets hexadecane and/or oleic acid. Providing a low diiodomethane contact angle (e.g., about 60° or less) and/or a low hexadecane contact angle (e.g., about 30° or less) can reduce the visibility and/or color shift associated with fingerprints by enabling fingerprint oil to be dispersed across the anti-fingerprint coating rather than beading up into pronounced droplets.

In aspects, the surface-modifying layer can be a fingerprint-hiding coating. Throughout the disclosure, a "fingerprint hiding coating" can reduce the visibility of and/or reduce a color shift of fingerprint oil disposed thereon relative to a glass-based substrate without the coating. As used herein, the visibility of a fingerprint refers to an absolute value of a difference in brightness (e.g., CIELAB L* value) for a portion of the fingerprint-hiding coating with the fingerprint oil and another portion of the fingerprint-hiding coating without the fingerprint oil. As used herein, the color shift of the glass-based substrate refers to a difference in measured color as $\sqrt{((a_1^* - a_2^*)^2 + (b_1^* - b_2^*)^2)}$, where a* refers to CIELAB a* values, b* refers to CIELAB b* values, subscript 1 refers to a portion of the fingerprint-hiding coating without fingerprint oil, and subscript 2 refers to a portion of the fingerprint-hiding coating with fingerprint oil. Specifically, the fingerprint-hiding coating can cause fingerprint oil to spread out over the surface of the fingerprint-hiding coating. Reducing the thickness of fingerprint oil droplets and/or increasing an area of fingerprint-hiding coating covered by the fingerprint oil can decrease a color shift and/or visibility associated with the fingerprint oil. Fingerprint-hiding coatings that can be oleophilic are to be contrasted with other coatings (e.g., anti-fingerprint coatings) that can reduce droplet formation by being oleophobic. Additionally, the fingerprint-hiding coating can enable the removal of aqueous material (e.g., water droplets, sweat droplets) from the coating, for example, by being hydrophobic, as discussed herein. In further aspects, the fingerprint-hiding coating can exhibit an (e.g., as-formed) water contact angle from 90° to 120°, an (e.g., as-formed) oleic acid contact angle of 40° or less, and a coefficient of friction of 0.25 or less. In further aspects, the fingerprint-hiding coating can be a fluorine-containing material. Alternatively, in further aspects, the fingerprint-hiding coating can be substantially free and/or free of fluorine. In further aspects, the finger-hiding coating can exhibit a hexadecane contact angle of 20° or less (or wet hexadecane) and/or a diiodomethane contact angle of 60° or more.

In aspects, the surface-modifying layer can be an easy-to-clean coating. Throughout the disclosure, a surface-modifying layer is an "easy-to-clean" coating if the coating on a glass-based substrate can repel material and/or facilitate removal of material disposed thereon relative to the glass-based substrate without the coating. As used herein, an ability to repel material is determined based on a contact angle with higher contact angles associated with greater repulsion. As used herein, an ability to remove material is measured by wiping the material disposed on the surface (e.g., coating or glass-based substrate) with a cheesecloth (see details from the Cheesecloth Abrasion Test with the modification that the material is disposed on the surface before wiping) and the visibility of the material is monitored. A decreased visibility (e.g., fewer wiping cycles to achieve a predetermined reduction is visibility) is associated with a coating facilitating removal of material disposed thereon. In further aspects, the easy-to-clean coating can exhibit an (e.g., as-formed) water contact angle from 90° to 120°, an (e.g., as-formed) oleic acid contact angle of 50° or more, and a coefficient of friction of 0.25 or less. In further aspects, the easy-to-clean coating can be a fluorine-containing material. Alternatively, in further aspects, the easy-to-clean coating can be substantially free and/or free of fluorine. In aspects, a diiodomethane contact angle of an anti-fingerprint coating (e.g., as-formed) can be about 60° or more, about 62° or more, about 65° or more, about 80° or less, about 75° or less, about 73° or less, or about 70° or less. In aspects, a diiodomethane contact angle of an anti-fingerprint coating (e.g., as-formed) can range from about 60° to about 80°, from about 62° to about 75°, from about 65° to about 72°, or any range or subrange therebetween. In aspects, the an anti-fingerprint coating can be oleophilic. In aspects, a hexadecane contact angle of the an anti-fingerprint coating (e.g., as-formed) can be about 45° or less, about 40° or less, about 30° or less, about 25° or less, about 20° or less, or the an anti-fingerprint coating can wet hexadecane. In further aspects, the an anti-fingerprint coating (e.g., as formed) wets hexadecane. Providing a low diiodomethane contact angle (e.g., about 60° or less) and/or a low hexadecane contact angle (e.g., about 30° or less) can reduce the visibility and/or color shift associated with fingerprints by enabling fingerprint oil to be dispersed across the surface-modifying layer rather than beading up into pronounced droplets.

Throughout the disclosure, an elastic modulus (e.g., Young's modulus) of the anti-fingerprint coating is determined using nanoindentation with a Berkovich diamond indenter tip. See: Fischer-Cripps, A.C., "Critical Review of Analysis and Interpretation of Nanoindentation Test Data," Surface & Coatings Technology, 200, 4153 - 4165 (2006); and Hay, J., Agee, P, and Herbert, E., "Continuous Stiffness measurement During Instrumented Indentation Testing, Experimental Techniques," 34 (3) 86 - 94 (2010). For coatings, instantaneous estimates of the elastic modulus are measured as a function of indentation depth. The elastic modulus is taken as the maximum value of the instantaneous estimate of the elastic modulus for measurements within the anti-fingerprint thickness **119** minus 5 nm from the exterior surface **115**. Without wishing to be bound by theory, if a coating is of sufficient thickness, then it is then possible to isolate the properties of the coating from an adjacent coating based on the resulting response profiles as a function of depth. Extraction of reliable nanoindentation data is based on well-established protocols described in the above-mentioned references. Otherwise, these metrics can be subject to significant errors. In aspects, an elastic modulus of the surface-modifying layer (e.g., anti-fingerprint coating **113**) can be about 9 GPa or more, about 10 GPa or more, about 12 GPa or more, about 15 GPa or more, about 20 GPa or more, about 25 GPa or more, about 70 GPa or less, about 60 GPa or less, about 50 GPa or less, about 40 GPa or less, about 38 GPa or less, about 35 GPa or less, about 30 GPa or less, or about 25 GPa or less. In aspects, an elastic modulus of the surface-modifying layer (e.g., anti-fingerprint coating **113**) can range from about 9 GPa to about 70 GPa, from about 9 GPa to about 60 GPa, from about 9 GPa to about 50 GPa, from about 10 GPa to about 40 GPa, from about 12 GPa to about 38 GPa, from about 15 GPa to about 35 GPa, from about 20 GPa to about 30 GPa, or any range or subrange therebetween. As discussed below in the Examples, it has been discovered that surface-modifying layers (e.g., anti-fingerprint coatings) in accordance with the present disclosure having an elastic modulus from about 9 GPa to about 40 GPa possess unexpectedly improved abrasion resistance.

In aspects, the surface-modifying layer (e.g., anti-fingerprint coating **113**) and/or the coated article **101, 201, 211, or 221** can comprise an average transmittance (as described above) of about 80% or more, about 85% or more, about 88% or more, about 89% or more, about 90% or more, about 91% or more, about 92% or more, or about 93% or more. In aspects, the average transmittance of the surface-modifying layer (e.g., anti-fingerprint coating **113**) and/or the coated article **101, 201, 211, or 221** can range from about 80% to 100%, from about 85% to about 99%, from about 88% to about 97%, from about 89% to about 97%, from about 90% to about 96%, from about 91% to about 95%, from about 92% to about 94%, or any range or subrange therebetween. In aspects, the transmittance of the surface-modifying layer (e.g., anti-fingerprint coating **113**) and/or the coated article **101, 201, 211, or 221** at 550 nm can be within one or more of the ranges mentioned above in this paragraph for the average transmittance.

As used herein, haze refers to transmission haze that is measured through the surface-modifying layer (e.g., anti-fingerprint coating **113**) and/or through the coated article **101, 201, 211, or 221** (through the exterior surface **115**) in accordance with ASTM D1003-21 at 0° relative to a direction normal to the exterior surface **115**. Haze is measured using a HAZE-GARD PLUS available from BYK Gardner with an aperture over the source port. The aperture has a diameter of 8 mm. A CIE C illuminant is used as the light source for illuminating the surface-modifying layer (e.g., anti-fingerprint coating **113**) and/or through the coated article **101, 201, 211, or 221**. In aspects, the surface-modifying layer (e.g., anti-fingerprint coating **113**) and/or through the coated article **101, 201, 211, or 221** comprises a haze of about 5% or less, about 2% or less, about 1.5% or less, about 1% or less, about 0.5% or less, or about 0.1% or less, for example from about 0.01% to about 5%, from about 0.01% to about 2%, from about 0.05% to about 1.5%, from about 0.05% to about 1%, from about 0.1% to about 0.5%, or any range or subrange therebetween.

Throughout the disclosure, a coefficient of friction refers to a dynamic coefficient of friction measured in accordance with ASTM D1894-14. Unless otherwise indicated, "coefficient of friction" refers to the "dynamic coefficient of friction." In aspects, the exterior surface **115** of the surface-modifying layer (e.g., anti-fingerprint coating **113**) can comprise a dynamic coefficient of friction of about 0.25 or less, about 0.22 or less, about 0.20 or less, about 0.18 or less, or about 0.15 or less. In aspects, the exterior surface **115** of the surface-modifying layer (e.g., anti-fingerprint coating **113**) can comprise a dynamic coefficient of friction in a range from 0.05 to about 0.25, from about 0.10 to about 0.22, from about 0.12 to about 0.20, from about 0.15 to about 0.18, or any range or subrange therebetween.

Throughout the disclosure, contact angles are determined for a drop of a corresponding liquid disposed on the exterior surface (not treated with plasma nor corona) using a 30 gauge needle with the contact angle measured using a goniometer in accordance with ASTM D5946. If a contact angle cannot be reliably determined due to a high degree of droplet spread corresponding to a contact fangle of 15° or less, then the coating is said to "wet" the droplet material. As used herein, water contact angles are measured using a drop of deionized water. As used herein, a coating is "hydrophobic" if it has a water contact angle of 100° or more. As used herein, a coating is "superhydrophobic" if it has a water contact angle of 130° or more. As used herein, an "as-formed" coating refers to a coating that has not been subjected to an abrasive (e.g., see Steel Wool Abrasion Test and Cheesecloth Abrasion Test below). As used herein, a coating is "oleophilic" if it has a hexadecane contact angle of less than 60°.

In aspects, the surface-modifying layer can be an anti-fingerprint coating. In aspects, the anti-fingerprint coating **113** (e.g., as-formed) is hydrophobic but not superhydrophobic. In aspects, the water contact angle of the anti-fingerprint coating **113** (e.g., as-formed) can be about 90° or more, about 100° or more, about 102° or more, about 105° or more, about 110° or more, about 115° or more, about 120° or less, about 115° or less, or about 110° or less. In aspects, the water contact angle of the anti-fingerprint coating **113** (e.g., as-formed) can range from about 90° to about 120°, from about 100° to about 115°, from about 102° to about 110°, from about 105° to about 110°, or any range or subrange therebetween. In aspects, a diiodomethane contact angle of the anti-fingerprint coating **113** (e.g., as-formed) can be about 60° or more, about 62° or more, about 65° or more, about 80° or less, about 75° or less, about 73° or less, or about 70° or less. In aspects, a diiodomethane contact angle of the anti-fingerprint coating **113** (e.g., as-formed) can range from about 60° to about 80°, from about 62° to about 75°, from about 65° to about 72°, or any range or subrange therebetween. In aspects, the anti-fingerprint coating **113** can be oleophilic. In aspects, a hexadecane contact angle of the anti-fingerprint coating **113** (e.g., as-formed) can be about 45° or less, about 40° or less, about 30° or less, about 25° or less, about 20° or less, or the anti-fingerprint coating **113** can wet hexadecane. In further aspects, the anti-fingerprint coating **113** (e.g., as formed) wets hexadecane. Providing a low diiodomethane contact angle (e.g., about 60° or less) and/or a low hexadecane contact angle (e.g., about 30° or less) can reduce the visibility and/or color shift associated with fingerprints by enabling fingerprint oil to be dispersed across the anti-fingerprint coating rather than beading up into pronounced droplets. Providing a high water contact angle (e.g., about 100° or more) can enhance the removal of aqueous material (e.g., water droplets, sweat droplets) from the anti-fingerprint coating.

Throughout the disclosure, surface energy (e.g., total surface energy) and components thereof (e.g., polar, dispersive) are calculated using the Wu model based on contact angle measurements, as described above. In aspects, the surface-modifying layer (e.g., anti-fingerprint coating **113**) can comprise a total surface energy of about 35 milliNewtons per meter (mN/m) or less, about 32 mN/m or less, about 30 mN/m or less, about 29 mN/m or less, about 28 mN/m or less, or about 27 mN/m or less. In aspects, the surface-modifying layer (e.g., anti-fingerprint coating **113**) can comprise a total surface energy ranging from about 20 mN/m to about 35 mN/m, from about 22 mN/m to about 32 mN/m, from about 25 mN/m to about 30 mN/m, from about 25 mN/m to about 29 mN/m, from about 26 mN/m to about 28 mN/m or any range or subrange therebetween. In aspects, the anti-fingerprint coating **113** can comprise a dispersive surface energy of about 30 mN/m or less, about 28 mN/m or less, about 26 mN/m or less, about 25 mN/m or less, about 24 mN/m or less, or about 23 mN/m or less. In aspects, the surface-modifying layer (e.g., anti-fingerprint coating **113**) can comprise a dispersive surface energy ranging from about 15 mN/m to about 30 mN/m, from about 18 mN/m to about 28 mN/m, from about 20 mN/m to about 26 mN/m, from about 22 mN/m to about 25 mN/m, or any range or subrange therebetween. In aspects, the anti-fingerprint coating **113** can comprise a polar surface energy of about 6 mN/m or less, about 4 mN/m or less, about 3 mN/m or less, or about 2 mN/m or less. In aspects, the anti-fingerprint coating **113** can comprise a dispersive surface energy ranging from about 0.5 mN/m to about 6 mN/m, from about 1 mN/m to about 4 mN/m, from about 1 mN/m to about 3 mN/m, from about 1.5 mN/m to about 2 mN/m, or any range or subrange therebetween. Providing a low total surface energy (including a low dispersive surface energy and/or a low polar surface energy) can enable oils (e.g., fingerprint oil) to be dispersed across the anti-fingerprint surface (e.g., oleophilic), which can decrease a visibility and/or a color shift associated with fingerprints.

Throughout the disclosure, the "Steel Wool Abrasion Test" is used to determine the durability of a coating. For the Steel Wool Abrasion Test, steel wool (Bonstar #0000) was cut into strips (25 mm x12 mm) and placed on a sheet of aluminum foil to bake in an oven for 2 hours at 100°C. A steel wool strip was fitted to an attachment (10 mm x10 mm) of an abrader (5750, Taber Industries) using a zip tie. Weights totaling 720 grams were added to the Taber arm to result in a total applied load of 1 kilogram. The stroke length was set at 25 mm, the speed was set to 40 cycles per minute, and testing occurred at 23°C. The area to be abraded was marked onto the back of the sample for tracking. A sample of the coating was secured in the abraded and subjected to 2,000 cycles, 3,000 cycles, or 3,500 cycles. After the coating is abraded for the predetermined number of cycles, an abraded water contact angle is measured in accordance with the method for the contact angle described above. Unless otherwise indicated, the abraded water contact angle is calculated as the average of 12 water contact angle measurements taken at evenly spaced locations along the abraded area. A high contact angle (e.g., about 85° or more, about 90° or more) is indicative of the a surface-modifying layer (e.g., anti-fingerprint coating) surviving the Steel Wool Abrasion Test. Decreases in the contact angle below 70 degrees correlate with a loss of the surface-modifying layer (e.g., anti-fingerprint coating). In aspects, the abraded water contact angle after 2,000 cycles, 3,000 cycles, and/or 3,5000 cycles in the Steel Wool Abrasion Test can be about 85° or more, about 88° or more, or about 90° or more.

Throughout the disclosure, the "Cheesecloth Abrasion Test" is also used to determine the durability of a coating. In the Cheesecloth Abrasion Test, 4 layers of cheesecloth wrap (Crockmeter Squares for American Standards, 200877; SDL Atlas USA, Rock Hill, SC) are affixed to a cylindrical tip with a radius of 2 cm of a Linear Taber Abrader (Model 5750; Taber Industries, North Tonawanda, NY) with a constant load of 750 grams. The path-length of each swipe is 15 mm, with each cycle comprising a forward and backward swipe to return the tip to its original position before proceeding with the next cycle. The speed was 30 cycles per minute, testing occurred at 23°C. After the coating is abraded for 200,000 cycles, a cheesecloth-abraded water contact angle is measured in accordance with the method for the contact angle described above In aspects, a cheesecloth-abraded water contact angle of the surface-modifying layer (e.g., anti-fingerprint coating **113**) can be about 100° or more, about 105° or more, or about 110° or more. In aspects a difference between the water contact angle of the surface-modifying layer (e.g., anti-fingerprint coating) (as-formed) and the cheesecloth-abraded water contact angle (after 200,000 cycles) can be about 15° or less, about 12° or less, about 10° or less, or about 8° or less.

As demonstrated by the results of the Steel Wool Abrasion Test and the Cheesecloth Abrasion Test, the surface-modifying layers (e.g., anti-fingerprint coatings) of the present disclosure can withstand abrasion and maintain good contact angles.

Throughout the disclosure, the "Rubber Abrasion Test" is also used to determine the durability of a coating. In the Rubber Abrasion Test, a 6 mm diameter by 20 mm rod of rubber is affixed to a cylindrical tip of a Linear Taber Abrader (Model 5750; Taber Industries, North Tonawanda, NY) with a length of 5 mm of the rubber is exposed to contact the coating and under with a constant load of 1 kg. The path-length of each swipe is 15 mm, with each cycle comprising a forward and backward swipe to return the tip to its original position before proceeding with the next cycle. The speed was 40 cycles per minute, testing occurred at 23°C. After the coating is abraded for 5,000 cycles, a rubber-abraded water contact angle is measured in accordance with the method for the contact angle described above. In aspects, a rubber-abraded water contact angle of the surface-modifying layer (e.g., anti-fingerprint coating **113**) can be about 80° or more, about 85° or more, about 90° or more, about 95° or more, about 100° or more, about 105° or more, or about 110° or more. In aspects a difference between the water contact angle of the surface-modifying layer (e.g., anti-fingerprint coating) (as-formed) and the rubber-abraded water contact angle (after 3,000 cycles) can be about 15° or less, about 12° or less, about 10° or less, or about 8° or less.

As used herein, "surface roughness" means the Ra surface roughness, which is an arithmetical mean of the absolute deviations of a surface profile from an average position in a direction normal to the surface of the test area. Ra surface roughness values for an 2 $\mu$m by 2 $\mu$m test area using atomic force microscopy (AFM). In aspects, the surface-modifying layer (e.g., anti-fingerprint coating **113**) can comprise a surface roughness Ra (e.g., as-formed) of about 1 nm or less, 0.8 nm or less, 0.7 nm or less, about 0.6 nm or less, about 0.5 nm or less, about 0.1 nm or more, about 0.2 nm or more, about 0.3 nm or more, or about 0.4 nm or more. In aspects, the surface-modifying layer (e.g., anti-fingerprint coating **113**) can comprise a surface roughness Ra (e.g., as-formed) ranging from about 0.1 nm to about 1 nm, from about 0.2 nm to about 0.8 nm, from about 0.3 nm to about 0.7 nm, from about 0.4 nm to about 0.5 nm, or any range or subrange therebetween.

Throughout the disclosure, a refractive index of coatings and films is measured by spectroscopic ellipsometry using a Woollam M-2000 and modelled using Wollam CompleteEase software. Unless otherwise specified, refractive index is measured at 550 nm. In aspects, a refractive index of the surface-modifying layer (e.g., anti-fingerprint coating **113**) can be about 1.38 or more, about 1.4 or more, about 1.42 or more, about 1.44 or more, about 1.48 or more, about 1.5 or more, about 1.55 or less, about 1.53 or less, about 1.49 or less, about 1.44 or less, about 1.42 or less, or about 1.4 or less. In aspects, a refractive index of the surface-modifying layer (e.g., anti-fingerprint coating **113**) can range from about 1.38 to about 1.55, from about 1.42 to about 1.55, from about 1.44 to about 1.55, from about 1.44 to about 1.53, from about 1.48 to about 1.51, or any range or subrange therebetween. In aspects, a refractive index of the substrate **103** can be greater than or less than the refractive index of the surface-modifying layer (e.g., anti-fingerprint coating **113**). As discussed below, different compositions of the surface-modifying layer (e.g., anti-fingerprint coating **113**) can have different refractive index values or ranges.

In aspects, a visibility of a fingerprint on the surface-modifying layer (e.g., anti-fingerprint coating **113**), as defined above as an absolute value of a difference between CIELAB L* values for a portion of the surface-modifying layer (e.g., anti-fingerprint coating **113**) with and without fingerprint oil, can be about 15 or less, about 10 or less, about 8 or less, about 5 or less, about 2 or less. In aspects, a visibility of a fingerprint on the surface-modifying layer (e.g., anti-fingerprint coating **113**) can range from 0 to 15, from about 0.5 to about 10, from about 1 to about 8, from about 2 to about 5, or any range or subrange therebetween. In aspects, a color shift of a fingerprint on the surface-modifying layer (e.g., anti-fingerprint coating **113**), as defined above as $\sqrt{((a_1^* - a_2^*)^2 + (b_1^* - b_2^*)^2)}$, can be about 15 or less, about 10 or less, about 8 or less, about 5 or less, about 2 or less. In aspects, a color shift of a fingerprint on the surface-modifying layer (e.g., anti-fingerprint coating **113**) can range from 0 to 15, from about 0.5 to about 10, from about 1 to about 8, from about 2 to about 5, or any range or subrange therebetween.

As used herein, an elemental composition of the surface-modifying layer (e.g., anti-fingerprint coating) is determined using X-ray photoelectron spectroscopy (XPS). In aspects, the anti-fingerprint coating can be fluorine-free. In aspects, the surface-modifying layer (e.g., anti-fingerprint coating **113**) can comprise silicon atoms, oxygen atoms, carbon atoms, and hydrogen atoms. In further aspects, the surface-modifying layer (e.g., anti-fingerprint coating **113**) can further comprise nitrogen atoms. In further aspects, oxygen atoms in the surface-modifying layer (e.g., anti-fingerprint coating) can be more common than any other atom in the surface-modifying layer (e.g., anti-fingerprint coating) detected by XPS. In further aspects, the surface-modifying layer (e.g., anti-fingerprint coating) can comprise about 30 atom% carbon or less, about 25 atom% carbon or less, about 10 atom% carbon or less, about 2 atom% carbon or more, or about 5 atom% carbon or more. Providing a fluorine-free surface-modifying layer (e.g., fluorine-free anti-fingerprint coating **113**) can be cheaper to produce and/or more environmentally friendly.

In aspects, the surface-modifying layer (e.g., anti-fingerprint coating) can comprise a partial silica-like network. A silica-like network refers to a coordination of silicon atoms bonded together by oxygen atoms with four Si-O bonds for a silicon atom, corresponding to a $SiO_2$ network. As used herein, a fraction of silicon atoms in a silica-like-network is determined by Fourier-transform infrared (FTIR) spectroscopy based on an intensity of an absorbance associated with a Si-O-Si bend (e.g., from about 1000 cm$^{-1}$ to 1060 cm$^{-1}$) relative all Si-O-Si bends (including the T-type stretch of POSS at about 1105 cm$^{-1}$). In aspects, a percentage of silicon atoms in the surface-modifying layer (e.g., anti-fingerprint coating **113**) in a silica-like network can be about 50% or more, about 60% or more, about 65% or more, about 70% or more, about 90% or less, about 80% or less, about 75% or less, or about 70% or less. In aspects, a percentage of silicon atoms in the surface-modifying layer (e.g., anti-fingerprint coating **113**) in a silica-like network can range from about 50% to about 90%, from about 60% to about 80%, from about 65% to about 75%, or any range or subrange therebetween. Providing a partial silica-like network can enable the surface-modifying layer (e.g., anti-fingerprint coating) to be stiff (e.g., elastic modulus of about 9 GPa or more) while remaining flexible enough to withstand abrasion.

A ratio of Si-O-Si bonds to silicon atoms of coating can be measured using (a) XPS to determine an amount of Si-O bonds based on Si 2p fine structure relative to an overall amount of Si or (b) $^{29}$Si solid-state nuclear magnetic resonance (NMR) based on fitting the observed chemical shifts to 6 Gaussian curves corresponding to different coordination structures (e.g., a T-unit, a D-unit, a M-unit, and three Q-units with different numbers of hydroxyls), where the functional group bonded to the silicon atom can be substituted with an organic group (e.g., carbon). In aspects, a ratio of Si-O-Si bonds to silicon atoms can be about 2 or more, about 2.2 or more, about 2.4 or more, about 2.6 or more, about 3 or less, about 2.9 or less, about 2.8 or less, or about 2.75 or less. In aspects, a ratio of Si-O-Si bonds to silicon atoms can range from about 2 to about 3, from about 2.2 to about 2.9, from about 2.4 to about 2.8, from about 2.6 to about 2.75, or any range or subrange therebetween.

In aspects, the surface-modifying layer (e.g., anti-fingerprint coating **113**) can comprise at least one alkyl silane at the exterior surface **115** and bonded to Si-O groups in the surface-modifying layer (e.g., anti-fingerprint coating **113**). In further aspects, the surface-modifying layer (e.g., anti-fingerprint coating **113**) can be a single alkyl silane thick, although in other aspects, multiple alkyl silanes can react to form the with the composite alkyl silane of the surface-modifying layer (e.g., anti-fingerprint coating **113**). As used herein, an "alkyl silane" refers to a compound comprising an alkyl chain directly bonded to a silicon atom of a silane group or a surface silanol (e.g., of the substrate or underlaying optical stack), and the silane group can be bonded to other silane groups (e.g., forming a siloxane or siloxane-like network). In further aspects, the alkyl silane can comprise from 4 carbons to about 34 carbons (i.e., a $C_4$-$C_{34}$ alkyl group), for example, from 6 carbons to 34 carbons (i.e., a $C_6$-$C_{34}$ alkyl group), from 8 carbons to 20 carbons (i.e. a $C_8$-$C_{20}$ alkyl group). Exemplary aspects of alkyl silane include iso-octylsilanes (e.g., iso-octyltrimethoxysilane), dodecylsilanes (e.g., dodecyltrimethoxysilane), octadecylsilanes (e.g., octadecyltrimethoxysilane), or combinations thereof. In further aspects, the silane can be a methoxy silane (e.g., trimethoxy silane) and/or a trialkoxy silane. In further aspects, the silane can be a trimethoxysilane, a triethoxysilane, a trichlorosilane, or combinations thereof (e.g. dichloromethoxysilane, chlorodimethoxysilane). In aspects, the alkyl silane can comprise an alkyl group comprising from 4 carbons to about 34 carbons (i.e., a $C_4$-$C_{34}$ alkyl group) (e.g., from 6 carbons to 34 carbons (i.e., a $C_6$-$C_{34}$ alkyl group), from 8 carbons to 20 carbons (i.e. a $C_8$-$C_{20}$ alkyl group)), for example, an iso-octyl alkyl group, a dodecyl alkyl group, an octadecyl alkyl group, or combinations thereof. An exemplary aspects of the alkyl group is an octadecyl alkyl group. Providing an alkyl silane can reduce a surface energy (e.g., total, dispersive, polar) of the surface-modifying layer (e.g., anti-fingerprint coating), which can enable the surface-modifying layer (e.g., anti-fingerprint coating) to be oleophilic. Reacting an initial coating with a methoxy silane and/or a trialkoxy silane can be well-bonded to the initial coating and enable low surface energy (e.g., total surface energy or about 30 mN/m or less, polar surface energy of about 5 mN/m or less).

The surface-modifying layer (e.g., anti-fingerprint coating **113**) can comprise one or more of (1) a percentage of silicon atoms in a silica-like network within one or more of the ranges discussed above (e.g., from about 50% to about 90%) or (2) a ratio of Si-O-Si bonds to silicon atoms within one or more of the ranges discussed above (e.g., from about 2 to about 3). In aspects, the surface-modifying layer (e.g., anti-fingerprint coating) can comprise a partial silica-like network and either silicon hydrides or silanols. In aspects, the surface-modifying layer (e.g., anti-fingerprint coating **113**) can comprise a refractive index ranging from about 1.38 to about 1.55, from about 1.42 to about 1.55, from about 1.44 to about 1.55, from about 1.44 to about 1.53, from about 1.48 to about 1.51, or any range or subrange therebetween. Alternatively, the surface-modifying layer (e.g., anti-fingerprint coating **113**) can comprise a refractive index from about 1.38 to about 1.44, from about 1.39 to about 1.43, from about 1.40 to about 1.42, or any range or subrange therebetween. In aspects, the surface-modifying layer (e.g., anti-fingerprint coating **113**) can comprise nitrogen atoms, for example with nitrogen atoms bonded to silicon atoms. For example, the surface-modifying layer (e.g., anti-fingerprint coating **113**) can be the product of at least partially curing a polysilazane on the first major surface **105** of the substrate **103** that can be reacted with a silane after being at least partially cured. Alternatively, the surface-modifying layer (e.g., anti-fingerprint coating **113**) can be free from nitrogen. In aspects, the surface-modifying layer (e.g., anti-fingerprint coating **113**) can be the product of impinging an ion beam on the first major surface **105** of the substrate during and/or after a functionalized polyhedral oligomeric silsesquioxane (POSS) (defined below) is disposed on the first major surface and reacted with a silane after the ion beam treatment. In aspects, the surface-modifying layer (e.g., anti-fingerprint coating **113**) can be the result of thermally curing a POSS (e.g., hydrogen POSS) compound on the first major surface **105** of the substrate **103** that can be reacted with a silane after being thermally cured. In aspects, the surface-modifying layer (e.g., anti-fingerprint coating **113**) can comprise at least one alkyl silane at the exterior surface **115** and bonded to Si-O groups in the surface-modifying layer (e.g.,

anti-fingerprint coating **113),** which can include one or more of the silanes discussed above. In aspects, the surface-modifying layer (e.g., anti-fingerprint coating **113)** can be free from fluorine and/or nitrogen. In aspects, the surface-modifying layer (e.g., anti-fingerprint coating **113)** can consist of carbon, oxygen, silicon, hydrogen, and oxygen.

In aspects, the silica-like network of the present disclosure can be readily distinguished from other silicon-containing oxides (e.g., a silica capping layer) by the properties discussed herein (e.g., hydroxyl content, hardness, refractive index, power spectral density of the surface, surface roughness Ra). For example, the silica-like network can comprise a greater hydroxyl content than a hydroxyl content of the capping layer; and/or the silica-like network can exhibit a lower hardness, lower elastic modulus, and/or higher refractive index than the corresponding property of the capping layer.

One way to quantify an amount (e.g., density) of hydroxyl in the surface-modifying layer (e.g., below the alkyl silane) is based on molar ratios determined by secondary-ion mass spectroscopy (SIMS). Unless otherwise indicated, samples were cleaned with a low-energy Ar gas cluster ion beam (GCIB) source before analysis with SIMS. A molar ratio at the surface can be measured using static SIMS. Unless otherwise indicated, the molar ratio is for a bulk of the surface-modifying layer using dynamic SIMS (D-SIMS). Unlike static SIMS, dynamic SIMS erodes the surface to provide depth-resolved compositional information. As used herein, D-SIMS was conducted using a time-of-flight secondary ion mass spectrometer (ToF-SIMS) with a dual beam configuration. Unless otherwise indicated, the TOF-SIMS used for the results reported herein was a TOF-SIMS M6 instrument (available from IONTOF GmbH) equipped with a Nanoprobe50 bismuth source. The TOF-SIMS M6 instrument was operated with a dual-beam configuration, where the analysis beam was a 30 kilo-electronVolts (keV) $Bi_3^+$ beam with a current of about 0.1 pA and the sputter beam was 2 keV $Cs^+$ with a current of about 120 nA. The sputter beam was configured form a 300 $\mu$m by 300 $\mu$m sputter "crater," and the analysis beam was configured to impinge a 75 $\mu$m by 75 $\mu$m area centered in the sputter "crater." Charge compensation was achieved using an electron flood gun operating with 20 nA beam current, 20 eV electron energy, and a 1.5 mm spot size focused on the location impinged by the analysis beam. The chamber was evacuated to a pressure of $5 \times 10^{-7}$ Pascals ($5 \times 10^{-9}$ millibar) before being brought to and maintained at a pressure of $5 \times 10^{-5}$ Pascals ($5 \times 10^{-7}$ millibar) using argon (e.g., 99.99999% purity). Data was collected in negative ion mode with the analyzer in the "all purpose" mode, an analyzer energy of 3000 V and a cycle time of 100 microseconds. Data was processed using Surface Lab software (version 7.3.125519 available from IONTOF GmbH). To obtain molar ratios from $^{16}O^1H^-$, $^{18}O^-$, and $^{28}Si$-signals, the known isotope ratio between $^{18}O^-$ and $^{17}O^-$ was used to calculate and subtract the $^{17}O^-$ interference from the $^{16}O^1H^-$ signal. A normalized intensity was defined as the mass-interference-corrected $^{16}O^1H$ signal divided by the $^{28}Si^-$ signal. The normalized intensity ($^{16}O^1H^-/^{28}Si^-$) was further corrected to remove background signals (as determined from the normalized intensity ($^{16}O^1H^-/^{28}Si^-$) contemporaneously measured from GE Type 124 fused quartz) to determine a "corrected signal." The corrected signal was converted to a hydrogen to silicon molar ratio ("molar ratio") using a calibration curve (derived from a series of natural mid-ocean-ridge basaltic (MORB) glasses with known -OH concentrations and other silica and silicate minerals covering a range from 0.0 wt% to 1.98 wt%) with an equation of "molar ratio" = 1.26 * "corrected signal" - 0.025.

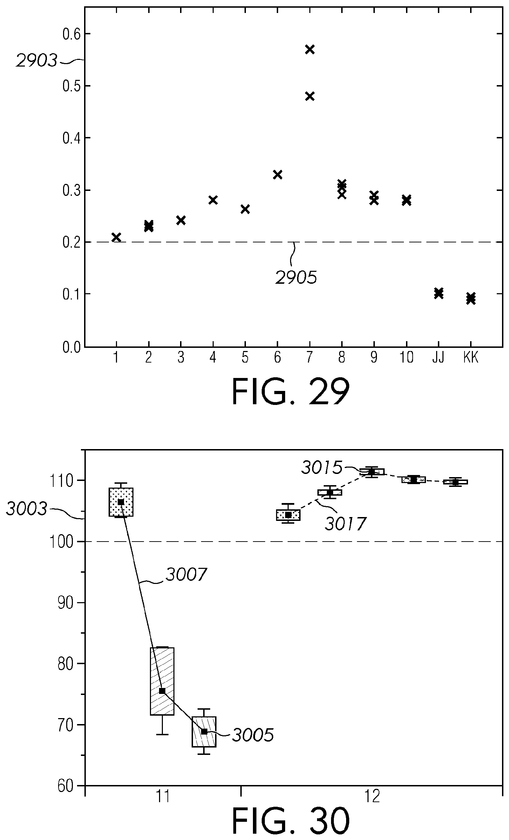

Throughout the disclosure, the "molar ratio" refers to a molar ratio of hydrogen to silicon (i.e., a molar amount of hydrogen divided by a molar amount of silicon) as determined by SIMS analysis of a material (e.g., surface-modifying layer below the alkyl silane). Without wishing to be bound by theory, it is believed that hydrogen is indicative of hydroxyl groups (e.g., silanol, Si-O-H). In aspects, a molar ratio (of hydrogen to silicon) of the surface-modifying layer below the alkyl silane can be about 0.2 or more (e.g., about 0.2 or more), about 0.21 or more, about 0.22 or more, about 0.23 or more, about 0.24 or more, about 0.25 or more, about 0.45 or less, about 0.4 or less, about 0.37 or less, about 0.35 or less, about 0.32 or less, about 0.30 or less, or about 0.28 or less. In aspects, a molar ratio (of hydrogen to silicon) can be in a range from about 0.2 to about 0.45, from about 0.20 to about 0.4 (e.g., from about 0.2 to about 0.4), from about 0.21 to about 0.37, from about 0.22 to about 0.35, from about 0.23 to about 0.32, from about 0.24 to about 0.32, from about 0.24 to about 0.30, from about 0.25 to about 0.28, or any range or subrange therebetween. In exemplary aspects, the molar ratio of hydrogen to silicon can be in a range from 0.20 to 0.4 or from about 0.22 to about 0.35. For example, as discussed below with reference to **FIG. 29,** the surface-modifying layers in accordance with aspects of the present disclosure (e.g., Examples 1-10) exhibits a molar ratio of hydrogen to silicon of 0.20 or more, from about 0.20 to 0.4, or from about 0.22 to about 0.35. In contrast, conventional methods of silica deposition (Comparative Examples JJ-KK) have a molar ratio of about 0.10 or less, meaning that Examples 1-10 have at least about double (2x) the molar ratio of Comparative Examples JJ-KK. In aspects, the molar ratio at the surface can be within any of the ranges recited above in this paragraph. In aspects, the molar ratio (of hydrogen to silicon) of the surface-modifying layer can be greater than the molar ratio of a reactively sputtered silica layer by a multiple of 2 or more, 2.5 or more, 3 or more, 4 or more, 10 or less, 7 or less, 5 or less, or 4 or less. In aspects, the molar ratio (of hydrogen to silicon) of the surface-modifying layer can be greater than the molar ratio of a reactively sputtered silica layer by a multiple in a range from about 2 to 10, from 2 to 7, from 2.5 to 5, from 2.5 to 4, from 3 to 4, or any range or subrange therebetween.

Another way to quantify an amount (e.g., density) of hydroxyl in the silica-like network layer (e.g., surface-modifying layer below the alkyl silane) is based on absorbance measured in infrared (IR) spectroscopy. Without wishing to be bound by theory, a broad absorbance associated with alcohols (e.g., hydroxyl (OH) stretch, for example, in silanols - Si-O-H) can be seen from about 3200 cm$^{-1}$ to about 3500 cm$^{-1}$ (e.g., with a peak centered around 3420 cm$^{-1}$); and a broad

absorbance is seen at 1059 cm$^{-1}$, which is attributed to an Si-O-Si structure. As used herein, a "hydroxyl ratio" is a peak absorbance of the broad hydroxyl signal (centered around 3420 cm$^{-1}$) divided by a peak absorbance of the Si-O-Si signal (centered at about 1060 cm$^{-1}$). In aspects, the hydroxyl ratio (e.g., of the surface-modifying layer below the alkyl silane) can be about 0.005 or more, about 0.008 or more, about 0.010 or more (e.g., about 0.01 or more), about 0.07 or less, about 0.06 or less, about 0.05 or less, or about 0.045 or less. In aspects, the hydroxyl ratio (e.g., of the surface-modifying layer below the alkyl silane) can be in a range from about 0.005 to about 0.07, from about 0.005 to about 0.06, from about 0.008 to about 0.5, from about 0.01 to about 0.045, or any range or subrange therebetween. Without wishing to be bound by theory, a hydroxyl ratio for a reactively sputtered silica layer is much lower than the hydroxyl ratios discussed herein (e.g., of the surface-modifying layer below the alkyl silane). In aspects, the hydroxyl ratio of the surface-modifying layer (e.g., surface-modifying layer below the alkyl silane) can be greater than the hydroxyl ratio of a reactively sputtered silica layer by a multiple of 2 or more, 3 or more, 4 or more, 5 or more, 8 or more, 20 or less, 15 or less, 12 or less, 10 or less, 8 or less, 6 or less, 5 or less, or 4 or less. In aspects, the hydroxyl ratio of the surface-modifying layer (e.g., surface-modifying layer below the alkyl silane) can be greater than the hydroxyl ratio of a reactively sputtered silica layer by a multiple in a range from 2 to 20, from 3 to 20, from 4 to 15, from 5 to 15, from 8 to 12, from 8 to 10, or any range or subrange therebetween. In aspects, In aspects, the hydroxyl ratio of the surface-modifying layer (e.g., surface-modifying layer below the alkyl silane) can be greater than the hydroxyl ratio of a reactively sputtered silica layer by a multiple of about 10 or less, for example, in a range from 2 to 10, from 3 to 8, from 3 to 6, from 3 to 5, from 3 to 4, or any range or subrange therebetween.

Alternatively, another embodiment of the present disclosure includes the surface-modifying layer (e.g., anti-fingerprint coating **113**) in any of the configurations discussed above in **FIGS. 1 and 2A-2C,** but the surface-modifying layer (e.g., anti-fingerprint coating **113**) may comprise a smaller anti-fingerprint thickness **119** and/or not contain a noticeable silica or partial silica-like network. For example, the surface modifying layer (e.g., anti-fingerprint coating **113**) can be the product of depositing an alkyl silane (e.g., within one or more of the ranges discussed below) without using a POSS or polysilazane compound. In aspects, the surface-modifying layer (e.g., anti-fingerprint coating **113**) can comprise an alkyl silane at the exterior surface **115,** which can contain any of the corresponding alkyl groups discussed above (e.g., an alkyl group comprising from 4 carbons to about 34 carbons (i.e., a $C_4$-$C_{34}$ alkyl group), for example, from 6 carbons to 34 carbons (i.e., a $C_6$-$C_{34}$ alkyl group), from 8 carbons to 20 carbons (i.e. a $C_8$-$C_{20}$ alkyl group). In further aspects, the alkyl group can be an iso-octyl alkyl group, a dodecyl alkyl group, an octadecyl alkyl group, or combinations thereof. An exemplary aspect of the alkyl group is an octadecyl alkyl group. In aspects, the anti-fingerprint thickness **119** can be about 1 nm or more, about 2 nm or more, about 3 nm or more, about 5 nm or more, about 8 nm or more, about 10 nm or more, about 75 nm or less, about 50 nm or less, about 25 nm or less, about 15 nm or less, about 10 nm or less, about 8 nm or less, or about 5 nm or less. In aspects, the anti-fingerprint thickness **119** can be in a range from about 1 nm to about 75 nm, from about 1 nm to about 50 nm, from about 1 nm to about 25 nm, from about 1 nm to about 15 nm, from about 2 nm to about 10 nm, from about 2 nm to about 8 nm, from about 2 nm to about 5 nm, from about 3 nm to about 5 nm, or any range or subrange therebetween. In aspects, the surface-modifying layer (e.g., anti-fingerprint coating **113**) can exhibit a water contact angle (e.g., about 100° or more or from 102° to 110°), a diiodomethane contact angle (e.g., about 60° or more), a coefficient of friction (e.g., about 0.25 or less), a polar surface energy (e.g., about 3 mN/m or less), a total surface energy (e.g., about 30 mN/m or less), a cheesecloth-abraded water contact angle (e.g., about 90° or more after being subjected to 200,000 cycles in the Cheesecloth Abrasion Test), and/or a rubber-abraded water contact angle (e.g., about 80° or more, about 90° or more, or from about 100° to about 110° after being subjected to 5,000 cycles in the Rubber Abrasion Test) within one or more of the corresponding ranges discussed above.

Aspects of the disclosure can comprise a consumer electronic product. The consumer electronic product can comprise a front surface, a back surface, and side surfaces. The consumer electronic product can further comprise electrical components at least partially within the housing. The electrical components can comprise a controller, a memory, and a display. The display can be at or adjacent to the front surface of the housing. The display can comprise liquid crystal display (LCD), an electrophoretic displays (EPD), an organic light-emitting diode (OLED) display, or a plasma display panel (PDP). The consumer electronic product can comprise a cover substrate disposed over the display. In aspects, at least one of a portion of the housing or the cover substrate comprises the coated article and/or the surface-modifying layer (e.g., anti-fingerprint coating) discussed throughout the disclosure. The consumer electronic product can comprise a portable electronic device, for example, a smartphone, a tablet, a wearable device, or a laptop.

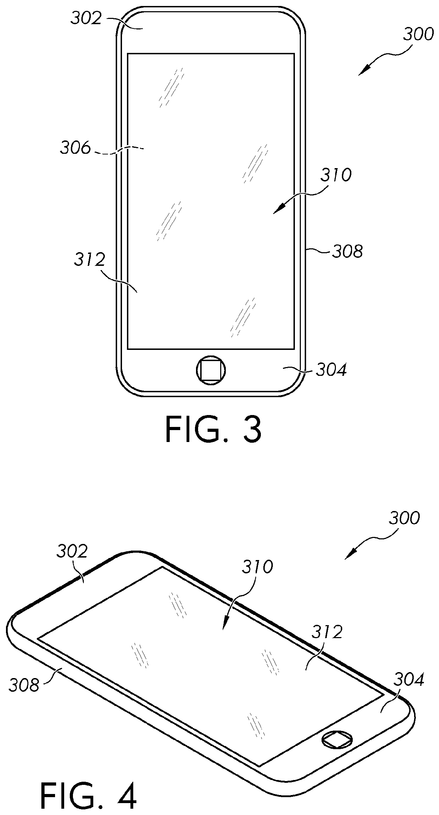

The coated article and/or surface-modifying layer (e.g., anti-fingerprint coating) disclosed herein may be incorporated into another article, for example, an article with a display (or display articles) (e.g., consumer electronics, including mobile phones, tablets, computers, navigation systems, wearable devices (e.g., watches), and the like), architectural articles, transportation articles (e.g., automotive, trains, aircraft, sea craft, etc.), appliance articles, or any article that may benefit from some transparency, scratch-resistance, abrasion resistance or a combination thereof. An exemplary article incorporating any of the coated articles and/or surface-modifying layers (e.g., anti-fingerprint coatings) disclosed herein is shown in **FIGS. 3-4.** Specifically, **FIGS. 3-4** show a consumer electronic device **300** including a housing **302** having front **304,** back **306,** and side surfaces **308.** Although not shown, the consumer electronic device can comprise electrical components that are at least partially inside or entirely within the housing. For example, electrical components include at least a controller, a memory, and a display. As shown in **FIGS. 3-4,** the display **310** can be at or adjacent to the front surface of the housing **302**. The consumer electronic device can comprise a cover substrate **312** at or over the front surface of the housing **302** such that it is over the display **310**. In aspects, at least one of the cover substrate **312** or a portion of housing **302** may include any of the coated articles and/or surface-modifying layers (e.g., anti-fingerprint coatings) disclosed herein.

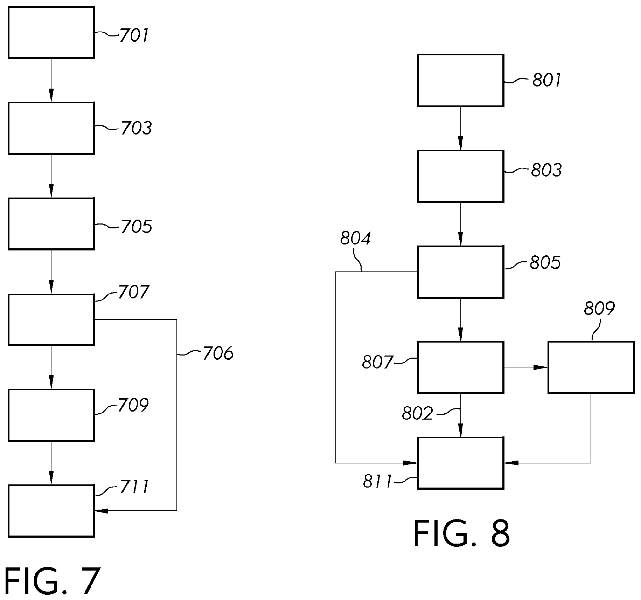

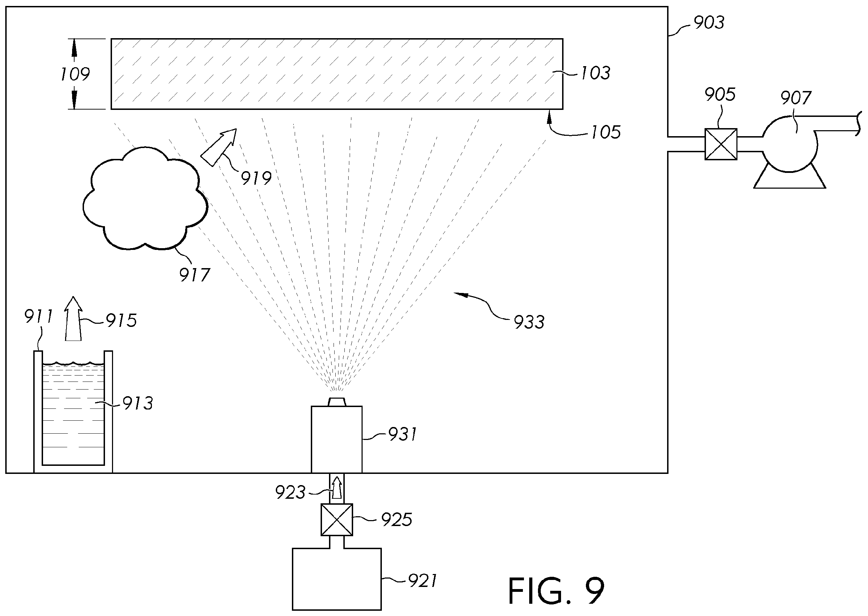

Aspects of methods of making the foldable apparatus and/or foldable substrate in accordance with aspects of the disclosure will be discussed with reference to the flow chart in **FIGS. 7-8** and example method steps illustrated in **FIGS. 9-12.**

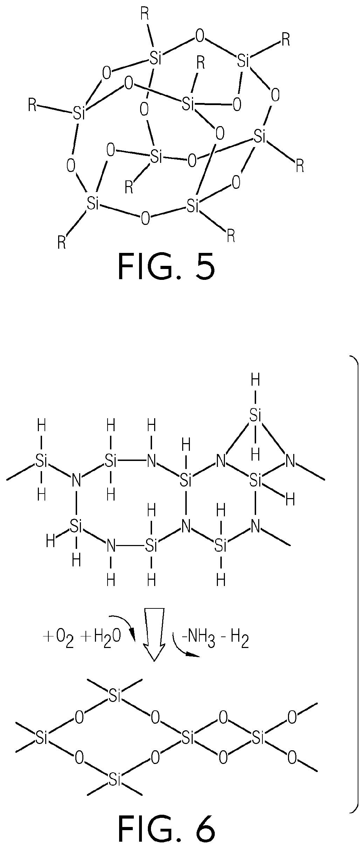

Example aspects of making a coated article **101, 201, 211, or 221** will now be discussed with reference to **FIGS. 5 and 9-10** and the flow chart in **FIG. 7.** In a first step **701,** methods can start with obtaining a substrate **103.** In aspects, the substrate **103** may be provided by purchase or otherwise obtaining a substrate or by forming the substrate. In aspects, the substrate **103** can comprise a glass-based material, a glass-ceramic material, and/or a ceramic-based material. In further aspects, glass-based materials, glass-ceramic materials, and/or ceramic-based materials can be provided by forming them with a variety of ribbon forming processes, for example, slot draw, down-draw, fusion down-draw, up-draw, press roll, redraw, or float. In further aspects, ceramic-based substrates can be provided by heating a glass-based substrate to crystallize one or more ceramic crystals. The substrate **103** comprises a first major surface **105** that can extend along a first plane **104.** In aspects, as indicated in **FIG. 1,** an optical stack **203** comprising an anti-reflective coating and/or a gradient coating comprising a refractive index gradient can be disposed on and/or bonded to the first major surface **105.** Although not shown in **FIGS. 9-10,** it is to be understood that the optical stack **203** can be disposed on the first major surface **105.** In aspects, the substrate **103** can be chemically strengthened with one or more compressive stress regions (or central tension regions) comprising any of the aspects related to depth of compression, maximum compressive stress, and/or tensile stress discussed above for the corresponding property.

In aspects, step **701** can further comprise obtaining a functionalized polyhedral oligomeric silsesquioxane (POSS). As used herein, a polyhedral oligomeric silsesquioxane (POSS) refers to a functionalized oligomer silsesquioxane consisting of $RSiO_{1.5}$ monomers. Exemplary aspects of functionalized POSS can comprise 6, 8, 10, or 12 $RSiO_{1.5}$ monomers, although other aspects are possible. For example, functionalized oligomeric silsesquioxane consisting of 8 $RSiO_{1.5}$ monomers is an octahedral functionalized POSS (e.g., polyoctahedral silsesquioxane). **FIG. 5** shows a functionalized POSS, namely, an octahedral functionalized POSS, where R are functional groups that can be independently selected from the functional groups discussed below.

In aspects, functionalized oligomeric silsesquioxanes can be formed from condensation reactions of silane. As used herein, a condensation reaction produces an $R_2O$ byproduct, where R can include any of the R units discussed below and can further comprise hydrogen (e.g., with a hydroxyl or water byproduct). For example, silanes (e.g., $R_3OSi$) can be reacted to form terminal $RSiO_2$ monomers. For example, a terminal $RSiO_2$ monomer can react with another $RSiO_2$ monomer (e.g., terminal, non-terminal) to form an $RSiO_{1.5}$ monomer as an oxygen atom of one monomer forms a bond with a silicon atom of another monomer, producing the condensation byproduct. It is to be understood that the $RSiO_{1.5}$ silsesquioxane monomers are different from siloxane monomers, which can include M-type siloxane monomers (e.g., $R_3SiO_{0.5}$), D-type siloxane monomers (e.g., $R_2SiO_2$), and/or silica-type siloxane monomers ($SiO_2$).

Functionalized oligomeric silsesquioxanes can be functionalized by one or more functional groups. For methods discussed with reference to the flow chart in **FIG. 7** (e.g., thermally evaporating the functionalized oligomeric silsesquioxane), a functional group functionalizing the functionalized oligomeric silsesquioxane can exclude hydrogen. In aspects, the functional group functionalizing the functionalized oligomeric silsesquioxane can exclude bisphenols, fluorine-containing functional groups isocyanates, epoxies, glycidyls, oxirane, sulfur-containing functional groups (e.g., thiols), anhydrides, acrylates, methacrylates, and/or alkynes. In aspects, the functional group functionalizing the functionalized oligomeric silsesquioxane be an alkyl group, an alkene group, an aromatic group (e.g., phenyl), a silane (e.g., alkyl silyl), or combinations thereof. As used herein, an alkyl group contains a saturated hydrocarbon with carbon-carbon single bonds and hydrogen bonded to carbon atoms. In aspects, alkyl functional groups can range from 1 to 10 carbons (i.e., $C_1$-$C_8$ alkyl), from 1 to 8 carbons (i.e., $C_1$-$C_8$ alkyl), for example, from 1 to 4 carbons (i.e., $C_2$-$C_4$ alkyl). Exemplary aspects of alkyl functional groups include methyl and isobutyl. An exemplary aspect of an aromatic functional group is a phenyl group. An exemplary aspect of a silane includes a dimethylsilyl group. As used herein, an alkene group contains an unsaturated hydrocarbon with one or more carbon-carbon double bonds. Alkenes can optionally include one or more carbon-carbon single bonds (e.g., alkyl chains in the alkene group). In even further aspects, the functionalized POSS can be at least partially functionalized by alkenes containing from 2 to 8 carbons (i.e., $C_2$-$C_8$ alkenes). At least partially functionalized by a functional group B means that one or more of the R-groups shown in **FIG. 5** is B. Completely functionalized mean that 95% or more of all R-groups shown in **FIG. 5** are B. An exemplary aspect of an alkene functionalized POSS is a vinyl POSS, for example, partially vinyl functionalized vinyl/isobutyl POSS (OL1123 available from Hybrid Plastics) or octa-vinyl POSS (OL1170 available from Hybrid Plastics). An exemplary aspect of an aromatic functionalized POSS is octaphenyl POSS (MS0840 available from Hybrid Plastics). Exemplary aspects of alkyl functionalized POSS are octamethyl POSS (MS0830 available from Hybrid Plastics) and octa(iso-butyl) POSS (MS0825 available from Hybrid Plastics). Providing a short chain (e.g., about 8 carbons or less) for functionalizing the functionalized POSS can enable the functionalized POSS to be evaporated during step **703.** Providing one or more of the functional groups discussed above functionalizing the functionalizing POSS can reduce the reactivity of the functionalized POSS before it is impinged by the ion beam and/or disposed on the substrate (e.g., by sterically hindering interactions between functionalized POSS), which can enable be used to produce the partially condensed silica-like network described above.

Alternatively, for example, when making reference to the flow chart in **FIG. 8** (e.g., applying the functionalized oligomeric silsesquioxane as a solution), the functional group functionalizing the functionalized oligomeric silsesquioxane can be hydrogen or an alkyl group. In aspects, the functional group functionalizing the functionalized oligomeric silsesquioxane can exclude bisphenols, fluorine-containing functional groups isocyanates, epoxies, glycidyls, oxirane, sulfur-containing functional groups (e.g., thiols), anhydrides, acrylates, methacrylates, and/or alkynes. In aspects, the functional group functionalizing the functionalized oligomeric silsesquioxane can be hydrogen, an alkyl group, an alkene group, an aromatic group, a silane, or combinations thereof. For example, the functional group can be one or more of the functional groups discussed above in the previous paragraph in addition to hydrogen. In further aspects, the functional group functionalizing the functionalized oligomeric silsesquioxane can consist of carbon and/or hydrogen. In even further aspects, the functionalized oligomeric silsesquioxane can be at least partially functionalized by and/or completely functionalized by hydrogen. In further aspects, the functionalized POSS can be at least partially functionalized by alkenes containing from 2 to 8 carbons (i.e., $C_2$-$C_8$ alkenes), for example, an ethene, a propene, a butene, a pentene, a hexene, a heptane, or a octene. In even further aspects, the functionalized POSS can be at least partially functionalized by alkenes containing from 2 to 8 carbons (i.e., $C_2$-$C_8$ alkenes).

Throughout the disclosure, an effective diameter of a molecule (e.g., functionalized POSS) is measured using dynamic light scattering in accordance with ISO 22412:2017. In aspects, an effective diameter of a functionalized POSS can be about 20 nm or less, about 15 nm or less, about 10 nm or less, about 6 nm or less, about 1 nm or more, about 2 nm or more, or about 4 nm or more. In aspects, an effective diameter of a functionalized POSS can be in a range from about 1 nm to about 20 nm, from about 1 nm to about 15 nm, from about 2 nm to about 15 nm, from about 2 nm to about 10 nm, from about 4 nm to about 10 nm, from about 4 nm to about 6 nm, from about 1 nm to about 6 nm, from about 2 nm to about 6 nm, or any range or subrange therebetween. In further aspects, a mean effective diameter of the functionalized POSS can be within one or more of the ranges discussed above in this paragraph. In further aspects, substantially all and/or all of the functionalized POSS can be within one or more of the ranges for the effective diameter of a functionalized oligomeric silsesquioxane discussed above.

After step **701,** as shown in **FIG. 9,** methods can proceed to step **703** comprising evaporating a functionalized POSS onto the first major surface **105** of the substrate **103.** In aspects, as shown, step **703** can comprise placing the substrate **103** in a chamber **903** (e.g., vacuum chamber) that can be maintained at a reduced pressure. In aspects, the reduced pressure can be about 50,000 Pascals (Pa) or less, about 1,000 Pa or less, about 1 Pa or less, about 0.5 Pa or less, about $10^{-6}$ Pa or more, about $10^{-4}$ Pa or more, or about $10^{-3}$ Pa. In aspects, the reduced pressure can range from about $10^{-6}$ Pa to about 1,000 Pa, from about $10^{-4}$ to about 1 Pa, from about $10^{-3}$ to about 0.5 Pa, from about $10^{-3}$ Pa to about $10^{-1}$ Pa, or any range or subrange therebetween. In aspects, the pressure (e.g., reduced pressure) of the chamber **903** can be maintained by operating one or more of the valve **905 and 925.** In further aspects, the pressure of the chamber **903** can be reduced or maintained by opening the valve **905** connected to a pump **907** that can remove gas from the chamber **903.** In further aspects, the pressure of the chamber **903** can be increased or maintained by opening the valve **925** connected to a gas source **921,** which adds gas to the chamber, as indicated by arrow **923.** In aspects, the gas source **921** can provide a non-reactive gas (e.g., argon, helium, krypton), oxygen, nitrogen, air, or a combination thereof. Providing a reduced pressure when evaporating the functionalized POSS can increase a rate of evaporation and/or enable a wide range of functionalized POSS materials to be used.

As shown in **FIG. 9,** the functionalized POSS **913** can be positioned in a container **911** placed within the chamber **903.** In the chamber **903,** the functionalized POSS **913** can evaporate (as indicated by arrow **915**) into the gas phase (as indicated by **917**) that can be disposed on the first major surface **105** of the substrate **103** (as indicated by arrow **919).** Exemplary aspects of the container **911** include a Knudsen cell or an effusion cell. In aspects, the container **911** can be maintained at a temperature of about 50°C or more, about 65°C or more, about 75°C or more, about 90°C or more, about 110°C or less, about 200°C or less, about 170°C or less, about 150°C or less, about 135°C or less, about 120°C or less, or about 110°C or less. In aspects, the container **911** can be maintained at a temperature ranging from about 50°C to about 200°C, from about 65°C to about 170°C, from about 75°C to about 150°C, from about 90°C to about 135°C, from about 110°C to about 135°C, or any range or subrange therebetween. Heating the container can facilitate evaporation of the functionalized POSS, which can increase a deposition rate.

In aspects, a deposition rate of the functionalized POSS **913** can be monitored using a sensor comprising a surface that is positioned a predetermined distance from the surface (e.g., first major surface **105** of the substrate **103).** In further aspects, the sensor can be configured to detect nanogram differences in mass from material deposited on the surface, where the increase in mass and predetermined surface area of the surface can be used to determine an effective deposition rate. It is to be understood that the "effective deposition rate" is not necessarily the actual deposition rate on the surface (e.g., first major surface **105**), and, in fact, may overestimate the actual deposition rate by as much as a factor or 2 or 3. An exemplary aspect of the sensor is a quartz crystal microbalance (QCM). As used herein, the "deposition rate" or "evaporation rate" refers to the effective deposition rate as measured by a QCM positioned 500 mm below the surface and 150 mm above the container **911**.

Although not shown, it is to be understood that if an optical stack **203** was disposed on the first major surface **105** that the functionalized POSS **913** would be disposed over the first major surface **105** and disposed on the optical stack **203**. In aspects, an evaporation rate of the functionalized POSS **913** onto the first major surface **105** can be about 0.01 nanometers per second (nm/s) (0.1 A/s) or more, about 0.03 nm/s (0.3 A/s) or more, about 0.05 nm/s (0.5 A/s) or more, about 0.1 nm/s or more (1 A/s), about 0.5 nm/s or less (5 A/s), about 0.3 nm/s (3 A/s) or less, about 0.2 nm/s (2 A/s) or less, or about 0.15 nm/s (1.5 A/s) or less. In aspects, an evaporation rate of the functionalized POSS **913** onto the first major surface **105** can range from about 0.01 nm/ to about 0.5 nm/s, from about 0.03 nm/s to about 0.3 nm/s, from about 0.05 to about 0.2 nm/s, from about 0.1 nm/s to about 0.15 nm/s, or any range or subrange therebetween. Controlling the evaporation rate within one or more of the above-mentioned ranges can efficiently (e.g., quickly) deposit a substantially uniform coating of the functionalized POSS on the first major surface. In aspects, at the end of step **703,** a thickness of the functionalized POSS disposed on the first major surface **105** can be within one or more of the ranges discussed above with reference to the anti-fingerprint thickness **119**. Without wishing to be bound by theory, it is believed that the evaporation of the functionalized POSS and deposition onto the first major surface does not in itself chemically (e.g., covalently) bond the functionalized POSS to the first major surface or modify the structure of the functionalized POSS. An Exemplary aspect of the container **911** in a Radak II cell that can be used in the chamber **903,** for example, an Angstrom Engineering Evovac chamber. Although not shown, it is to be understood that if an optical stack **203** was disposed on the first major surface **105** that the functionalized POSS **913** would be disposed over the first major surface **105** and disposed on the optical stack **203**.

After step **703** (or concurrent with step **703),** as shown in **FIG. 9,** methods can proceed to step **705** comprising impinging an ion beam traveling as a plume **933** on the first major surface **105** of the substrate **103**. As shown, the substrate **103** can be in the chamber **903,** which can be the same chamber **903** discussed above with reference to step **703.** In aspects, as shown in **FIG. 9,** a beam source **931** can be configured to emit an ion beam traveling as a plume **933** that is incident on the first major surface **105** of the substrate **103**. The beam source **931** can be operated such that the ion beam traveling as a plume **933** impinges the entire first major surface **105.** In aspects, the ion beam source **931** can comprise an end-Hall ion source, a grided ion source, or an inductively coupled plasma (ICP) ion source. An exemplary aspect of a beam source **931** is an end-Hall ion source. In aspects, the beam source **931** can generate the ion beam using a discharge current. Without wishing to be bound by theory, it is believed that an extent of reaction (e.g., from functionalized POSS to partial silica-like network) is influenced by the ion beam energy and discharge current. In further aspects, the discharge current can be about 0.25 Amps (A) or more, about 0.3 A or more, about 0.35 A or more, about 1 A or less, about 0.75 A or less, or about 0.5 A or less. In further aspects, the discharge current can range from about 0.25 A to about 1 A, from about 0.3 A to about 0.75 A, from about 0.35 A to about 0.5 A, or any range or subrange therebetween. In aspects, the beam source **931** can be operated at a voltage of about 100 Volts (V), for example, from about 50 V to about 220 V, from about 70 V to about 120 V, from about 90 V to about 110 V, or any range or subrange therebetween. In aspects, the ion beam can comprise ions of oxygen, ions of argon, or combinations thereof. The composition of the ion beam can be adjusted through choice of the gas source **921** and controlling an amount of gas released from the gas source **921** (e.g., using the valve **925).** In aspects, the chamber **903** (e.g., vacuum chamber) can be maintained at a reduced pressure within one or more of the ranges discussed above for the reduced pressure in step **703** (e.g., from about $10^{-8}$ Pa to about $10^{-7}$ Pa).

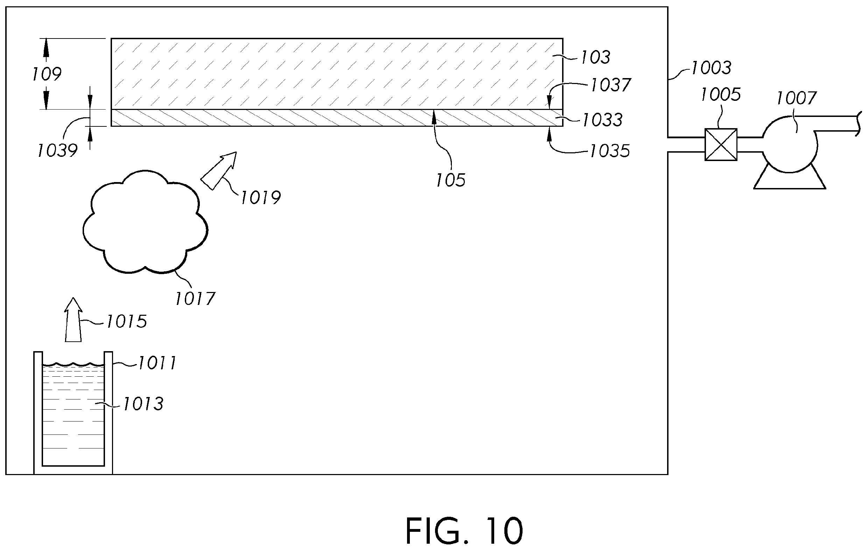

Without wishing to be bound by theory, it is believed that the ion beam disrupts the cage structure of the functionalized POSS, volatilizes the functional groups functionalizing the functionalized POSS, and/or causes the functionalized POSS to become bonded to the surface it is disposed on (e.g., the first major surface **105** as shown in **FIG. 9** or the fourth major surface **207** of the optical stack **203,** if present). At the end of step **705,** the coating **1033** (see **FIG. 10)** formed can comprise a partial silica-like network, for example, with a percentage of silicon atoms in the coating being in a silica-like network within one or more of the ranges discussed above for the percentage of silica atoms in the surface-modifying layer (e.g., anti-fingerprint coating) in a silica-like network. Additionally or alternatively, at the end of step **705,** the coating **1033** (see **FIG. 10)** formed can comprise a ratio of Si-O-Si bonds to silicon atoms within one or more of the ranges discussed above for the ratio of Si-O-Si bonds to silicon atoms. In further aspects, impinging the ion beam in step **705** can convert at least a fraction of the silicon atoms in a cage structure of the functionalized POSS to a partial Si-O-Si network (i.e., Si-O-Si bonds). In even further aspects, the fraction of silicon atoms converted in step **705** can range from about 50% to about 90%, from about 60% to about 80%, from about 65% to about 75%, or any range or subrange therebetween. In aspects, the coating thickness **1039** of the coating **1033** defined between opposing surfaces **1035 and 1037** can be within one or more of the ranges discussed above for the anti-fingerprint thickness **119**.

In aspects, the evaporating the functionalized POSS **913** of step **703** and the impinging the ion beam traveling along a beam path of step **705** can occur simultaneously. As used herein, steps **703 and 705** occurring "simultaneously" means that there is at least one point in time where the activities of steps **703 and 705** are both occurring. It is to be understood that it can still be simultaneous if one of the steps begins before the other step ends and/or if one of the steps ends before the other one ends, although both steps **703 and 705** can begin at the same time and/or end at the same time in further aspects. As shown in **FIG. 9,** the container **911** (e.g., Knudsen cell or an effusion cell), the substrate **103,** and at least a portion of the beam path can be positioned in the chamber **903** such that the functionalized POSS **913** in the gas phase (as indicated by **917**) and/or disposed on the first major surface **105** can be impinged by the ion beam travelling along the beam path. Performing steps **703 and 705** simultaneously can facilitate the formation of a coating **1033** (see **FIG. 10**) with good adhesion to the substrate **103** and/or that is relatively homogenous. Providing a discharge current of about 0.25 A or more can facilitate the formation of the coating **1033** (see **FIG. 10),** for example, producing an ion beam with sufficient energy to cause the functionalized POSS to react with other functionalized POSS and/or the first major surface **105** of the substrate **103** at an appreciable rate (e.g., compared to lower discharge currents). Providing a discharge current of about 1 A or less can provide an ion beam that is not so strong as to remove any POSS material being disposed by the evaporating. Additionally, performing steps **703 and 705** simultaneously can decrease processing time.

In aspects, after step **705,** as shown in **FIG. 10,** methods can proceed to step **707** comprising reacting material (e.g., coating **1033**) at the first major surface **105** of the substrate **103** with a alkyl silane to form a surface-modifying layer (e.g., an anti-fingerprint coating). **FIG. 10** shows one method of silanization. Methods can be performed at atmospheric pressure and/or a pressure within one or more of the ranges discussed above for step **703.** For example, the chamber **1003** can be an inert ampoule is heated by an oven at from about 60°C to about 200°C (e.g., about 60°C or more, about 80°C or more, about 90°C or more, about 100°C or more, about 120°C or more, about 140°C or more, about 250°C or less, about 220°C or less, about 200°C or less, about 180°C or less, or about 160°C or less). Samples are optionally plasma treated for surface activation with an $O_2$ or Ar plasma, and placed in the ampoule with a drop of silane, sealed and heated for from about 2 hours to about 5 hours. Providing an elevated temperature when evaporating the silane and reacting the silane with the coating can increase a rate of evaporation, enable a wide range of silanes to be used, increase a reaction rate or reactivity of the silane, and/or promote the formation of a covalent bonding to surface **1035** of the partially condensed silica film **1033.** Alternatively, the alkyl silane can react with the surface (e.g., first major surface, a surface of an optical stack, or the silica-like network formed by IAD) under ambient conditions (e.g., from about 25°C to about 30°C) to form the surface-modifying layer.

Another embodiment which we also have demonstrated is using a low vacuum chamber with a vapor source such as a YES-1124P (available from Yield Engineering Systems). Other manufacturers have similar systems. For example, the chamber can be heated at a temperature from about 100°C to about 200°C and evacuated to a pressure of about 10 Pa. Substrates are optionally exposed to a Ar or $O_2$ capacitively coupled plasma generated by low or high frequency RF. After pumping to base pressure the silane precursor vapor is introduced to the chamber. One method of silane vaporization is using a liquid vaporizer. Liquid can be injected by a pulse pump into a heated vaporization cell with independent temperature control where it is vaporized and travels through independently heated passage into the chamber. With independent temperature control condensation in the passage can be prevented. Vaporization of the silane can raise the chamber pressure by from about 1 Pa to about100 Pa, and the substrates are exposed to the vapor for a time (e.g., from about 2 minutes to about 20 minutes) and the chamber is evacuated with the pump to remove excess vapors and condensation products.

In another embodiment, a high vacuum coating chamber similar to **FIG. 9.** Substrates are cleaned with the End-Hall or ICP ion source and the silane is vaporized from either a liquid injection source similar to that described above, or desorbed from a sorbate (typically enclosed in a canister) using a thermal source such as a resistively heated tungsten boat, an effusion or Knudesn cell, or an electron beam evaporator. Deposition rate and total thickness can be monitored in these systems with a quartz crystal monitor (QCM). This type of chamber is commonly used in production of fluorinated ETC coatings on handheld devices such as cellphones.

In aspects, the silane **1013** can comprise an alkyl silane. In further aspects, the alkyl silane can comprise four or more carbons, for example, from 4 carbons to 34 carbons (e.g., $C_4$-$C_{34}$ alkyl), from 6 carbons to 20 carbons (e.g., $C_6$-$C_{34}$ alkyl), from 8 carbons to 18 carbons (e.g., $C_8$-$C_{18}$ alkyl), from 8 carbons to 12 carbons (e.g., $C_8$-$C_{12}$ alkyl), or any range or subrange therebetween. Exemplary aspects of alkyl silanes include iso-octyltrimethoxysilane, dodecyltrimethoxysilane, octadecyltrimethoxysilane, or combinations thereof. In aspects, the alkyl silane can comprise an alkyl group comprising from 4 carbons to about 34 carbons (i.e., a $C_4$-$C_{34}$ alkyl group) (e.g., from 6 carbons to 34 carbons (i.e., a $C_6$-$C_{34}$ alkyl group), from 8 carbons to 20 carbons (i.e. a $C_8$-$C_{20}$ alkyl group)), for example, an iso-octyl alkyl group, a dodecyl alkyl group, an octadecyl alkyl group, or combinations thereof. An exemplary aspects of the alkyl group is an octadecyl alkyl group. Providing an alkyl silane can reduce a surface energy (e.g., total, dispersive, polar) of the coating, which can enable the resulting anti-fingerprint coating to be oleophilic. At the end of step **707,** the silane can be bonded to the material of the coating **1033** to form the surface-modifying layer (e.g., anti-fingerprint coating **113**) (see **FIGS. 1 and 2A-2C).**

In aspects, after step **707,** methods can proceed to step **709** comprising assembling the coated article comprising the surface-modifying layer (e.g., anti-fingerprint coating **113**) into a consumer electronic device. For example, the surface-modifying layer (e.g., anti-fingerprint coating **113**) can comprise an exterior surface of a display portion of a display device and/or a touch-sensor. For example, the surface-modifying layer (e.g., anti-fingerprint coating **113**) can comprise an exterior surface of at least a portion of a consumer electronic device.

After step **707 or 709,** methods can proceed to step **711,** where methods of making the coated article can be complete. In aspects, methods of making a coated article in accordance with aspects of the disclosure can proceed along steps **701, 703, 705, 707, 709, and 711** of the flow chart in **FIG. 7** sequentially, as discussed above. In aspects, methods can follow arrow **706** from step **707** to step **711,** for example, if methods of making the coated article are complete at the end of step **707.** Any of the above options may be combined to make a foldable apparatus in accordance with the embodiments of the disclosure.

It is known that POSS materials can be cured at high temperatures (e.g., about 600°C or more). However, the methods discussed above with reference to the flow chart in **FIG. 7** can subject the functionalized POSS to a maximum temperature (e.g., through the evaporating of the functionalized POSS, impingement with the ion-beam, and subsequent functionalization with a silane) of about 250°C or less (e.g., about 220°C or less, about 200°C or less, about 180°C or less, about 160°C or less, about 120°C or less, or about 50°C or less) to obtain the surface-modifying layer (e.g., anti-fingerprint coating **113).** Consequently, the properties of the surface-modifying layer (e.g., anti-fingerprint coating **113)** formed in this way can exhibit a partial silica-like network (e.g., from about 50% to about 90%) as opposed to a substantially complete silica-like network, which could be formed from higher temperature treatments. As discussed below, the increased elastic modulus associated with exposing functionalized POSS materials to higher temperatures is associated with poor abrasion resistance.

At the end of methods discussed above with reference to the flow chart in **FIG. 7,** the coated article **101, 201, 211, or 221** and/or the surface-modifying layer (e.g., anti-fingerprint coating) can comprise any one or more of the aspects discussed above. For example, the surface-modifying layer (e.g., anti-fingerprint coating) can be fluorine-free and/or nitrogen-free. The surface-modifying layer (e.g., anti-fingerprint coating) can comprise a water contact angle, a diiodomethane contact angle, and/or a hexadecane contact angle within one or more of the corresponding ranges discussed above. The surface-modifying layer (e.g., anti-fingerprint coating) can comprise an abraded water contact angle after being abraded for 2,000 cycles, 3,000 cycles, or 3,5000 in a Steel Wool Abrasion Test and/or a cheesecloth-abraded water contact angle after being abraded for 200,000 cycles in a Cheesecloth Abrasion Test within one or more of the corresponding ranges discussed above. The surface-modifying layer (e.g., anti-fingerprint coating) can comprise a total surface energy, a dispersive surface energy, and/or a polar surface energy within one or more of the corresponding ranges discussed above. The surface-modifying layer (e.g., anti-fingerprint coating) can comprise an elastic modulus, a surface roughness Ra, and/or an anti-fingerprint thickness within one or more of the corresponding ranges discussed above. The surface-modifying layer (e.g., anti-fingerprint coating) can comprise a refractive index ranging from about 1.38 to about 1.55, from about 1.44 to about 1.55, from about 1.44 to about 1.53, from about 1.48 to about 1.51, or any range or subrange therebetween. In aspects, a percentage of silicon atoms in a silica-like network can be within one or more of the ranges discussed above (e.g., from about 50% to about 90%). In aspects, a ratio of Si-O-Si bonds to silicon atoms can be within one or more of the ranges discussed above (e.g., from about 2 to about 3).

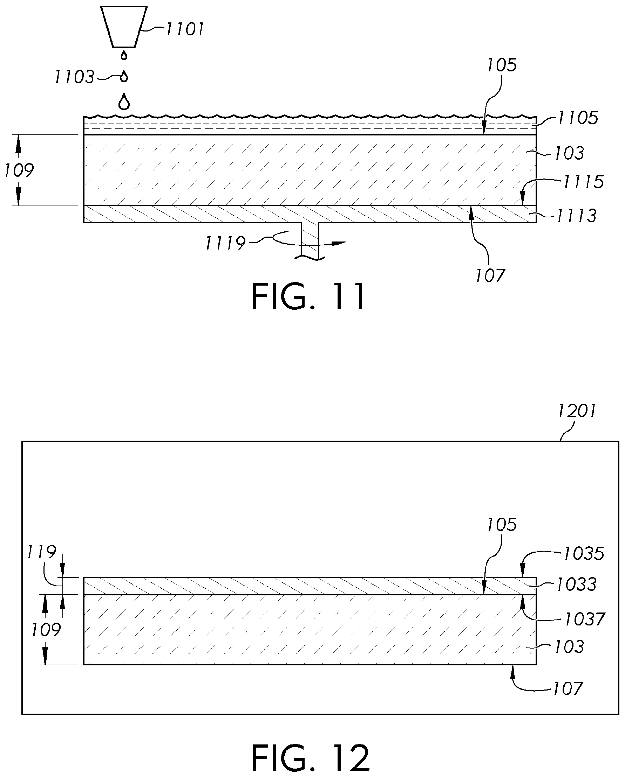

Example aspects of making a coated article **101, 201, 211, or 221** will now be discussed with reference to **FIGS. 6 and 10-12** and the flow chart in **FIG. 8.** In a first step **801,** methods can start with obtaining a substrate **103.** In aspects, the substrate **103** may be provided by purchase or otherwise obtaining a substrate or by forming the substrate. In aspects, the substrate **103** can comprise a glass-based material, a glass-ceramic material, and/or a ceramic-based material. In further aspects, -based material, a glass-ceramic material, and/or a ceramic-based material can be provided by forming them with a variety of ribbon forming processes, for example, slot draw, down-draw, fusion down-draw, up-draw, press roll, redraw, or float. In further aspects, ceramic-based substrates can be provided by heating a glass-based substrate to crystallize one or more ceramic crystals. The substrate **103** comprises a first major surface **105** that can extend along a first plane **104.** In aspects, as indicated in **FIG. 1,** an optical stack **203** comprising an anti-reflective coating and/or a gradient coating comprising a refractive index gradient can be disposed on and/or bonded to the first major surface **105.** Although not shown in **FIGS. 11-12,** it is to be understood that the optical stack **203** can be disposed on the first major surface **105.** In aspects, the substrate **103** can be chemically strengthened with one or more compressive stress regions (or central tension regions) comprising any of the aspects related to depth of compression, maximum compressive stress, and/or tensile stress discussed above for the corresponding property.

In aspects, step **801** can comprise obtaining material for a precursor solution **1103** (see **FIG. 11)** or obtaining a precursor solution. In further aspects, the precursor solution **1103** can comprise a functionalized polyhedral oligomeric silsesquioxane (POSS) (see **FIG. 5),** as discussed above with reference to step **701.** In even further aspects, the functionalized POSS can be at least partially and/or completely functionalized by hydrogen, which can simply be referred to as POSS. In further aspects, the precursor solution can comprise a polysilazane. As used herein, "polysilazane" is a polymer comprising a backbone of silicon and nitrogen. An exemplary polysilazane is perhydropolysilazane For example, as shown by the top compound in **FIG. 6,** the polysilazane can consist of alternating silicon and nitrogen atoms in a backbone of the polysilazane with hydrogen atoms bonded thereto. In further aspects, a concentration of the polysilazane or the POSS the precursor solution **1103** can be about 0.1 wt% or more, about 0.2 wt% or more, about 0.5 wt% or more, about 1 wt% or more, about 1.5 wt% or more, about 2 wt% or more, about 25 wt% or less, about 15 wt% or less, about 6 wt% or less, about 5 wt% or less, about 4 wt% or less, about 3 wt% or less, about 2.5 wt% or less, or about 2 wt% or less. In further aspects, a concentration of wherein a concentration of the polysilazane or the POSS the precursor solution **1103** can range from about 0.1 wt% to about 25 wt%, from about 0.2 wt% to about 25 wt%, from about 0.2 wt% to about 15 wt%, from about 0.2 wt% to about 6 wt%, from about 0.2 wt% to about 5 wt%, from about 0.5 wt% to about 4 wt%, from about 1 wt% to about 3 wt%, from about 1.5 wt% to about 2.5 wt%, or any range or subrange therebetween.

After step **801,** as shown in **FIG. 11,** methods can proceed to step **803** comprising disposing the precursor solution **1103** over the first major surface **105** of the substrate **103.** The precursor solution **1103** can comprise the polysilazane or the POSS in a concentration within one or more of the ranges discussed in the previous paragraph. In aspects, as shown **FIG. 11,** the precursor solution **1103** can be dispensed from a container **1101** (e.g., conduit, flexible tube, micropipette, ink-jet print head, or syringe) over (e.g., onto) the first major surface **105** of the substrate **103** to form a precursor layer **1105.** In further aspects, as shown, step **803** can comprise spin coating the precursor solution **1103** over (e.g., onto) the first major surface **105,** for example, by disposing the second major surface **107** of the substrate over a surface **1115** of a holder **1113** and the holder can be rotated (as shown by arrow **1119**) while and/or after the precursor solution **1103** is disposed over the first major surface **105.** In even further aspects, the holder **1113** can be rotated at 200 revolutions per minute (rpm) or more, about 500 rpm or more, about 700 rpm or more, about 4,000 rpm or less, about 2,500 rpm or less, or about 1,500 rpm or less. In even further aspects, the holder **1113** can be rotated from 200 rpm to about 4,000 rpm, from about 500 rpm to about 2,500 rpm, from about 700 rpm to about 1,500 rpm, or any range or subrange therebetween. Spin coating the precursor solution can form a substantially uniform precursor layer over the first major surface of the substrate.

After step **803,** as shown in **FIG. 12,** methods can proceed to step **805** comprising heating the precursor layer **1105** of the precursor solution **1103** (see **FIG. 11**) at a first temperature for a first period of time to form the coating **1033.** In aspects, as shown, the substrate **103** can be placed in an oven **1201** maintained at the first temperature for the first period of time. In aspects, the first temperature can be about 150°C or more, about 170°C or more, about 190°C or more, about 400°C or less, about 300°C or less, about 250°C or less, about 230°C or less, or about 210°C or less. In aspects, the first temperature can range from about 150°C to about 400°C, from about 150°C to about 300°C, from about 150°C to about 250°C, from about 170°C to about 230°C, from about 190°C to about 210°C, or any range or subrange therebetween. In aspects, the first period of time can be about 5 minutes or more, about 10 minutes or more, about 20 minutes or more, about 25 minutes or more, about 2 hours or less, about 1.5 hours or less, about 1 hour or less, or about 40 minutes or less. In aspects, the first period of time can range from about 5 minutes to about 2 hours, from about 10 minutes to about 1.5 hours, from about 20 minutes to about 1 hour, from about 25 minutes to about 40 minutes, or any range or subrange therebetween. In aspects, the precursor solution **1103** can comprise a catalyst or be free from a catalyst. In aspects, the precursor solution **1103** can contain a silane in addition to the polysilazane or the POSS. The silane can comprise any of the aspects discussed above for silanes.

Without wishing to be bound by theory, heating the precursor layer of the precursor solution can remove solvent from the precursor layer and/or partially cure the polysilazane or the POSS, for example, to form a partial silica-like network. For example, heating the POSS can cause the silicon-oxygen network to rearrange to a silica-like network and/or bond to a surface (e.g., first major surface **105**) that the precursor solution is disposed on. For example, as shown in **FIG. 6,** the polysilazane can undergo a reaction where ammonia and hydrogen is evolved and oxygen and water is consumed to transform from a structure with an alternating silicon-nitrogen backbone to a silica-like network with silicon-oxygen bonds. Since the polysilazane may only partially undergo this reaction, at the end of the step **805,** the coating **1033** can comprise silicon, oxygen, nitrogen, and/or hydrogen. Also, it is to be understood that these reactions may continue in subsequent steps (e.g., step **807**).

After step **805,** as shown in **FIG. 10,** methods can proceed to step **807** comprising reacting material (e.g., coating **1033**) at the first major surface **105** of the substrate **103** with an alkyl silane to form a surface-modifying layer (e.g., an anti-fingerprint coating). In further aspects, as shown, the substrate **103** can be placed in a chamber **1003,** which can be the same as the chamber **903** discussed above with reference to step **703** and/or step **705.** In further aspects, the chamber **1003** can be maintained at a reduced pressure, which can be within one or more of the ranges discussed above for the reduced pressure in step **703.** In aspects, the chamber **1003** can be maintained at a temperature within one or more of the range discussed above for the temperature in step **705.** Providing a reduced pressure and/or elevated temperature when evaporating the silane and reacting the silane with the coating can increase a rate of evaporation, enable a wide range of silanes to be used, increase a reaction rate or reactivity of the silane, and/or promote the formation of a silica-like network. As shown in **FIG. 10,** a silane **1013** can be positioned in a container **1011** placed within the chamber **1003.** In the chamber **1003,** the silane **1013** can evaporate (as indicated by arrow **1015**) into the gas phase (as indicated by **1017**) that can be disposed on the exterior surface **1035** of the coating **1033** (as indicated by arrow **1019**). In aspects, an evaporation rate of the silane **1013** can be within one or more of the evaporation rates discussed above with reference to step **705,** and controlling the evaporation rate within one or more of those ranges can efficiently (e.g., quickly) deposit and react the silane with the material of the coating (e.g., on the first major surface). In aspects, the silane **1013** can be heated for a period of time within one or more of the corresponding ranges discussed above with reference to step **705.** The silane **1013** can comprise any one or more of the silanes discussed above with reference to step **705.** For example, the silane can be an alkyl silane. The alkyl silane can comprise 4 or more carbons (e.g., $C_4$-$C_{34}$ alkyl, $C_6$-$C_{34}$ alkyl, $C_6$-$C_{20}$ alkyl, $C_8$-$C_{18}$ alkyl, or $C_8$-$C_{12}$ alkyl). Exemplary aspects of alkyl silanes include iso-octyltrimethoxysilane, dodecyltrimethoxysilane, octadecyltrimethoxysilane, or combinations thereof. In aspects, the alkyl silane can comprise an alkyl group comprising from 4 carbons to about 34 carbons (i.e., a $C_4$-$C_{34}$ alkyl group) (e.g., from 6 carbons to 34 carbons (i.e., a $C_6$-$C_{34}$ alkyl group), from 8 carbons to 20 carbons (i.e. a $C_8$-$C_{20}$ alkyl group)), for example, an iso-octyl alkyl group, a dodecyl alkyl group, an octadecyl alkyl group, or combinations thereof. An exemplary aspects of the alkyl group is an octadecyl alkyl group. The silane can be a bis-silane and/or tris-silane, which can be bonded to the rest of the coating in more than one location. For example, the bis-silane and/or tri-silane can comprise multiple silane groups at the same end of the silane, which can help orient a functional group of the silane. Providing an alkyl silane can reduce a surface energy (e.g., total, dispersive, polar) of the coating, which can enable the resulting anti-fingerprint coating to be oleophilic. At the end of step **807,** the silane can be bonded to the material of the coating **1033** to form the surface-modifying layer (e.g., anti-fingerprint coating **113**) (see **FIGS. 1 and 2A-2C).**

Alternatively, although not shown, reacting the material at the first major surface of the substrate with an alkyl substrate to form the surface-modifying layer (e.g., anti-fingerprint coating) can comprise (a) disposing the silane on the substrate as a solution before (b) heating the substrate to react the silane with the material at the first major surface of the substrate. For example, disposing the silane on the substrate can comprise dip coating the substrate in a solution comprising the silane can comprise spin coating the substrate with the solution comprising the silane, spray coating the substrate with a solution comprising the silane, or printing on the substrate with a solution comprising the silane. In aspects, the silane solution can comprise the silane, as a wt% of the silane solution, of about 0.1 wt% or more, about 0.2 wt% or more, about 0.5 wt% or more, about 1 wt% or more, about 25 wt% or less, about 15 wt% or less, about 6 wt% or less, about 5 wt% or less, or about 2 wt% or less. In aspects, the silane solution can comprise the silane, as a wt% of the silane solution, can range from about 0.1 wt% to about 25 wt%, from about 0.2 wt% to about 25 wt%, from about 0.2 wt% to about 15 wt%, from about 0.2 wt% to about 6 wt%, from about 0.2 wt% to about 5 wt%, from about 0.5 wt% to about 5 wt%, from about 1 wt% to about 2 wt%, or any range or subrange therebetween. In aspects, the silane can comprise any one or more of the silanes mentioned in the previous paragraph.

In aspects, after step **807,** methods can proceed to step **809** comprising assembling the coated article comprising the surface-modifying layer (e.g., anti-fingerprint coating **113)** into a consumer electronic device. For example, the surface-modifying layer (e.g., anti-fingerprint coating **113)** can comprise an exterior surface of a display portion of a display device and/or a touch-sensor. For example, the surface-modifying layer (e.g., anti-fingerprint coating **113)** can comprise an exterior surface of at least a portion of a consumer electronic device.

After step **807 or 809,** methods can proceed to step **811,** where methods of making the coated article can be complete. In aspects, methods of making a coated article in accordance with aspects of the disclosure can proceed along steps **801, 803, 805, 807, 809, and 811** of the flow chart in **FIG. 8** sequentially, as discussed above. In aspects, methods can follow arrow **802** from step **807** to step **811,** for example, if methods of making the coated article are complete at the end of step **807.** In aspects, methods can follow arrow **804** from step **805** to step **811,** for example if the precursor solution contained a silane in addition to a polysilazane or a POSS. Any of the above options may be combined to make a foldable apparatus in accordance with the embodiments of the disclosure.

At the end of methods discussed above with reference to the flow chart in **FIG. 7,** the coated article **101, 201, 211, or 221** and/or the surface-modifying layer (e.g., anti-fingerprint coating) can comprise any one or more of the aspects discussed above. For example, the surface-modifying layer (e.g., anti-fingerprint coating) can be fluorine-free. The surface-modifying layer (e.g., anti-fingerprint coating) can comprise a water contact angle, a diiodomethane contact angle, and/or a hexadecane contact angle within one or more of the corresponding ranges discussed above. The surface-modifying layer (e.g., anti-fingerprint coating) can comprise an abraded water contact angle after being abraded for 2,000 cycles, 3,000 cycles, or 3,5000 cycles in a Steel Wool Abrasion Test and/or a cheesecloth-abraded water contact angle after being abraded for 200,000 cycles in a Cheesecloth Abrasion Test within one or more of the corresponding ranges discussed above. The surface-modifying layer (e.g., anti-fingerprint coating) can comprise a total surface energy, a dispersive surface energy, and/or a polar surface energy within one or more of the corresponding ranges discussed above. The surface-modifying layer (e.g., anti-fingerprint coating) can comprise an elastic modulus, a surface roughness Ra, and/or an anti-fingerprint thickness within one or more of the corresponding ranges discussed above. The surface-modifying layer (e.g., anti-fingerprint coating) can comprise a refractive index ranging from about 1.38 to about 1.44, from about 1.39 to about 1.43, from about 1.4 to about 1.42, or any range or subrange therebetween. In aspects, the surface-modifying layer (e.g., anti-fingerprint coating) can comprise a partial silica-like network and either silicon hydrides or silanols.

Alternatively, another embodiment of the present disclosure can comprise making the surface-modifying layer (e.g., anti-fingerprint coating **113)** of the coated article **101, 201, 211, and/or 211** with a smaller anti-fingerprint thickness **119** and/or without a noticeable silica or partial silica-like network. For example, with reference to the flow chart shown in **FIG. 7,** although not shown, methods can go directly from step **701** to step **707** comprising disposing (e.g., reacting an alkyl silane) with a surface of the article (e.g., substrate) to form the surface-modifying layer (e.g., anti-fingerprint coating). For example, with reference to the flow chart shown in **FIG. 8,** although not shown, methods can go directly from step **801** to step **807** comprising disposing (e.g., reacting an alkyl silane) with a surface of the article (e.g., substrate) to form the surface-modifying layer (e.g., anti-fingerprint coating). In aspects, the alkyl silane can comprise any of the materials discussed above with reference to steps **707 and/or 807.** In further aspects, the alkyl silane can comprise an alkyl group comprising from 4 carbons to about 34 carbons (i.e., a $C_4$-$C_{34}$ alkyl group), for example, from 6 carbons to 34 carbons (i.e., a $C_6$-$C_{34}$ alkyl group), from 8 carbons to 20 carbons (i.e. a $C_8$-$C_{20}$ alkyl group). In even further aspects, the alkyl group can be an iso-octyl alkyl group, a dodecyl alkyl group, an octadecyl alkyl group, or combinations thereof. An exemplary aspect of the alkyl group is an octadecyl alkyl group. In aspects, the deposition conditions can be within any of the corresponding ranges discussed above with reference to step **707 and/or 807** and/or with reference to **FIG. 10.** Alternatively, the alkyl silane can be sprayed (e.g., spray coated) on the surface of the article (e.g., substrate), which can - in further aspects - be heated to form the surface-modifying layer (e.g., anti-fingerprint coating). As discussed above, the alkyl silane can react with the surface (e.g., first major surface, a surface of an optical stack) by (1) heating at the conditions discussed above for step **707** and/or (2) under ambient conditions (e.g., from about 25°C to about 30°C) to form the surface-modifying layer. In aspects, the anti-fingerprint thickness of the surface-modifying layer (e.g., anti-fingerprint coating) can be in a range from about 1 nm to about 75 nm, from about 1 nm to about 50 nm, from about 1 nm to about 25 nm, from about 1 nm to about 15 nm, from about 2 nm to about 10 nm, from about 2 nm to about 8 nm, from about 2 nm to about 5 nm, from about 3 nm to about 5 nm, or any range or subrange therebetween. In aspects, the surface-modifying layer (e.g., anti-fingerprint coating, alkyl silane) can exhibit a water contact angle (e.g., about 100° or more or from 102° to 110°), a diiodomethane contact angle (e.g., about 60° or more), a coefficient of friction (e.g., about 0.25 or less), a polar surface energy (e.g., about 3 mN/m or less), a total surface energy (e.g., about 30 mN/m or less), a cheesecloth-abraded water contact angle (e.g., about 90° or more after being subjected to 200,000 cycles in the Cheesecloth Abrasion Test), and/or a rubber-abraded water contact angle (e.g., about 80° or more, about 90° or more, or from about 100° to about 110° after being subjected to 5,000 cycles in the Rubber Abrasion Test) within one or more of the corresponding ranges discussed above.

## EXAMPLES

Various aspects will be further clarified by the following examples. Examples A-C and AA-CC comprised a glass-based substrate (Composition 1 having a nominal composition in wt% of: 61.9 $SiO_2$; 19.7 $Al_2O_3$; 12.9 $Na_2O$; 3.9 $B_2O_3$, 1.5 MgO, and 0.1 $K_2O$) with a thickness of 0.55 mm. Examples D-J and Comparative Examples DD-II comprised a glass-based substrate (Composition 1) with a thickness of 1 mm. Examples K-M and 1-12 and Comparative Examples JJ-KK comprised a glass-based substrate (Composition 2 having a nominal composition in wt% of: 67.6 $SiO_2$; 12.7 $Al_2O_3$; 13.6 $Na_2O$; 3.7 $B_2O_3$, 2.3 MgO, and 0.1 $Sn_2O$) with a thickness of 0.55 mm. Examples O-S comprised a silicon substrate for analysis by infrared spectroscopy.

Comparative Example AA was just the glass-based substrate. Comparative Example BB comprised a $SiO_2$ coating disposed on the glass-based substrate using high-density plasma chemical vapor deposition (HDPCVD). Comparative Examples AA-BB had water contact angles < 60°. Comparative Example CC comprised a coating of octavinyl POSS (OV-POSS) disposed on the glass-based substrate by thermally evaporating the OV-POSS at a rate of 0.2 nm/s. Unless otherwise, indicated, thermal evaporation of functionalized POSS occurred using a Radak II cell in an Angstrom Engineering Evovac chamber.

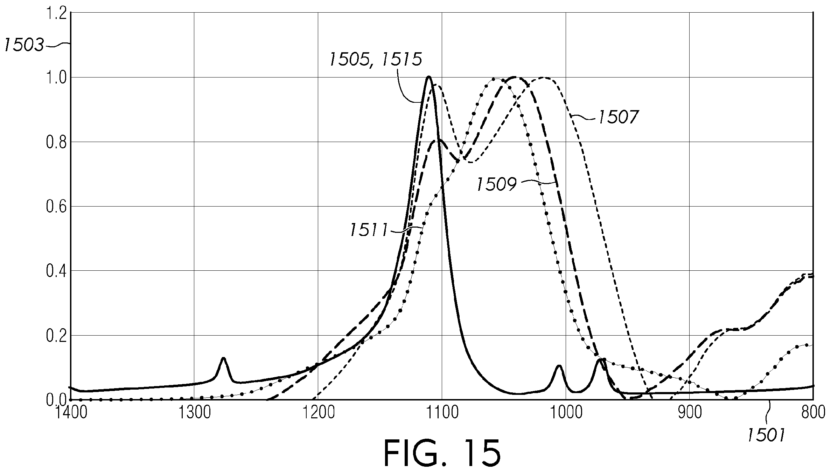

**FIG. 15** shows infrared (IR) absorption spectra with the horizontal axis **1501** (i.e., x-axis) corresponding to wavenumber in inverse centimeters ($cm^{-1}$) and the vertical axis **1503** (i.e., y-axis) corresponding to normalized absorbance. Curve **1515** represents the normalized absorbance of OV-POSS, as obtained, where a large peak at about 1105 $cm^{-1}$ corresponding to the Si-O-Si bonds of the T-type ($RSiO_{1.5}$) units in the POSS cage and smaller peaks around 1270 $cm^{-1}$, 1010 $cm^{-1}$ and 980 $cm^{-1}$ are visible. Curve **1505** represents the absorbance of Comparative Example CC, where the OV-POSS was thermally evaporated onto the glass-based substrate. Curves **1505 and 1515** are identical, which indicates that the OV-POSS thermally evaporated onto the glass-based substrate has not reacted with itself or the glass-based substrate. Also, the coating of Comparative Example was easily removed with a fingernail and exhibited poor abrasion resistance.

As used in this section, the ion beam formed from an end-Hall source (KRI 400 from Kaufman & Robinson) operated at a voltage of 100 V. To explore the effect of ion beam intensity on coating formation during evaporation of the OV-POSS at 0.1 A/s, the discharge current was adjusted while the chamber pressure was about 1.3 x $10^{-2}$ Pa of argon (Ar) gas (maintained with a flow of 2.7 sccm Ar). At a discharge current of 2.5 A, no coating was observed. The discharge current was decreased until coating formation was observed, which occurred at a discharge current of about 1 A. It is believed that the ion beam removed and/or decomposed the OV-POSS at the same rate or faster than it was deposited by thermal evaporation. Also, coatings were formed with different discharge current while the chamber pressure was maintained at about 2.7 x $10^{-2}$ Pa of oxygen ($O_2$) gas (maintained with a flow of 7 sccm $O_2$). The discharge current was increased from 0 A to determine the lowest discharge current that a coating that could not be easily removed with a fingernail was obtained, which resulted in a minimum discharge current of about 0.25 A. Consequently, it is believed that the coatings can be formed using a discharge current of from about 0.25 A to about 1 A with the end-Hall source.

The properties of Examples A-C and Comparative Examples AA-CC are shown in Table 1. In Table 1, "IAD" refers to ion-assisted deposition and refers to the use of the ion beam in conjunction with the evaporation. In Table 1, the reported refractive index values and extinction coefficient values were taken at an optical wavelength of 550 nm. The thickness of the coatings was measured using SEM, as described above, and is reported in Table 1.

Examples A-C were formed by thermally evaporating the OV-POSS at a rate of about 0.07 nm/s (0.7 A/s) (slightly lower than in Comparative Example CC due to the ion beam) and simultaneously impinging an ion beam formed from an end-Hall source (KRI 400 from Kaufman & Robinson) operated at a voltage of 100 V and a discharge current of 0.25 A. For Example A, the chamber pressure was about $1.3 \times 10^{-2}$ Pa of argon (Ar) gas (maintained with a flow of 2.7 sccm Ar). For Example B, the chamber pressure was about $2.7 \times 10^{-2}$ Pa of oxygen ($O_2$) gas (maintained with a flow of 7 sccm $O_2$). For example C, the chamber pressure was about $4 \times 10^{-2}$ Pa of a 70 mol% Ar 30 mol% $O_2$ mix (maintained with a flow of 10 sccm of the mixture). In Examples A-C, the evaporation and ion-beam treatment continued until a coating of about 400 nm was obtained.

Table 1: Properties of Examples A-C and Comparative Examples AA-CC

| Ex. | Coating | t (nm) | Refractive Index | Extinction Coefficient | Elastic Modulus (GPa) | % Silica-like Network | Ra (nm) |
|---|---|---|---|---|---|---|---|
| A | OV-POSS (Ar IAD) | 460 | 1.55 | 0.006 | 20 | 85 | 0.59 |
| B | OV-POSS ($O_2$ IAD) | 465 | 1.48 | <0.003 | 30 | 65 | 0.42 |
| C | OV-POSS (Ar/$O_2$ IAD) | 77 | 1.54 | 0.005 | -- | 75 | -- |
| AA | n/a | n/a | -- | -- | n/a | n/a | -- |
| BB | $SiO_2$ | 305 | 1.46 | <0.003 | 48 | 100 | 0.39 |
| CC | OV-POSS (evap) | 400 | 1.48 | 0.003 | 5 | 0 | -- |

Returning to **FIG. 15,** curves **1507, 1509, and 1511** correspond to Examples A-C, respectively. As shown, curves **1507, 1509, and 1511** have large peaks from about 1000 cm$^{-1}$ to about 1060 cm$^{-1}$ that is not present to this extent in curve **1505 or 1515.** This peak is attributed to the formation of Q-type (i.e., silica-like) Si-O-Si bonds, which demonstrates that the ion beam treatment transforms the OV-POSS. Indeed, the intensity of the peak around 1105 cm$^{-1}$ decreases going from curve **1505** to curve **1507** to curve **1509** to curve **1511.** This demonstrates that the ion-beam treatment at least partially disrupts the cage structure, for example, by transforming T-type structures into Q-type structures. Also, the greater fraction of oxygen in the chamber (and thus in the ion beam) is associated with greater disruption of the T-type structures.

Based on the IR peaks, a % silica-type network is calculated, as discussed above, and reported in Table 1. Also, the elastic modulus of the coatings was measured using nanoindentation, as discussed above, and reported in Table 1. As shown, the elastic modulus increases as the fraction of the coating in a silica-like network increases. Example A comprises an elastic modulus of 20 GPa and about 65% of the coating is in a silica-type network. Example B comprises an elastic modulus of 30 GPa and about 85% of the coating is in a silica-type network. Based on the increased fraction of silica-type network in Example B relative to Example A, it appears that the oxygen ion beam achieves a greater extent of reaction (from OV-POSS to silica-type network) than the argon ion beam (and thermal evaporation along does not cause this reaction to occur).

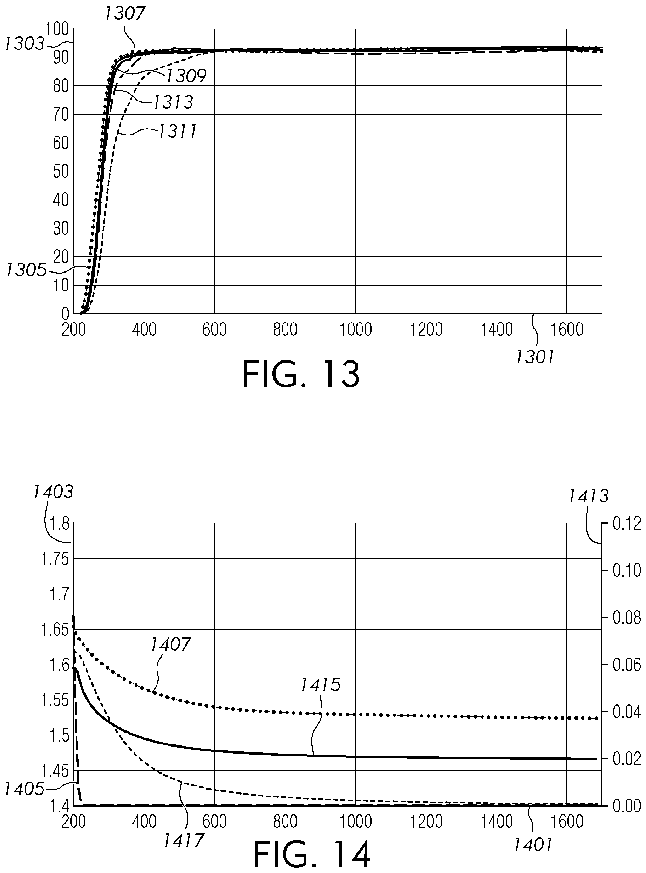

**FIG. 14** shows refractive index and extinction coefficient curves as a function of optical wavelength for Examples A-B. The horizontal axis **1401** (i.e., x-axis) represents optical wavelength in nm. The left vertical axis **1403** (i.e., y-axis on the left) represents refractive index, and curves **1405 and 1407** correspond to the refractive index curves of Examples A-B, respectively. The right vertical axis **1413** (i.e., y-axis on the right) represents the extinction coefficient, and curves **1415 and 1417** correspond to the extinction coefficient curves of Examples A-B, respectively. As shown, in Table 1 and **FIG. 14,** Example B (curve **1407;** 1.48) has a greater refractive index than Example A (curve **1405;** 1.55), which can be attributed to the greater disruption of the POSS cage structure by the oxygen ion beam compared to the argon ion beam resulting in a more silica-like structure. As shown in **FIG. 14,** the extinction coefficient for Example B (curve **1417**) drops to zero before an optical wavelength of 250 nm and remains there throughout the visible spectrum, which is associated with low absorption of visible light. For Example A (curve **1415**) the extinction coefficient decreases as optical wavelength increases, but the extinction coefficient at 550 nm is still about 0.006.

**FIG. 13** shows transmittance as a function of optical wavelength for Examples A-B and Comparative Examples AA-CC. The horizontal axis **1301** (i.e., x-axis) corresponds to optical wavelengths in nm, and the vertical axis **1303** (i.e., y-axis) corresponds to transmittance %. As shown in **FIG. 13,** curves **1305, 1307, and 1309** (Comparative Examples AA-CC, respectively) have substantially the same transmittance over the visible spectrum. Curve **1313** (Example B) has decreased transmittance for optical wavelengths less than 400 nm, but the transmittance is about the same as Comparative Examples AA-CC for optical wavelengths of about 400 nm or more. Curve **1311** (Example A) has decreased transmittance for optical wavelengths less than 600 nm, but the transmittance is about the same as Comparative Examples AA-CC for optical wavelengths of about 600 nm or more. Based on these results shown in **FIGS. 13-14,** the oxygen ion beam produces coatings with decreased extinction coefficient and increased transmittance than those produced with the argon ion beam.

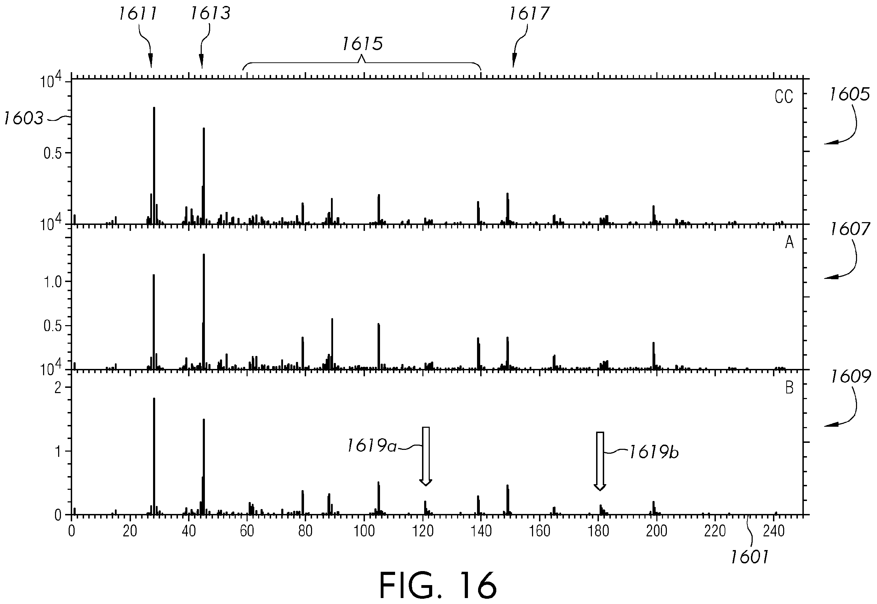

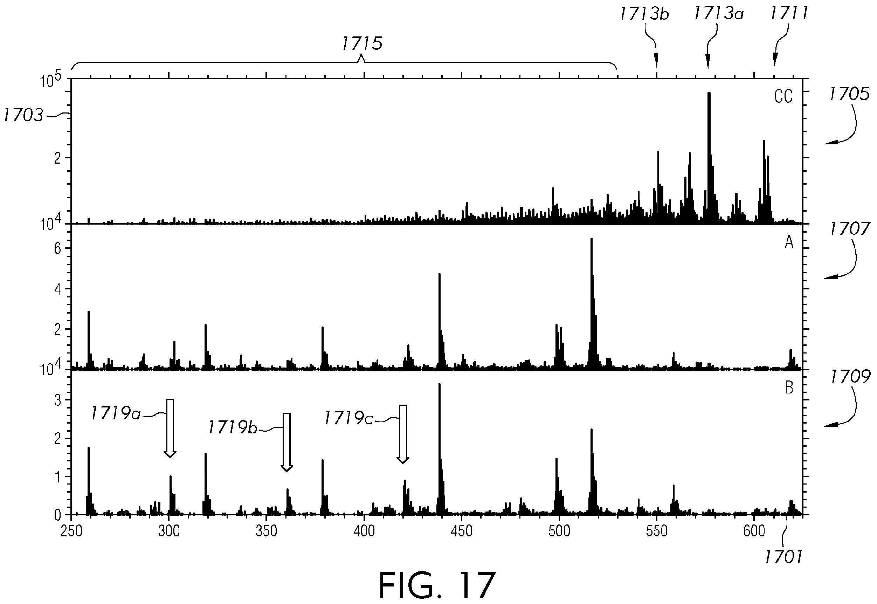

**FIGS. 16-17** illustrate the mass-to-charge distributions for Examples A-B and Comparative Example CC from secondary-ion mass spectrometry (SIMS) (i.e., static SIMS). The horizontal axes **1601 and 1701** (i.e., x-axis) represent positive mass-to-charge ratios with horizontal axis **1601** (i.e., x-axis) spanning from 0 to 250 and horizontal axis **1701** (i.e., x-axis) spanning from 250 to 650. Samples were cleaned with a low-energy Ar gas cluster ion beam (GCIB) source before analysis with SIMS. The vertical axis **1603 and 1703** (i.e., y-axis) represents the number of counts observed. In **FIGS. 16-17,** each distribution in the same figure shares the same horizontal axis (i.e., x-axis) while the vertical axis (i.e., y-axis) resets at the horizontal line. Distributions **1605 and 1705** correspond to Comparative Example CC, distributions **1607 and 1707** correspond to Comparative Example A, and distributions **1609 and 1709** correspond to Example B. In **FIG. 17,** peak **1711** corresponds to OV-POSS, and peaks **1713a and 1713b** correspond to large fragments of OV-POSS, which is consistent with the observations above that evaporation of OV-POSS alone does not physically bond or otherwise react with the first major surface of the substrate. Peak **1617** corresponds to phthalates. Peak **1611** corresponds to Si and peak **1613** corresponds to SiOH. Regions **1615 and 1715** predominantly correspond to silicate clusters. Specifically peaks **1719a, 1719b, and 1719c** correspond to dehydrogenated silicate clusters, which are only present in distributions **1609 and 1709** and is believed to be associated with higher content of silica-like networks.

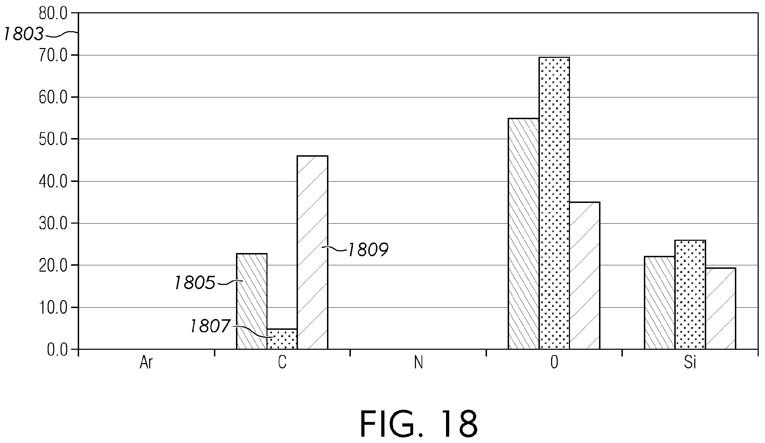

**FIG. 18** illustrates the elemental composition of Examples A-B and Comparative Example CC as determined by X-ray photoelectron spectroscopy (XPS). As shown, rectangles **1805** correspond to Example A, rectangles **1807** correspond to Example B, and rectangles **1809** correspond to Comparative Example CC. The vertical axis **1803** (i.e., y-axis) represents the atom%. All of the Examples had 0.1 atom% or less of argon and nitrogen. Rectangle **1809** (Example CC) has the most carbon and the least oxygen. Compared to the about 45 atom% carbon for rectangle **1809,** rectangle **1805** (Example A) has about half the carbon (about 23 atom%) while rectangle **1807** (Example B) has about 5 atom% carbon. It is believed that the 5 atom% carbon level is about the level of background environmental contamination present when the samples were analyzed. Rectangle **1807** (Example B) had the least carbon and the least oxygen, which corresponds to the greater extent of reaction caused by the oxygen ion beam, for example, resulting in the vinyl functional groups at the exterior surface being removed. The silicon amounts are about the same for Examples A-B and Comparative Example CC.

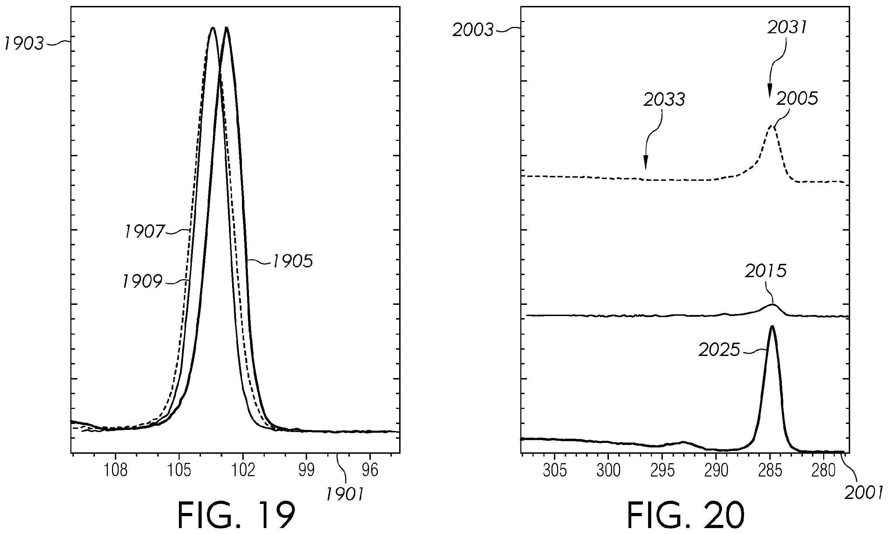

**FIG. 19** shows binding energy distributions from XPS for electrons in the 2p orbital of silicon atoms for Examples A-B and Comparative Example CC, and **FIG. 20** shows binding energy corresponding to the fine-structure of carbon atoms. The horizontal axes **1901 and 2001** (i.e., x-axis) correspond to binding energy in electronVolts (eV), and the vertical axes **1903 and 2003** (i.e., y-axis) correspond to the intensity. **FIG. 19** shows binding energy distributions for the 2p orbital of silicon atoms. Curve **1905** corresponds to Comparative Example CC, which had the highest binding energy, which is lower than that for pure Si-CH=CH$_2$ bonding but greater than that for pure silica-like networks. Curves **1907 and 1909** correspond to Examples A-B, respectively, which are symmetric and have the same peak binding energy, which is about the same as the reference value for a pure silica-like network, which is consistent with the reduced carbon observed for these examples in **FIG. 18.** Curve **1907** (Example A) is narrower than curve **1909** (Example B), which suggests a more uniform structure that would be consistent with the greater extent of reaction caused by the oxygen ion beam.

**FIG. 20** shows binding energy corresponding to the fine-structure of carbon atoms. Curves **2005, 2015, and 2025** correspond to Examples A-B and Comparative Example CC, respectively. Region **2031** corresponds to carbon single bonds (e.g., with another carbon atoms or with a hydrogen atom) while region **2033** corresponds to carbon-carbon double bonds. As shown, only curve **2025** (Comparative Example CC) has significant intensity in region **2033,** which is consistent with the above explanation that the ion beam treatment reacts and/or removes the vinyl functional groups. As shown, the large peak in region **2031** can be fit as the sum of several smaller curves (e.g., Gaussians). In region **2031,** curve **2025** is the biggest, followed by curve **2005,** and then **2015,** which is consistent with the carbon content detected in **FIG. 18.**

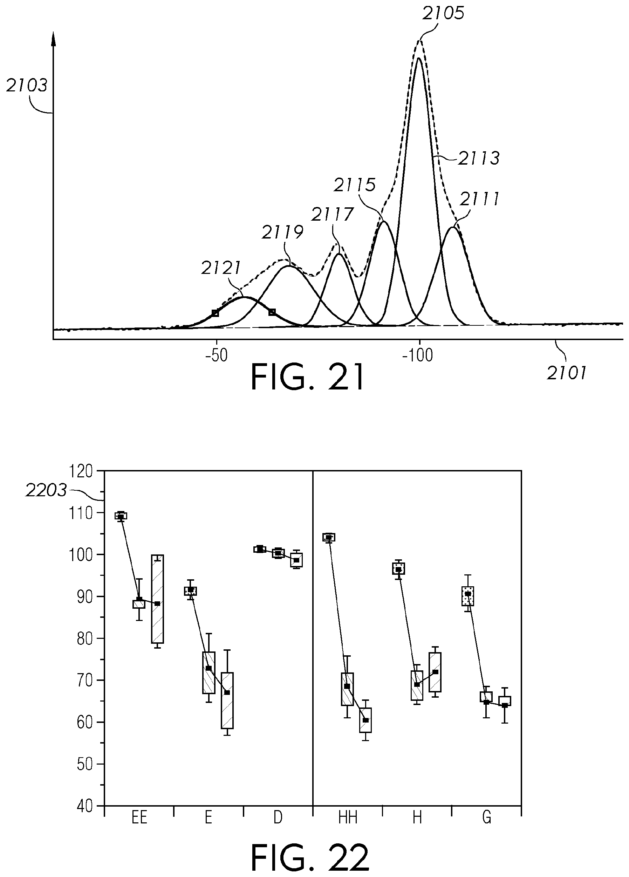

**FIG. 21** shows $^{29}$Si chemical shift from solid-state nuclear magnetic resonance (NMR) (SS-NMR) for a sample prepared the same as Example B, but on a Si-coated KBr substrate to form a thickness of 2.7 $\mu$m using 8 deposition cycles to improve signal resolution. The 2.7 $\mu$m thick coating was scraped off the glass-based substrate and analyzed using SS-NMR to remove contributions from the glass-based substrate. The horizontal axis **2101** (i.e., x-axis) is the $^{29}$Si chemical shift and the vertical axis **2103** (i.e., y-axis) is intensity. Curve **2105** is the overall signal detected, which is fit using 6 smaller curves (e.g., Gaussian) **2111, 2113, 2115, 2117, 2119, and 2121.** Based on the $^{29}$Si chemical shift for each fitted curve, these curves can be assigned to different structures. For example, curve **2121** is associated with an M-type structure (e.g., (SiO)Si(OH)$_3$), curve **2119** is associated with a T-type structure found in POSS (e.g., (SiO)$_3$Si(R) or RSiO$_{1.5}$), curve **2117** is associated with a D-type structure (e.g., (SiO)2Si(OH)(R)), and curves **2111, 2113, and 2115** are associated with Q-type structures (e.g., silica-type networks with $(SiO)_xSi(OH)_{4-x}$, where x is an integer from 2 to 4). Based on the assignment of these fitted curves and the associated area, ratios of 1.4 Si-OH per Si, 0.14 Si-R per Si (where R is an organic group), and 2.72 Si-O-Si per Si were determined. The low amount of Si-R bonds is consistent with the oxygen ion beam decreasing the organic content of the OV-POSS. The large preponderance of Q-type structures is indicative of the large (but not complete - e.g., from about 50% to about 90%) silica-type network formed using the deposition conditions of Example B.

The adhesion of the Examples A-C and Comparative Examples AA-BB was tested by disposing a 2 $\mu$m thick silicon nitride (SiN$_x$) coating on thereon with the surface of the coating cleaned with either (a) a Branson inductively coupled plasma (ICP) asher (Branson L3200 ICP Plasma Asher) operated at 600 W and a chamber pressure of 160 Pa with 300 sccm of oxygen for 10 minutes and/or (b) a Versaline HDPCVD (available from Plasma-Therm) operated at 2,000 W and a chamber pressure of about 1 Pa with 50 sccm of oxygen for 1 minute before disposing the silicon nitride coating. A diamond scribe was used to make three parallel 20 mm long scratches that penetrated through all coatings to the first major surface of the glass-based substrate. Then, the coatings were covered with 0.1 wt% Triton X-100 in deionized water for 1 minute before a plastic razor blade was used to squeegee perpendicular to the scratches 25 times in both directions. The samples were inspected using optical microscopy (100x magnification) as-formed and then after the samples were scratched, covered, and squeegeed for blisters or other signs of delamination. The 2 $\mu$m thick silicon nitride coating makes it clearer whether delaminations occur and subjects the coating to the sorts of stresses that would be encountered in when used in conjunction with other coatings (e.g., anti-reflective, gradient index).

Table 2 presents the results of this adhesion testing. Comparative Examples AA-BB exhibited no blisters and 0 or 1 delaminations. For Examples A and C, the Branson cleaning prevented the blister seen without it and reduced the number of delaminations from 50 or 28 to 4 or 5. For Example B, no blistering was observed for any condition with either 0 or 1 delamination. It is unexpected that Example B (oxygen ion beam) would provide no blisters and 0 or 1 delaminations under these harsh conditions.

Table 2: Adhesion testing for Examples A-B and Comparative Examples AA-CC

| Ex. | Branson cleaning? | Takachi cleaning? | Blisters | Delaminations |
|---|---|---|---|---|
| A | N | Y | Y | 50 |
| A | Y | Y | N | 4 |
| B | N | N | N | 0 |
| B | N | Y | N | 0 |
| B | Y | Y | N | 1 |
| C | N | Y | Y | 28 |
| C | Y | Y | N | 5 |
| AA | N | N | N | 1 |
| AA | N | Y | N | 1 |
| BB | N | N | N | 0 |

The chemical stability of Examples A-B and Comparative Example BB were tested by measuring the changing in thickness and refractive index after the coatings were sequentially subjected to (1) 20 minutes in 2 wt% alkaline detergent solution (Semi Clean KG) at 50°C and (2) 20 minutes in deionized water. All samples exhibited a thickness loss of less than 7 nm and less than 2%, with Example A having a thickness loss of about 1.2 nm, Example B having a thickness loss of about 6.7 nm (1.4%), and Comparative Example BB having a thickness loss of 5.1 nm (1.7%). All examples exhibited a change in refractive index of less than 0.002 with Example A having an increase in refractive index of 0.0008, Example B having an increase in refractive index of 0.004, and Comparative Example BB having a decrease in refractive index of 0.0013. This demonstrates that the chemical stability of Examples A-B is comparable to if not better than that of a silica coating (Comparative Example BB).

The thermal stability of Examples A-B were evaluated by heating samples at a temperature of 200°C, 300°C, or 400°C for 10 minutes. For all conditions, changes in thickness were less than 5%. At 300°C, the change in thickness was less than 3% for Example A and about 1% for Example B. At 200°C, the change in thickness for Example B was less than 2.5% and less than 0.5% for Example A. Likewise, IR spectra after these thermal treatments (not shown) were substantially the same with changes in normalized absorbance of less than 0.05. from 500 cm$^{-1}$ to 1500 cm$^{-1}$. This demonstrates that the coatings are thermally stable. However, as discussed above, it is believed that prolonged heating at high temperatures can form a greater amount of silica-like network (e.g., greater than 90%) that is detrimental to abrasion resistance.

Table 3 presents contact angles and surface energy values for Examples D-I and Comparative Example DD-GG, which were prepared by disposing an initial coating and then optionally reacting this coating with an evaporated silane. The initial coating for Examples D-F was formed by evaporating OV-POSS at 0.78 A/s while impinging an oxygen ion beam generated by an end-Hall source (KRI EH-400) operated at 100 V with a discharged current of 0.25 and a chamber pressure of $5.3 \times 10^{-5}$ Pa of oxygen ($O_2$) gas (maintained with a flow of 3 sccm $O_2$), which produced a thickness of about 105 nm, a refractive index of 1.486, and relatively strong O-H stretch by FTIR ("high OH"). The initial coating for Examples G-I was formed by evaporating OV-PSS at 18.9 A/s while impinging an oxygen ion beam generated by an end-Hall source (KRI EH-400) operated at 100 V with a discharged current of 0.25 and a chamber pressure of $5.3 \times 10^{-5}$ Pa of oxygen ($O_2$) gas (maintained with a flow of 3 sccm $O_2$), which had a slight gray color attributed to residual vinyl groups, which was confirmed by FTIR showing the C=C vinyl stretch and a relatively weak O-H stretch ("low OH"). Then, the initial coatings (e.g., low OH, high OH) were placed upright in Salvillex PFA vials along with 25 µL of a silane disposed away from the sample; after the lid was secured, it was heated at 170°C for 5 hours before removing the lid and allowing the sample to cool to room temperature (e.g., about 25°C) naturally.

As used in Table 3, "18TMS" refers to octadecyltrimethoxysilane, "i8TMS" refers to iso-octyltrimethoxysilane, "12TES" refers to dodecyltriethoxysilane, and "ETMS" refers to ethyoxytrimethylsilane. 18TMS, i8TMS, 12TES, and ETMS are alkyl silanes (e.g., trialkoxy alkyl silanes). 18TMS, i8TMS, and 12TES are methoxysilanes while ETMS is an ethoxysilane. "POTS" refers to heptadecafluoro-1,1,2,2-tetrahdryotrimethoxysilane, which is a fluorine-containing silane. As used herein, "WCA" refers to the water contact angle (as-formed), "HDCA" refers to the hexadecane contact angle (as-formed), and "DIMCA" refers to the diiodomethane contact angle (as-formed).

As shown in FIG. 3, Comparative Examples DD and GG are not hydrophobic, have total surface energies of 40 mN/m or more, and polar surface energies of 7 mN/m or more, which suggests that the initial coating of OV-POSS alone would not be suitable as an anti-fingerprint coating. Also, Comparative Examples FF and II are not hydrophobic, have total surface energies of 34 mN/m or more, and polar surface energies of 8 mN/m or more, which suggests that the single ethoxy silane may not be suitable for functionalizing the initial coating of OV-POSS to form an anti-fingerprint coating. On the other hand, Comparative Examples EE and HH uses a fluorine-containing silane, which produces a hydrophobic water contact angle, a low total surface energy, and a low polar surface energy.

Table 3: Contact angles and surface energy for Examples

| Ex | Initial Coating | Silane | WCA | HDCA | DIMCA | Total Surface Energy (mN/m) | Dispersive Surface Energy (mN/m) | Polar Surface Energy (mN/m) |
|---|---|---|---|---|---|---|---|---|
| D | High OH | 18TMS | 103.5° | wet | 66.6° | 29.2 | 27.3 | 1.9 |
| E | High OH | i8TMS | 100.2° | 27.1° | 73.9° | 26.9 | 23.6 | 3.4 |
| F | High OH | 12TES | 101.6° | 18.1° | 73.5° | 28.5 | 25.7 | 2.9 |
| G | Low OH | 18TMS | 96.9° | wet | 55.1° | 32.2 | 27.9 | 4.3 |
| H | Low OH | i8TMS | 99.1° | 31.9° | 63.3° | 28.1 | 23.6 | 4.5 |
| I | Low OH | 12TES | 102.9° | 42.8° | 73.8° | 24.9 | 21.1 | 3.8 |
| J | PHPS | 18TMS | 103° | 17° | 65° | 28.6 | 26.1 | 2.6 |
| DD | High OH | n/a | 31.8° | 28.4° | 48.1° | 63.7 | 24.8 | 38.9 |
| EE | High OH | POTS | 110.5° | 70.2° | 101.6° | 17.3 | 13.6 | 3.7 |
| FF | High OH | ETMS | 67.6° | 29.3° | 83.5° | 35.1 | 24.6 | 10.5 |
| GG | Low OH | n/a | 87.0° | 19.6° | 48.9° | 40.2 | 33.4 | 6.8 |
| HH | Low OH | POTS | 108.3° | 55.9° | 82.2° | 20.4 | 17.4 | 3.0 |
| II | Low OH | ETMS | 86.8° | 23.1° | 58.8° | 34.5 | 25.7 | 8.8 |

Examples D-I are hydrophobic with water contact angles of 90° or more and 95° or more. Examples D-F and I have water contact angles of 100° or more. Examples D-I are oleophilic. Examples D-I either wet hexadecane or has a hexadecane water contact of 45° or less. Examples D-H either wet hexadecane or has a hexadecane water contact angle of 40° or less or about 35° or less. Examples D-G either wet hexadecane or has a hexadecane water contact angle of 30° or less. This suggests that "high OH" initial coating (e.g., with the lower evaporation rate of the functionalized POSS). Examples D-F and G-I have a diiodomethane contact angle from about 60° to about 80°. Examples D-F and H-I have a total surface energy of 30 mN/m or less. Examples D-I have a dispersive surface energy of 30 mN/m or less. Examples D-I have a polar surface energy of 5 mN/m or less. Examples D-F and I have a surface energy of 4 mN/m or less. Example D and F have a polar surface energy of 3 mN/m or less. Compared to Comparative Examples EE and HH (fluorine-containing silane), Examples D-I are more oleophilic (lower hexadecane contact angle) and have a lower diiodomethane contact angle, which suggests that Examples D and F are better suited for anti-fingerprint applications than Comparative Examples EE and HH.

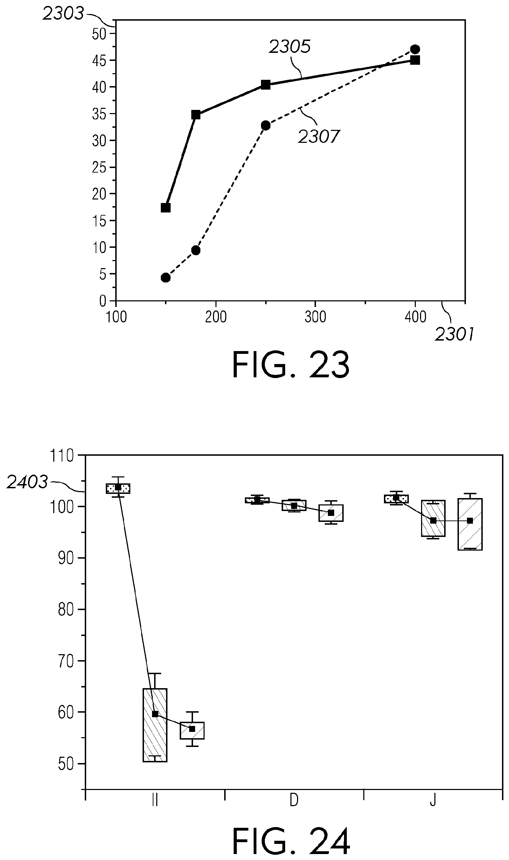

FIGS. 22 and 24 and Table 4 present results of the Steel Wool Abrasion Test for Examples D-E, G-H, and J as well as Comparative Examples EE and HH-II. The vertical axis 2203 or 2403 (i.e., y-axis) is the water contact angle in degrees. For Comparative Example EE, the contact angle decreased by from about 21° from as-formed to 3,500 cycles while the contact angle decreased by more than 40° for Comparative Examples HH and II. As discussed above, Examples D-E, G-H, and J are hydrophobic as-formed. After 2,500 cycles and after 3,500 cycles Examples D and J is still hydrophobic. In fact, the water contact angle for Example D only decreased by from 3° to 5° (compared to more than 40° for Comparative Examples HH and II or 21° for Comparative Example EE) after 3,500 cycles, which demonstrates that Examples D and J have good abrasion resistance and can maintain a high water contact angle after abrasion.

Table 4: Results of Steel Wool Abrasion Test

| Ex | Initial Coating | Silane | WCA (as-formed) | Abraded WCA (2,000 cycles) | Abraded WCA (3,500 cycles) |
|---|---|---|---|---|---|
| D | High OH | 18TMS | 102° | 100° | 99° |
| E | High OH | i8TMS | 92° | 73° | 67° |
| G | Low OH | 18TMS | 91° | 65° | 64° |
| H | Low OH | i8TMS | 96° | 69° | 72° |
| J | PHPS | 18TMS | 102° | 97° | 97° |
| EE | High OH | POTS | 109° | 89° | 88° |
| HH | Low OH | POTS | 104° | 69° | 61° |
| II | n/a | 18TMS | 104° | 60° | 57° |

**FIG. 23** illustrates the elastic modulus obtained for heating a solution of perhydropolysilazane (a polysilazane) was spin coated on a glass-based substrate comprising Composition 1 at 1,000 revolutions per minute (rpm) for 30 seconds before being heated at various temperatures for 30 minutes. The horizontal axis **2301** (i.e., x-axis) is the curing temperature in °C, and the vertical axis **2303** (i.e., y-axis) is the elastic modulus in GPa. For curve **2305,** the solution of perhydropolysilazane contained a catalyst (Durazane 2850 available from Merck). For curve 2307, the solution of perhydropolysilazane did not contain a catalyst (Durazane 2250 available from Merck). As shown, curve **2305** obtains an elastic modulus of more than 15 GPa at temperatures of about 175°C or more, and curve obtains an elastic modulus less than about 40 GPa at temperatures of about 250°C or less. As shown, curve **2307** obtains an elastic modulus of about 9 GPa or more at temperatures of about 175°C or more, and curve **2307** obtains an elastic modulus of less than about 40 GPa for temperatures less than 400°C (e.g., about 350°C or less). At lower cure temperatures, the catalyzed polysilazane coating exhibits a much higher elastic modulus compared to the uncatalyzed polysilazane material, suggesting that the catalyzed material is cured to a greater degree than the uncatalyzed material. At higher cure temperatures (e.g., 400°C), the difference in elastic modulus between the uncatalyzed material and the catalyzed material is minimal, suggesting that the catalyst is less effective and/or not necessary to accelerate curing at these higher temperatures. For the catalyzed polysilazane, the refractive index after being heated at 175°C was about 1.44, which increases to 1.45 after being heated at 400°C. For the uncatalyzed polysilazane, the refractive index after being heated at 175°C was about 1.505 and decreased to about 1.435 after being heated at 400°C.

In Example J, a precursor solution comprising 3% by volume (%v/v) perhydropolysilazane (PHPS) without catalyst in dibutyl ether (Durazane 2250) was spin coated on a glass-based substrate comprising Composition 2 at 1,000 rpm for 30 seconds before being heated at 250°C for 30 minutes to form an initial coating. The PHPS films of example J were functionalized with 18TS applied via dip coating in a solution of 2 vol% of 18TMS was added to toluene. The samples were immersed in this solution for 30 min. Following this the samples were transferred to an oven set at 150°C for 30 min. If necessary, the samples were wiped with a toluene soaked wipe to remove visible haze. As shown in Table 3, the resulting coating has a water contact angle (as-formed) of 103°, a hexadecane contact angle of 17°, and a diiodomethane contact angle of 65°. Example J was hydrophobic and oleophilic. Example J had a total surface energy of 28.6 mN/m, a dispersive surface energy of 26. 1 mN/m, and a polar surface energy of 2.6 mN/m. As shown in Table 4 and **FIG. 24,** Example J maintains a hydrophobic surface with a water contact angle of 97° after 2,000 cycles and 3,500 cycles in the Steel Wool Abrasion Test with only a 5° decrease in water contact angle as a result of the Steel Wool Abrasion Test.

A precursor solution comprising 1% by volume (%v/v) of hydrogen POSS was spin-coated on a glass-based substrate comprising Composition 2 at 1200 rpm for 30 seconds before being heated at 400°C or at 600°C for 30 minutes. When heated at 400°C, the cured hydrogen POSS coating had an elastic modulus of about 9.4 GPa. When heated at 600°C, the cured hydrogen POSS coating had an elastic modulus of about 56.5 GPa. It is predicted that improved abrasion resistance can be obtained for curing hydrogen POSS-containing solutions at temperatures from about 400°C to about 530°C. Further, it is expected that this will also apply to solutions containing hydrogen POSS and one or more of the silanes discussed above.

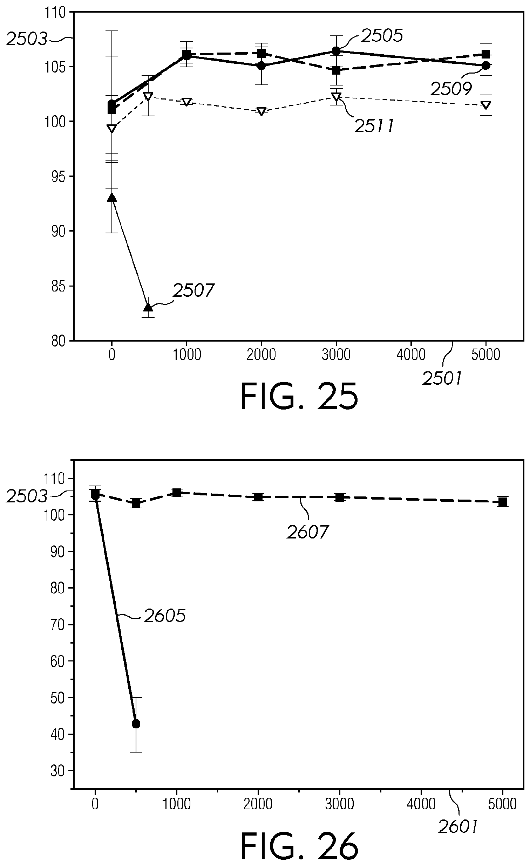

**FIG. 25** schematically illustrates water contact angles in a Rubber Abrasion Test for Examples K-N. Example K comprised a layer formed from 18TMS (octadecyltrimethoxysilane) (25 $\mu$L of 18TMS and the glass-based substrate was heated at 170°C for 5 hours) disposed directly on the glass-based substrate (Composition 2). Example L comprised a layer formed from 18TMS (octadecyltrimethoxysilane) (25 $\mu$L of 18TMS and the article was heated at 170°C for 5 hours) disposed on the optical stack shown in Table 5 that was, in turn, disposed on the glass-based substrate (Composition 2). Table 5 shows the composition of the optical stack in Examples L and N (corresponding to the order that the layers are deposited - meaning that the first row is the closest to the glass-based substrate and the last row is the furthest from the glass-based substrate). In Table 5, the substrate (i.e., glass-based substrate) and air are shown to help orient the optical stack, but the substrate and air are not actually elements of the optical stack. In Table 5, "SiON" refers to silicon oxynitride (i.e., $SiO_xN_y$ with non-zero amounts of both silicon and oxygen - x > 0, y > O - and x + y is less than or equal to 1), and "$SiN_x$" refers to silicon nitride, which can have a non-stoichiometric (i.e., other than $Si_3N_4$) ratio of the constituent atoms. Example M comprised the material of Example D (formed by evaporating OV-POSS at 0.78 A/s while impinging an oxygen ion beam generated by an end-Hall source (KRI EH-400) operated at 100 V with a discharged current of 0.25 and a chamber pressure of $5.3 \times 10^{-5}$ Pa of oxygen ($O_2$) gas (maintained with a flow of 3 sccm $O_2$); followed by heating 25 $\mu$L of 18TMS and the article at 170°C for 5 hours) disposed directly on the glass-based substrate (Composition 2). Example N comprised the material of Example D (formed by evaporating OV-POSS at 0.78 A/s while impinging an oxygen ion beam generated by an end-Hall source (KRI EH-400) operated at 100 V with a discharged current of 0.25 and a chamber pressure of $5.3 \times 10^{-5}$ Pa of oxygen ($O_2$) gas (maintained with a flow of 3 sccm $O_2$); followed by heating 25 $\mu$L of 18TMS and the article at 170°C for 5 hours) disposed on the optical stack shown in Table 5 that was, in turn, disposed on the glass-based substrate (Composition 2).

Table 5: Composition of Optical Stack for Examples L and N

| Material | Refractive Index | Thickness (nm) |
|---|---|---|
| (substrate) | 1.50 | |
| $SiO_2$ | 1.48 | 20.0 |
| SiON | 1.94 | 8.0 |
| $SiO_2$ | 1.48 | 64.0 |
| SiON | 1.94 | 20.0 |
| $SiO_2$ | 1.48 | 49.2 |
| SiON | 1.94 | 35.9 |
| $SiO_2$ | 1.48 | 26.4 |
| SiON | 1.94 | 50.6 |
| $SiO_2$ | 1.48 | 8.0 |
| SiON | 1.94 | 1500. |
| $SiO_2$ | 1.48 | 16.0 |
| $SiN_x$ | 2.01 | 39.4 |
| $SiO_2$ | 1.48 | 50.4 |
| $SiN_x$ | 2.01 | 25.2 |
| $SiO_2$ | 1.48 | 85.6 |
| $SiN_x$ | 2.01 | 26.0 |
| $SiO_2$ | 1.48 | 45.1 |
| $SiN_x$ | 2.01 | 154.4 |
| $SiO_2$ | 1.48 | 101.5 |

(continued)

| Material | Refractive Index | Thickness (nm) |
|----------|------------------|----------------|
| (air) | 1.00 | |

In **FIG. 25,** the horizontal axis **2501** (i.e., x-axis) corresponds to the number of cycles in the Rubber Abrasion Test (defined above) while the vertical axis **2503** (i.e., y-axis) corresponds to the water contact angle. Curve **2507** corresponds to Example L, which had an as-formed water contact angle of about 93° and a water contact angle of less than 85°C after only 500 cycles. In contrast, curves **2505, 2509, and 2511** (corresponding to Examples K, M, and N, respectively) maintained water contact angles of about 100° or more over the 5,000 cycles tested in the Rubber Abrasion Test. Further, Examples K and N maintained water contact angles of about 105° over the 5,000 cycles tested in the Rubber Abrasion Test.

**FIG. 26** schematically illustrates water contact angles in Steel Wool Abrasion Test for Examples K and M. In **FIG. 26,** the horizontal axis **2601** (i.e., x-axis) corresponds to the number of cycles in the Steel Wool Abrasion Test (defined above) while the vertical axis **2503** (i.e., y-axis) corresponds to the water contact angle. Curve **2605** corresponds to Example K, which shows that the surface-modifying layer (e.g., anti-fingerprint coating) did not withstand 500 cycles in the Steel Wool Abrasion Test (having a water contact angle less than 80°). In contrast, Example M (curve **2607)** maintained a water contact angle of 100° or more (e.g., about 105°) for at least 2,000 cycles, at least 3,000 cycles, at least 3,500 cycles, and for all 5,000 cycles tested in the Steel Wool Abrasion Test.

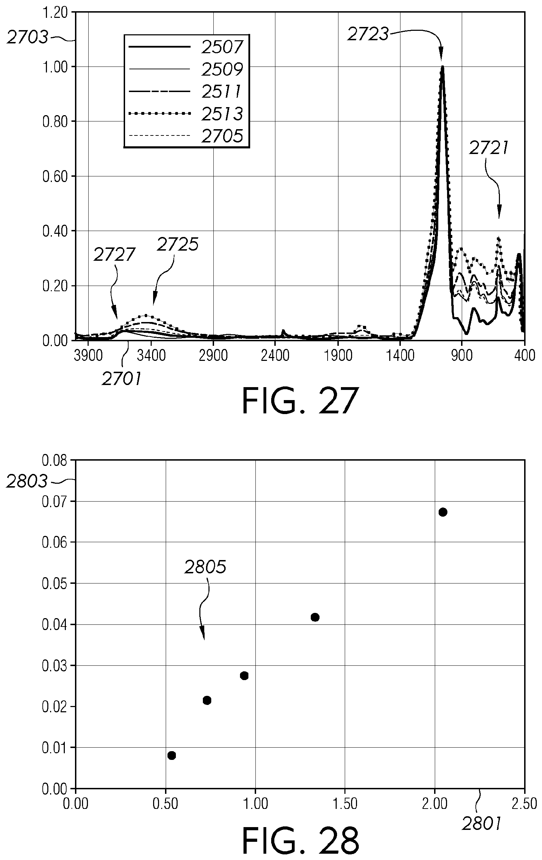

**FIG. 27** presents infrared (IR) spectroscopy of Examples O-S. Examples O-S were formed on a silicon substrate by thermally evaporating octa-isobutyl POSS (OB-POSS) from a Radak II cell and impinging the evaporated OB-POSS it with an ion beam formed from an end-Hall source (KRI 400 from Kaufman & Robinson) operated at a voltage of 60 V and a discharge current of 0.25 amps (A); the chamber pressure was about 6.7 x 10$^{-3}$ Pa (5 x 10$^{-5}$ Torr) of oxygen (O$_2$) gas (maintained with a flow of 6.6 sccm O$_2$). As used in this section, the "deposition rate" is measured by QCM positioned 500 nm above the Radak II cell and 150 nm below the surface. Examples O-S had different deposition rates, namely, 0.5 A/s, 0.7 A/s, 0.9 A/s, 1.3 A/s, and 2.0 A/s, respectively.

IR spectroscopy was measured using a Nicolet iS50 FTIR Spectrometer (Thermo Scientific) with a DTGS (deuterated triglycine sulfate) detector element, where the absorbance was measured with 4 wavenumber (cm$^{-1}$) resolution and averaged from 256 individual scans. In **FIG. 27,** the horizontal axis **2701** (i.e., x-axis) corresponds to wavenumber (cm$^{-1}$) and the vertical axis **2703** (i.e., y-axis) corresponds to a normalized absorbance. Curve **2705** correspond to the absorbance of Example O and a deposition rate of 0.5 A/s; curves **2707** correspond to the absorbance of Example P and a deposition rate of 0.7 A/s; curves **2709** correspond to the absorbance of Example Q and a deposition rate of 0.9 A/s; curves **2711** correspond to the absorbance of Example R and a deposition rate of 1.3 A/s; and curves **2713** correspond to the absorbance of Example S and a deposition rate of 2.0 A/s.

**FIG. 27** presents the entire wavenumber range measured from 400 cm$^{-1}$ to 4000 cm$^{-1}$. A broad absorbance **2723** is seen at 1059 cm$^{-1}$, which is attributed to an Si-O-Si structure. Modeling (based on the model of Devine, J. Non. Cryst. Sol. 152(1993): 50-58) suggests that the peak corresponds to a bond angle of 136° for Si-O-Si with a fictive temperature of about 5300K. This corresponds to a highly strained non-equilibrium structure in the surface-modifying layers of Examples O-S. The fictive temperature calculated here is higher than what is typically seen for sputtered silica films. Also, curves **2705, 2707, 2709, 2711, and 2713** differ in the absorbance from about 800 cm$^{-1}$ to about 980 cm$^{-1}$ (absorbance range **2721),** which is attributed to C-H stretches from the organic functional group on the functionalized POSS. As the deposition rate increased from Example P to Example S (from curve **2707** to curve **2713),** the amount of residual organic material appears to increase.

Also, an OH stretch associated with free water is seen as an absorbance **2727** around 3550 cm$^{-1}$ for curves. The free water absorption increases with increased deposition rate (e.g., from curve **2705** to curve **2713).** Although not shown, it was observed that the free water absorption largely disappeared for Example S (2.0 A/s) after vacuum annealing for 1 hour at 200°C. Additionally, a hydroxyl (OH) stretch associated with alcohols (e.g., silanols - Si-O-H) is seen as a broad absorbance **2725** from about 3200 cm$^{-1}$ to about 3500 cm$^{-1}$. The amplitude of the broad absorbance **2725** (associated with hydroxyls) also increases with increased deposition rate (e.g., from curve **2705** to curve **2713).**

**FIG. 28** presents a relationship between deposition rate and a "hydroxyl ratio", which is a peak absorbance of the broad hydroxyl signal (centered around 3420 cm$^{-1}$) divided by a peak absorbance of the Si-O-Si signal (centered at about 1060 cm$^{-1}$), for Examples O-S. As shown in **FIG. 27,** the peak of the Si-O-Si absorbance is much stronger than the hydroxyl absorbance. In **FIG. 28,** the horizonal axis **2801** correspond to the deposition rate (as measured by QCM) in A/s, and the vertical axis **2803** (i.e., y-axis) is the value of the "hydroxyl ratio" defined above. Points **2805** (circles) correspond to the hydroxyl ratio for Examples O-S. As shown, the hydroxyl ratio increases as deposition rate increases (going from Example O to Example S). Examples O-S have a hydroxyl ratio of from 0.005 to 0.07. Examples OR have a hydroxyl ratio from 0.005 to 0.06 (e.g., from 0.008 to 0.05 or from 0.01 to 0.045). Although not shown, a hydroxyl ratio for a reactively sputtered silica layer is much lower than the hydroxyl ratios shown in **FIG. 28.** For example, the hydroxyl ratio of the surface-modifying layer (e.g., Examples O-S) is greater than the hydroxyl ratio of a reactively sputtered silica layer by a multiple of from 2 to 20 (e.g., from 3 to 10 or from 3 to 5).

**FIG. 29** presents the molar ratio of hydrogen to silicon in Examples 1-10 and Comparative Examples JJ-KK as measured by SIMS. In **FIG. 29,** the vertical axis **2903** (i.e., y-axis) is the molar ratio of hydrogen to silicon. As discussed above, it is believed that hydrogen is indicative of hydroxyl groups (e.g., silanol, Si-O-H). As discussed above, D-SIMS was conducted using a time-of-flight secondary ion mass spectrometer (ToF-SIMS) with a dual beam configuration. Unless otherwise indicated, the TOF-SIMS used for the results reported herein was a TOF-SIMS M6 instrument (available from IONTOF GmbH) equipped with a Nanoprobe50 bismuth source. The TOF-SIMS M6 instrument was operated with a dual-beam configuration, where the analysis beam was a 30 kilo-electronVolts (keV) $Bi_3^+$ beam with a current of about 0.1 pA and the sputter beam was 2 keV $Cs^+$ with a current of about 120 nA. The sputter beam was configured form a 300 $\mu$m by 300 $\mu$m sputter "crater," and the analysis beam was configured to impinge a 75 $\mu$m by 75 $\mu$m area centered in the sputter "crater." Charge compensation was achieved using an electron flood gun operating with 20 nA beam current, 20 eV electron energy, and a 1.5 mm spot size focused on the location impinged by the analysis beam. The chamber evacuated to a pressure of $5 \times 10^{-7}$ Pascals ($5 \times 10^{-9}$ millibar) before being brought to and maintained at a pressure of $5 \times 10^{-5}$ Pascals ($5 \times 10^{-7}$ millibar) using argon (e.g., 99.99999% purity). Data was collected in negative ion mode with the analyzer in the "all purpose" mode, an analyzer energy of 3000 V and a cycle time of 100 microseconds. Data was processed using Surface Lab software (version 7.3.125519 available from IONTOF GmbH). To obtain molar ratios from $^{16}O^1H^-$, $^{18}O^-$, and $^{28}Si^-$ signals, the known isotope ratio between $^{18}O^-$ and $^{17}O^-$ was used to calculate and subtract the $^{17}O^-$ interference from the $^{16}O^1H^-$ signal. A normalized intensity was defined as the mass-interference-corrected $^{16}O^1H$ signal divided by the $^{28}Si^-$ signal. The initial $^{16}O^1H^-/^{28}Si^-$ ratio was further corrected to remove background signals (as determined from the normalized intensity ($^{16}O^1H^-/^{28}Si^-$) from contemporaneously measured from GE Type 124 fused quartz) to determine a "corrected signal." The normalized intensity ($^{16}O^1H^-/^{28}Si^-$) was converted to a hydrogen to silicon molar ratio ("molar ratio") using a calibration curve (derived from a series of natural mid-ocean-ridge basaltic (MORB) glasses with known -OH concentrations and other silica and silicate minerals covering a range from 0.0 wt% to 1.98 wt%) with an equation of "molar ratio" = 1.26 * "corrected signal" - 0.025.

The deposition conditions for Examples 1-10 and Comparative Examples JJ-KK are shown in Table 6. As used in this section for Examples 1-10, the ion-assisted deposition (IAD) process included thermal evaporation of functionalized POSS using a Radak II cell in an Angstrom Engineering Evovac chamber; an ion beam formed from an end-Hall source (KRI 400 from Kaufman & Robinson) operated at a voltage of 60 V and a discharge current of 0.25 amps (A); the chamber pressure was about $6.7 \times 10^{-3}$ Pa ($5 \times 10^{-5}$ Torr) of oxygen ($O_2$) gas (maintained with a flow of 6.6 sccm $O_2$); and the "deposition rate" is measured by QCM positioned 500 nm above the Radak II cell and 150 nm below the surface. Example 1 was formed by spin coating a of 1% by volume (%v/v) solution of hydrogen POSS (i.e., POSS with R=H in FIG. 5) (HSQ) on the glass-based substrate at 1,200 rpm for 30 seconds before being heated at 400°C for 30 minutes. Example 2 was formed by spin coating a 3% by volume (%v/v) solution of perhydropolysilazane (PHPS - see FIG. 6) without catalyst in dibutyl ether (Durazane 2250) on the glass-based substrate at 1,000 rpm for 30 seconds before being heated at 250°C for 30 minutes. Examples 3-7 used octa-isobutyl-functionalized POSS (OBPOSS) (i.e., POSS with R=iso-butyl in FIG. 5) in the IAD process (described above) with the deposition rates from 0.5 A/s to 2.0 A/s stated in Table 9. Examples 8-10 used octa-vinyl POSS (OVPOSS)((i.e., POSS with R=vinyl in **FIG.** 5) in the IAD process (described above) to achieve a thickness from 50 nm to 200 nm as shown in Table 6. Comparative Example JJ was formed by plasma-enhanced chemical vapor deposition (PECVD). Comparative Example KK was formed by reactive sputtering using an Evovac sputter tool (Angstrom Engineering) impinging a p-type silicon target with 525 Watt pulses with a pulse length of 40 microseconds ($\mu$s) and repetition rate of 50 kiloHertz (kHz) in vacuum chamber with a pressure of 0.27 Pa (0.002 Torr) maintained by 40 sccm Ar and 10 sccm O2, which achieved a deposition rate of 2.5 A/s at 23°C.

Table 6: Deposition Conditions for Examples 35-44 and Comparative Examples JJ-KK

| Example | Material | Method | Molar Ratio (H/Si) |
|---|---|---|---|
| 1 | HSQ | Spin Coating | 0.21 |
| 2 | PHPS | Spin Coating | 0.23 |
| 3 | OBPOSS | IAD: 0.5 A/s | 0.24 |
| 4 | OBPOSS | IAD: 0.7 A/s | 0.28 |
| 5 | OBPOSS | IAD 0.9 A/s | 0.26 |
| 6 | OBPOSS | IAD: 1.3 A/s | 0.31 |
| 7 | OBPOSS | IAD 2.0 A/s | 0.52 |

(continued)

| Example | Material | Method | Molar Ratio (H/Si) |
|---------|----------|--------|---------------------|
| 8 | OVPOSS | IAD: 50 nm | 0.30 |
| 9 | OVPOSS | IAD: 100 nm | 0.28 |
| 10 | OVPOSS | IAD: 200 nm | 0.28 |
| JJ | Silica | PECVD | 0.10 |
| KK | Silica | Reactive Sputtering | 0.09 |

Dashed line **2905** corresponds to a molar ratio of hydrogen to silicon of 0.20. As shown in **FIG. 29,** Comparative Examples JJ-KK have molar ratios of hydrogen to silicon of about 0.10 (about half of dashed line **2905**). As shown in **FIG. 29,** Examples 1-10 all have molar ratios of 0.2 or more. Consequently, Examples 1-10 have at least about double (2x) the molar ratio of Comparative Examples JJ-KK. Increasing the deposition rate for OBPSS (Examples 3-7) generally increases the molar ratio. However, increasing the thickness formed by OVPSS IAD from 50 nm to 200 nm (Examples 8-10) slightly decreases or does not substantially change the molar ratio. Also, Examples 2-6 and 8-10 have a molar ratio from 0.2 to 0.4 or from 0.22 to 0.35.

**FIG. 30** presents the water contact angles before and after 100,000 to 400,000 abrasion cycles in the Cheesecloth Abrasion Test for Examples 11-12. Examples 11-12 comprised the optical stack shown in Table 7 (corresponding to the order that the layers are deposited - meaning that the first row is the closest to the glass-based substrate and the last row is the furthest from the glass-based substrate). For Example 11, the surface-modifying layer was formed by disposing 18TMS directly on the optical stack (25 μL of a silane disposed away from the sample; after the lid was secured, it was heated at 170°C for 5 hours). For Example 12, the surface-modifying layer was formed using octa-iso-butyl-functionalized POSS (OBPOSS) (i.e., POSS with R=iso-butyl in **FIG. 5**) in the IAD process (described above) at a deposition rate of 0.9 A/s followed by disposing 18TMS thereon (25 μL of a silane disposed away from the sample; after the lid was secured, it was heated at 170°C for 5 hours).

Table 7: Composition of Optical Stack for Examples 11-12

| Material | Refractive Index | Thickness (nm) |
|----------|------------------|----------------|
| (substrate) | 1.50 | |
| $SiO_2$ | 1.48 | 25.0 |
| $Nb_2O_5$ | 2.36 | 12.4 |
| $SiO_2$ | 1.48 | 40.4 |
| $Nb_2O_5$ | 2.36 | 116.0 |
| $SiO_2$ | 1.48 | 83.8 |
| (air) | 1.00 | |

In **FIG. 30,** the vertical axis **3003** (i.e., y-axis) corresponds to the water contact angle in degrees. Points **3005** correspond to the water contact angles of Example 11 with line **3017** showing the trend from as-formed (0 cycles), 100,000 cycles, and 200,000 cycles (going from left to right). As shown, the water contact angle decreases to less than 90° (e.g., about 75°) after 100,000 and further decreases to less than 75° after 200,000 cycles. Points **3015** correspond to the water contact angles of Example 12 with line **3017** showing the trend from as-formed (0 cycles) to 400,000 cycles (with points corresponding to water contact angles after every 100,000 cycles). As shown, points **3015** (Example 12) maintain a water contact angle greater than 90°, greater than 95°, greater than 98°, greater than 100°, and greater than 105° (e.g., about 110° or more) for all cycles measured (e.g., after 100,000 cycles, after 200,000 cycles, after 300,000 cycles, and after 400,000 cycles). The difference between the initial water contact angle and the braded contact angle (e.g., after 200,000 cycles) is less than 10° (e.g., about 5° or less).

The above observations can be combined to provide surface-modifying layers (e.g., anti-fingerprint layers) or coated articles including the same that can reduce a visibility and/or color shift associated with disposing a fingerprint thereon. Providing a low total surface energy (including a low dispersive surface energy and/or a low polar surface energy) of the surface-modifying layer (e.g., anti-fingerprint coating) can enable oils (e.g., fingerprint oil) to be dispersed across the anti-fingerprint surface (e.g., oleophilic), which can decrease a visibility and/or a color shift associated with fingerprints. For example, providing an alkyl silane can reduce a surface energy (e.g., total, dispersive, polar) of the surface-modifying layer (e.g., anti-fingerprint coating), which can enable the surface-modifying layer (e.g., anti-fingerprint coating) to be oleophilic. Providing a low hexadecane contact angle (e.g., about 30° or less) and/or a low diiodomethane contact angle (e.g., about 60° or less) can reduce the visibility and/or color shift associated with fingerprints by enabling fingerprint oil to be dispersed across the surface-modifying (e.g., anti-fingerprint coating) rather than beading up into pronounced droplets. Providing a high water contact angle (e.g., about 100° or more) can enhance the removal of aqueous material (e.g., water droplets, sweat droplets) from the surface-modifying (e.g., anti-fingerprint coating). Consequently, the surface-modifying (e.g., anti-fingerprint coating) can be hydrophobic and oleophilic.

Providing a surface-modifying layer (e.g., an anti-fingerprint coating) in accordance with the aspects of the disclosure can exhibit good abrasion resistance (e.g., an abraded water contact angle of about 90° or more after 2,000 cycles, 3,000 cycles, and/or 3,500 cycles in a Steel Wool Abrasion Test, a cheesecloth-abraded water contact angle of about 90° after 200,000 cycles in a Cheesecloth Abrasion Test), for example, maintaining a hydrophobic and/or oleophilic character. The surface-modifying layer (e.g., anti-fingerprint coating) can exhibit good adhesion to the surface that is disposed on, for example, a surface of a substrate or an optical stack. Providing a thickness of the surface-modifying layer (e.g., anti-fingerprint coating) from about 100 nm to 600 nm or from 1 nm to 75 nm can increase a durability of the surface-modifying layer (e.g., anti-fingerprint coating).

In aspects, forming the surface-modifying layer (e.g., anti-fingerprint coating) can comprise evaporating a functionalized POSS onto a substrate and impinging the substrate with an ion beam. Properties of the coating can be controlled by the discharge current of the ion beam. For a KRI EH-400 End-Hall ion source in a Angstrom Evovac chamber operating at 100V, providing a discharge current of about 0.25 A or more can facilitate the formation of the coating, for example, producing an ion beam with sufficient energy to cause the functionalized POSS to react with other functionalized POSS and/or the first major surface of the substrate at an appreciable rate (e.g., compared to lower discharge currents). Providing a discharge current of about 1 A or less to the ion beam source facilitates deposition of a condensed POSS material. The ion beam discharge can facilitate condensation of the functionalized POSS converting at least a portion of the cage structure of the functionalized POSS to a partial Si-O-Si network. Functionalized POSS is evaporated and subjected to ion beam to create partially condensed silica-like network at or near room temperature. Alternatively, the substrate that the thermally evaporated functionalized POSS condenses on and the ion beam impinges can be heated. Substrate temperature during POSS deposition is 250°C or less, 200°C or less, 100°C or less, or preferably 50°C or less. Alternatively, the partially condensed structure could be heated 400°C to 700°C to create a dense, high modulus silica-like network, but that would lead to poor abrasion performance. Consequently, providing a maximum temperature (e.g., through the evaporating of the functionalized POSS, impingement with the ion-beam, and subsequent functionalization with a silane) of about 250°C or less (e.g., about 220°C or less, about 200°C or less, about 180°C or less, or about 160°C or less) to obtain the surface-modifying layer (e.g., anti-fingerprint coating) with good abrasion resistance.

The surface-modifying layer (e.g., anti-fingerprint coating) can be formed by treating the partially condensed silica-like network with an alkyl silane, which can be done in-situ (i.e., in the same chamber as the POSS deposition) or in a second chamber. The partially condensed silica-like network can be exposed to vapors of the alkyl silane at elevated temperature (e.g., from about 100°C to about 200°C). Before treatment with the silane (e.g., alkyl silane), the partially condensed silica-like network can optionally be subjected to plasma activation of the surface in an O2, air, or Ar plasma. Silane evaporation can be at atmospheric pressure or under reduced pressure. Alternatively, the silane can be applied to the partially condensed silica-like network as a solution (e.g., dip coating). Plasma activation can be performed at atmospheric pressure or under reduced pressure. Reacting an initial coating with a methoxy silane, a chlorosilane, a trialkoxy silane, a trichlorosilane, or combinations thereof (e.g., dichloromethyoxy silane, chlorodithmethoxy silane) silane can ensure that the silane is well-bonded to the initial coating and enable low surface energy (e.g., total surface energy or about 30 mN/m or less, polar surface energy of about 5 mN/m or less).

As discussed above in the Examples, it has been discovered that surface-modifying layers (e.g., anti-fingerprint coatings) in accordance with the present disclosure having an elastic modulus from about 9 GPa to about 41 GPa possess unexpectedly improved abrasion resistance. Providing a partial silica-like network can enable the surface-modifying layer (e.g., anti-fingerprint coating) to be stiff (e.g., elastic modulus of about 9 GPa or more) while remaining flexible enough to withstand abrasion. Also, as demonstrated by the results of the Steel Wool Abrasion Test, the Rubber Abrasion Test, and the Cheesecloth Abrasion Test, the surface-modifying layer (e.g., anti-fingerprint coatings) of the present disclosure can withstand abrasion and maintain good contact angles. Providing a fluorine-free surface-modifying layer (e.g., fluorine-free anti-fingerprint coating) can be cheaper to produce and/or more environmentally friendly.

The substrate can comprise a glass-based, a a glass-ceramic, and/or ceramic-based material, which can provide good dimensional stability, good impact resistance, and/or good puncture resistance. The glass-based, glass-ceramic, and/or ceramic-based substrate can comprise one or more compressive stress regions, which can further provide increased impact resistance and/or increased puncture resistance.

Directional terms as used herein-for example, up, down, right, left, front, back, top, bottom-are made only with reference to the figures as drawn and are not intended to imply absolute orientation.

It will be appreciated that the various disclosed aspects may involve features, elements, or steps that are described in connection with that aspect. It will also be appreciated that a feature, element, or step, although described in relation to one aspect, may be interchanged or combined with alternate aspects in various non-illustrated combinations or permutations.

It is also to be understood that, as used herein, the terms "the," "a," or "an," mean "at least one," and should not be limited to "only one" unless explicitly indicated to the contrary. For example, reference to "a component" comprises aspects having two or more such components unless the context clearly indicates otherwise. Likewise, a "plurality" is intended to denote "more than one."

As used herein, the term "about" means that amounts, sizes, formulations, parameters, and other quantities and characteristics are not and need not be exact, but may be approximate and/or larger or smaller, as desired, reflecting tolerances, conversion factors, rounding off, measurement error and the like, and other factors known to those of skill in the art. Ranges can be expressed herein as from "about" one particular value, and/or to "about" another particular value. When such a range is expressed, aspects include from the one particular value and/or to the other particular value. Similarly, when values are expressed as approximations, by use of the antecedent "about," it will be understood that the particular value forms another aspect. Whether or not a numerical value or endpoint of a range in the specification recites "about," the numerical value or endpoint of a range is intended to include two aspects: one modified by "about," and one not modified by "about." It will be further understood that the endpoints of each of the ranges are significant both in relation to the other endpoint and independently of the other endpoint.

The terms "substantial," "substantially," and variations thereof, as used herein, are intended to note that a described feature is equal or approximately equal to a value or description. For example, a "substantially planar" surface is intended to denote a surface that is planar or approximately planar. Moreover, as defined above, "substantially similar" is intended to denote that two values are equal or approximately equal. In aspects, "substantially similar" may denote values within about 10% of each other, for example, within about 5% of each other, or within about 2% of each other.

Unless otherwise expressly stated, it is in no way intended that any method set forth herein be construed as requiring that its steps be performed in a specific order. Accordingly, where a method claim does not actually recite an order to be followed by its steps or it is not otherwise specifically stated in the claims or descriptions that the steps are to be limited to a specific order, it is in no way intended that any particular order be inferred.

While various features, elements, or steps of particular aspects may be disclosed using the transitional phrase "comprising," it is to be understood that alternative aspects, including those that may be described using the transitional phrases "consisting of" or "consisting essentially of," are implied. Thus, for example, implied alternative aspects to an apparatus that comprises A+B+C include aspects where an apparatus consists of A+B+C and aspects where an apparatus consists essentially of A+B+C. As used herein, the terms "comprising" and "including", and variations thereof shall be construed as synonymous and open-ended unless otherwise indicated.

The above aspects, and the features of those aspects, are exemplary and can be provided alone or in any combination with any one or more features of other aspects provided herein without departing from the scope of the disclosure. That is, it will be appreciated that the various disclosed embodiments may involve particular features or elements that are described in connection with that particular embodiment. It will also be appreciated that a particular feature or element although described in relation to one particular embodiment, may be interchanged or combined with alternate embodiments in various non-illustrated combinations or permutations.

It will be apparent to those skilled in the art that various modifications and variations can be made to the present disclosure without departing from the spirit and scope of the disclosure. Thus, it is intended that the present disclosure cover the modifications and variations of the aspects herein provided they come within the scope of the appended claims and their equivalents.

Embodiments of the present invention may be defined as follows:

[1] A coated article comprising:

a substrate comprising a first major surface;
an anti-fingerprint coating disposed on the first major surface, the anti-fingerprint coating comprising an exterior surface of the coated article, the anti-fingerprint coating comprising a thickness from about 10 nanometers to about 600 nanometers, the anti-fingerprint coating comprises a partial silica-like network having a ratio of Si-O-Si bonds to Si atoms in the anti-fingerprint coating is from about 2 to about 3, the anti-fingerprint coating is fluorine-free, and the anti-fingerprint coating further comprises an alkyl silane at the exterior surface and bonded to Si-O groups in the anti-fingerprint coating.

[2] The coated article of [1], wherein the anti-fingerprint coating comprises a refractive index ranging from about 1.38 to about 1.55.

[3] The coated article of any one of [1]-[2], wherein the anti-fingerprint coating comprises an elastic modulus ranging from about 9 GigaPascals to about 70 GigaPascals.

[4] The coated article of any one of [1]-[3], wherein the alkyl silane comprises a $C_4$-$C_{34}$ alkyl group.

[5] The coated article of any one of [1]-[4], wherein the alkyl silane comprises an iso-octylsilane, a dodecylsilane, an octadecylsilane, or combinations thereof.

[6] The coated article of any one of [1]-[5], wherein the anti-fingerprint coating further comprises nitrogen atoms bonded to silicon atoms.

[7] The coated article of any one of [1]-[6], wherein the anti-fingerprint coating comprises either silicon hydrides or silanols.

[8] The coated article of any one of [1]-[7], wherein the anti-fingerprint coating exhibits a diiodomethane contact angle of about 60° or more.

[9] The coated article of any one of [1]-[8], wherein the anti-fingerprint coating exhibits a water contact angle of about 100° or more.

[10] The coated article of any one of [1]-[9], wherein the anti-fingerprint coating wets hexadecane or exhibits a hexadecane contact angle of about 30° or less.

[11] The coated article of any one of [1]-[10], wherein the anti-fingerprint coating comprises a polar surface energy of about 3 milliNewtons per meter (mN/m) or less.

[12] The coated article of any one of [1]-[11], wherein the anti-fingerprint coating comprises a total surface energy of about 30 milliNewtons per meter (mN/m) or less.

[13] The coated article of any one of [1]-[12], wherein the anti-fingerprint coating exhibits an abraded water contact angle of about 90° after being abraded for 2,000 cycles in a Steel Wool Abrasion Test.

[14] The coated article of any one of [1]-[13], wherein the anti-fingerprint coating exhibits a cheesecloth-abraded water contact angle of about 90° or more after being subjected to 200,000 cycles in a Cheesecloth Abrasion Test.

[15] The coated article of any one of [1]-[14], wherein the anti-fingerprint coating exhibits a rubber abrasion water contact angle of about 100° or more after being subjected to 5,000 cycles in a Rubber Abrasion Test.

[16] The coated article of any one of [1]-[15], further comprising an anti-reflective coating positioned between the anti-fingerprint coating and the substrate.

[17] The coated article of any one of [1]-[15], further comprising a gradient coating comprising a refractive index gradient positioned between the anti-fingerprint coating and the substrate.

[18] The coated article of any one of [1]-[15], further comprising an optical stack positioned between the anti-fingerprint coating and the substrate, wherein the optical stack comprises an anti-reflective coating, a band-pass filter coating, an edge neutral mirror, a beam splitter coating, a multi-layer high-reflectance coating, or an edge filter coating.

[19] The coated article of [18], wherein the optical stack has a thickness from about 10 nanometers to about 10 micrometers.

[20] The coated article of [19], wherein the thickness of the optical stack is from about 50 nanometers to about 5 micrometers.

[21] The coated article of [19], wherein the thickness of the optical stack is from about 50 nanometers to about 500 nanometers.

[22] The coated article of any one of [18]-[21], wherein the optical stack comprises a scratch resistant layer, and wherein the scratch resistant layer has a thickness from 0.05 micrometers to 3 micrometers.

[23] The coated article of any one of [18]-[22], wherein the coated article including the optical stack and the anti-fingerprint coating exhibits a hardness of 8 GigaPascals or greater measured by a Berkovich Indenter Hardness test.

[24] The coated article of [23], wherein the coated article including the optical stack and the anti-fingerprint coating exhibits the hardness of 12 GigaPascals or greater measured by the Berkovich Indenter Hardness test.

[25] The coated article of any one of [18]-[24], wherein the optical stack comprises one or more of a silicon-containing oxide, a silicon-containing nitride, a silicon-containing oxynitride, and $Nb_2O_5$.

[26] The coated article of any one of [18]-[25], wherein the optical stack comprises two or more layers with different refractive indices including at least a first low refractive index (low RI) layer and a second high refractive index (high RI) layer, an absolute value of a difference between the first low RI layer and the second high RI layer is 0.2 or more, and further wherein the optical stack comprises one or more of a silicon-containing oxide, a silicon-containing nitride, a silicon-containing oxynitride, and $Nb_2O$.

[27] The coated article of any one of [1]-[26], wherein the substrate is a textured substrate.

[28] The coated article of [27], wherein the coated article further comprises an anti-reflective coating or a gradient coating positioned between the anti-fingerprint coating and the textured substrate.

[29] The coated article of any one of [1]-[28], wherein the substrate comprises a glass-based material, a glass-ceramic material, or a ceramic-based material.

[30] The coated article according to [29], wherein the glass-based material, the glass-ceramic material, or the ceramic-based material is transparent, colored transparent, opaque, colored opaque, translucent, or colored translucent.

[31] A coated article comprising:

a substrate comprising a first major surface;
an alkyl silane disposed on the first major surface, the alkyl silane comprising an exterior surface of the coated article, the alkyl silane layer comprising a thickness from about 1 nanometer to about 75 nanometers, and the alkyl silane is fluorine-free.

[32] The coated article of [31], wherein the alkyl silane comprises a $C_4$-$C_{34}$ alkyl group.

[33] The coated article of [31], wherein the alkyl silane comprises an octadecyl alkyl group.

[34] The coated article of any one of [31]-[33], wherein the exterior surface exhibits a water contact angle of 100° or more.

[35] The coated article of [34], wherein the exterior surface exhibits the water contact angle from 102° to 110°.

[36] The coated article of any one of [31]-[35], wherein the exterior surface exhibits a diiodomethane contact angle of about 60° or more.

[37] The coated article of any one of [31]-[36], wherein the exterior surface exhibits a coefficient of friction of 0.25 or less.

[38] The coated article of any one of [31]-[37], wherein the alkyl silane comprises a polar surface energy of about 3 milliNewtons per meter (mN/m) or less.

[39] The coated article of any one of [31]-[38], wherein the alkyl silane comprises a total surface energy of about 30 milliNewtons per meter (mN/m) or less.

[40] The coated article of any one of [31]-[39], wherein the alkyl silane comprises a cheesecloth-abraded water contact angle of about 90° or more after being subjected to 200,000 cycles in a Cheesecloth Abrasion Test.

[41] The coated article of any one of [31]-[40], wherein the alkyl silane exhibits a rubber abrasion water contact angle of about 100° or more after being subjected to 5,000 cycles in a Rubber Abrasion Test.

[42] The coated article of any one of [31]-[41], further comprising an optical stack p]ositioned between the alkyl silane and the substrate, wherein the optical stack comprises an anti-reflective coating, a band-pass filter coating, an edge neutral mirror, a beam splitter coating, a multi-layer high-reflectance coating, or an edge filter coating.

[43] The coated article of [42], wherein the optical stack has a thickness from about 10 nanometers to about 10 micrometers.

[44] The coated article of [43], wherein the thickness of the optical stack is from about 50 nanometers to about 5 micrometers.

[45] The coated article of [43], wherein the thickness of the optical stack is from about 50 nanometers to about 500 nanometers.

[46] The coated article of any one of [42]-[45], wherein the optical stack comprises a scratch resistant layer, and wherein the scratch resistant layer has a thickness from 0.05 micrometers to 3 micrometers.

[47] The coated article of any one of [42]-[46], wherein the coated article including the optical stack and the alkyl silane exhibits a hardness of 8 GigaPascals or greater measured by a Berkovich Indenter Hardness test.

[48] The coated article of [47], wherein the coated article including the optical stack and the alkyl silane exhibits the hardness of 12 GigaPascals or greater measured by the Berkovich Indenter Hardness test.

[49] The coated article of any one of [42]-[48], wherein the optical stack comprises one or more of a silicon-containing oxide, a silicon-containing nitride, a silicon-containing oxynitride, and $Nb_2O_5$.

[50] The coated article of any one of [42]-[49], wherein the optical stack comprises two or more layers with different refractive indices including at least a first low refractive index (low RI) layer and a second high refractive index (high RI) layer, an absolute value of a difference between the first low RI layer and the second high RI layer is 0.2 or more, and further wherein the optical stack comprises one or more of a silicon-containing oxide, a silicon-containing nitride, a silicon-containing oxynitride, and $Nb_2O$.

[51] The coated article of any one of [31]-[41], wherein the substrate is a textured substrate.

[52] The coated article of [51], wherein the coated article further comprises an anti-reflective coating or a gradient coating positioned between the anti-fingerprint coating and the textured substrate.

[53] The coated article of any one of [31]-[52], wherein the substrate comprises a glass-based material, a glass-ceramic material, or a ceramic-based material.

[54] The coated article according to [53], wherein the glass-based material, the glass-ceramic material, or the ceramic-based material is transparent, colored transparent, opaque, colored opaque, translucent, or colored translucent.

[55] A method of forming a coated article comprising:

evaporating a functionalized polyhedral oligomeric silsesquioxane onto a first major surface of a substrate;
impinging an ion beam on the first major surface of the substrate, the impinging occurs in a chamber comprising a chamber pressure ranging from about $10^{-4}$ Pascal to about 1 Pascal, and the impinging converts from about 50% to about 90% of the silicon atoms in the functionalized polyhedral oligomeric silsesquioxane from a cage structure to a network of Si-O-Si bonds; and then
reacting material at the first major surface of the substrate with an alkyl silane to form an anti-fingerprint coating, the alkyl silane comprising 4 or more carbons.

[56] The method of [55], wherein the functionalized polyhedral oligomeric silsesquioxane is at least partially functionalized by at least one alkene comprising from 2 to 8 carbons.

[57] The method of [55], wherein the functionalized polyhedral oligomeric silsesquioxane is completely functionalized by alkenes comprising from 2 to 8 carbons.

[58] The method of any one of [56]-[57], wherein the functionalized polyhedral oligomeric silsesquioxane is at least partially functionalized by an alkyl group or an aromatic group.

[59] The method of any one of [55]-[58], wherein the reacting comprises heating the alkyl silane at a temperature of about 80°C to about 250°C for a period of time from about 10 minutes to about 8 hours.

[60] The method of any one of [55]-[58], wherein the alkyl silane comprises an iso-octyl alkyl group, a dodecyl alkyl group, an octadecyl alkyl group, or combinations thereof.

[61] The method of any one of [55]-[60], wherein the silane is a trimethoxysilane, a triethoxysilane, a trichlorosilane, a dichloromethoxy silane, or a chlorodimethoxysilane.

[62] The method of any one of [55]-[61], wherein the evaporating the functionalized polyhedral oligomeric silsesquioxane and the impinging occur simultaneously.

[63] The method of any one of [55]-[62], wherein the evaporating the functionalized polyhedral oligomeric silsesquioxane comprises an evaporation rate from about 0.01 nanometers per second (nm/s) to about 0.2 nm/s.

[64] The method of any one of [55]-[63], wherein the ion beam comprises ions of argon or oxygen.

[65] The method of any one of [55]-[64], wherein a ratio of Si-O-Si bonds to Si atoms is from about 2 to about 3.

[66] The method of any one of [55]-[65], wherein the anti-fingerprint coating comprises a thickness from about 10 nanometers to about 600 nanometers.

[67] The method of any one of [55]-[66], wherein the anti-fingerprint coating comprises a refractive index ranging from about 1.38 to about 1.55.

[68] The method of any one of [55]-[67], wherein the anti-fingerprint coating comprises an elastic modulus ranging from about 9 GigaPascals to about 70 GigaPascals.

[69] The method of any one of [55]-[68], wherein the anti-fingerprint coating comprises a total surface energy of about 30 milliNewtons per meter (mN/m) or less.

[70] The method of any one of [55]-[69], wherein the anti-fingerprint coating comprises a polar surface energy of about 3 milliNewtons per meter (mN/m) or less.

[71] The method of any one of [55]-[70], wherein the anti-fingerprint coating comprises a water contact angle of about 100° or more.

[72] The method of any one of [55]-[71], wherein the anti-fingerprint coating comprises an abraded water contact angle of about 90° after being abraded for 2,000 cycles in a Steel Wool Abrasion Test.

[73] The method of any one of [55]-[72], wherein the anti-fingerprint coating comprises a cheesecloth-abraded water contact angle of about 90° or more after being subjected to 200,000 cycles in a Cheesecloth Abrasion Test.

[74] The coated article of any one of [55]-[73], wherein the anti-fingerprint coating exhibits a rubber abrasion water contact angle of about 100° or more after being subjected to 5,000 cycles in a Rubber Abrasion Test.

[75] The method of any one of [55]-[74], wherein the anti-fingerprint coating comprises a surface roughness Ra of about 1 nm or less.

[76] The method of any one of [55]-[75], wherein the anti-fingerprint coating is fluorine-free.

[77] The method of any one of [55]-[76], further comprising an optical stack positioned between the anti-fingerprint coating and the substrate, wherein the optical stack comprises an anti-reflective coating, a band-pass filter coating, an edge neutral mirror, a beam splitter coating, a multi-layer high-reflectance coating, or an edge filter coating.

[78] The method of [77], wherein the optical stack thickness is from about 10 nanometers to about 10 micrometers.

[79] The method of [77], wherein the optical stack comprises scratch resistant layer, and the scratch resistant layer has a thickness from 0.05 micrometers to 3 micrometers.

[80] The method of any one of [76]-[79], wherein the optical stack comprises one or more of a silicon-containing oxide, a silicon-containing nitride, and/or a silicon-containing oxynitride.

[81] The method of any one of [76]-[80], wherein the optical stack two or more layers with different refractive indices, a first low RI layer and a second high RI layer, wherein the absolute value of a difference between the first low RI layer and the second high RI layer is 0.2 or more, and further wherein the optical stack comprises one or more of a silicon-containing oxide, a silicon-containing nitride, and/or a silicon-containing oxynitride.

[82] The method of any one of [55]-[76], wherein the substrate is a textured substrate.

[83] The method of [82], wherein the coated article further comprises an anti-reflective coating or a gradient coating positioned between the anti-fingerprint coating and the textured substrate.

[84] The method of any one of [55]-[83], wherein the substrate comprises a glass-based material, a glass-ceramic material, or a ceramic-based material.

[85] A method of forming a coated articled comprising:

  disposing a solution over a first major surface of a substrate, the solution comprising a polysilazane or a polyhedral oligomeric silsesquioxane;
  heating the solution at a temperature from about 150°C to about 400°C for a period of time from about 5 minutes to about 120 minutes; and
  reacting material at the first major surface of the substrate with an alkyl silane to form an anti-fingerprint coating, the alkyl silane comprising 4 or more carbons.

[86] The method of [85], wherein a concentration of the polysilazane or the polyhedral oligomeric silsesquioxane ranges from about 0.2 wt% to about 25 wt%.

[87] The method of any one of [85]-[86], wherein the temperature ranges from about 150°C to about 250°C.

[88] The method of any one of [85]-[87], wherein the reacting comprises heating the alkyl silane at a temperature of about 80°C to about 250°C for a period of time from about 10 minutes to about 8 hours.

[89] The method of any one of [85]-[88], wherein the alkyl silane comprises iso-octyltrimethoxysilane, dodecyltrimethoxysilane, octadecyltrimethoxysilane, or combinations thereof.

[90] The method of any one of [85]-[89], wherein the silane is a trimethoxysilane, a triethoxysilane, a trichlorosilane, a dichloromethoxy silane, or a chlorodimethoxysilane.

[91] The method of any one of [85]-[88], wherein the alkyl silane comprises an iso-octyl alkyl group, a dodecyl alkyl group, an octadecyl alkyl group, or combinations thereof.

[92] The method of any one of [85]-[91], wherein the anti-fingerprint coating comprises a diiodomethane contact angle of about 60° or more.

[93] The method of any one of [85]-[92], wherein the anti-fingerprint coating wets hexadecane or comprises a hexadecane contact angle of about 30° or less.

[94] The method of any one of [85]-[93], wherein the heating forms the anti-fingerprint coating as a partial silica-like network and either silicon hydrides or silanols.

[95] The method of any one of [85]-[94], wherein the heating forms the anti-fingerprint coating comprising a ratio of Si-O-Si bonds to Si atoms is from about 2 to about 3.

[96] The method of any one of [85]-[95], wherein the anti-fingerprint coating comprises a thickness from about 10 nanometers to about 600 nanometers.

[97] The method of any one of [85]-[96], wherein the anti-fingerprint coating comprises a refractive index from about 1.38 to about 1.55.

[98] The method of any one of [85]-[97], wherein the anti-fingerprint coating comprises an elastic modulus ranging from about 9 GigaPascals to about 70 GigaPascals.

[99] The method of any one of [85]-[98], wherein the anti-fingerprint coating comprises a total surface energy of about 30 milliNewtons per meter (mN/m) or less.

[100] The method of any one of [85]-[99], wherein the anti-fingerprint coating comprises a polar surface energy of about 3 milliNewtons per meter (mN/m) or less.

[101] The method of any one of [85]-[100], wherein the anti-fingerprint coating comprises a water contact angle of about 100° or more.

[102] The method of any one of [85]-[101], wherein the anti-fingerprint coating comprises an abraded water contact angle of about 90° after being abraded for 2,000 cycles in a Steel Wool Abrasion Test.

[103] The method of any one of [85]-[102] wherein the anti-fingerprint coating comprises a cheesecloth-abraded water contact angle of about 90° or more after being subjected to 200,000 cycles in a Cheesecloth Abrasion Test.

[104] The coated article of any one of [85]-[103], wherein the anti-fingerprint coating exhibits a rubber abrasion water contact angle of about 100° or more after being subjected to 5,000 cycles in a Rubber Abrasion Test.

[105] The method of any one of [85]-[104], wherein the anti-fingerprint coating comprises a surface roughness Ra of about 1 nm or less.

[106] The method of any one of [85]-[105], wherein the anti-fingerprint coating is fluorine-free.

[107] The method of any one of [85]-[106], wherein the substrate comprises a glass-based material, a glass-ceramic material, or a ceramic-based material.

[108] The method of any one of [85]-[107], wherein the anti-fingerprint coating further comprises nitrogen atoms bonded to silicon atoms.

[109] The method of any one of [85]-[108], further comprising an optical stack positioned between the anti-fingerprint coating and the substrate, wherein the optical stack comprises an anti-reflective coating, a band-pass filter coating, an edge neutral mirror, a beam splitter coating, a multi-layer high-reflectance coating, or an edge filter coating.

[110] The method of [109], wherein the optical stack thickness is from about 10 nanometers to about 10 micrometers.

[111] The method of [110], wherein the optical stack comprises scratch resistant layer, and the scratch resistant layer has a thickness from 0.05 micrometers to 3 micrometers.

[112] The method of any one of [109]-[111], wherein the optical stack comprises one or more of a silicon-containing oxide, a silicon-containing nitride, and/or a silicon-containing oxynitride.

[113] The method of any one of [109]-[112], wherein the optical stack two or more layers with different refractive indices, a first low RI layer and a second high RI layer, wherein the absolute value of a difference between the first low RI layer and the second high RI layer is 0.2 or more, and further wherein the optical stack comprises one or more of a silicon-containing oxide, a silicon-containing nitride, and/or a silicon-containing oxynitride.

[114] The method of any one of [85]-[108], wherein the substrate is a textured substrate.

[115] The method of [114], wherein the coated article further comprises an anti-reflective coating or a gradient coating positioned between the anti-fingerprint coating and the textured substrate.

[116] A method of forming a coated article comprising:

reacting material at a first major surface of a substrate with an alkyl silane to form surface-modifying layer, the alkyl silane comprising an alkyl group with 4 or more carbons,
wherein the surface-modifying layer exhibits a water contact angle of 100° or more.

[117] The method of [116], wherein the alkyl group comprises an iso-octyl alkyl group, a dodecyl alkyl group, an octadecyl alkyl group, or combinations thereof.

[118] The method of [116], wherein the alkyl group comprises an octadecyl alkyl group.

[119] The method of any one of [116]-[118], wherein the alkyl silane comprises iso-octyltrimethoxysilane, dodecyltrimethoxysilane, octadecyltrimethoxysilane, or combinations thereof.

[120] The method of any one of [116]-[119], wherein the silane is a trimethoxysilane, a triethoxysilane, a trichlorosilane, a dichloromethoxy silane, or a chlorodimethoxysilane.

[121] The method of any one of [116]-[120], wherein the exterior surface exhibits a water contact angle of 100° or more.

[122] The method of [121], wherein the exterior surface exhibits the water contact angle from 102° to 110°.

[123] The method of any one of [116]-[121], wherein the exterior surface exhibits a diiodomethane contact angle of about 60° or more.

[124] The method of any one of [116]-[122], wherein the exterior surface exhibits a coefficient of friction of 0.25 or less.

[125] The method of any one of [116]-[124], wherein the surface-modifying layer comprises a polar surface energy of about 3 milliNewtons per meter (mN/m) or less.

[126] The method of any one of [116]-[125], wherein the surface-modifying layer comprises a total surface energy of about 30 milliNewtons per meter (mN/m) or less.

[127] The method of any one of [116]-[126], wherein a thickness of the surface-modifying layer is from 1 nanometer to 75 nanometers.

[128] The method of any one of [126]-[127], wherein the surface-modifying layer comprises a cheesecloth-abraded water contact angle of about 90° or more after being subjected to 200,000 cycles in a Cheesecloth Abrasion Test.

[129] The method of any one of [116]-[128], wherein the surface-modifying layer exhibits a rubber abrasion water contact angle of about 100° or more after being subjected to 5,000 cycles in a Rubber Abrasion Test.

[130] The method of any one of [116]-[129], further comprising an optical stack positioned between the surface-modifying layer and the substrate, wherein the optical stack comprises an anti-reflective coating, a band-pass filter coating, an edge neutral mirror, a beam splitter coating, a multi-layer high-reflectance coating, or an edge filter coating.

[131] The method of [130], wherein the optical stack has a thickness from about 10 nanometers to about 10 micrometers.

[132] The method of [131], wherein the thickness of the optical stack is from about 50 nanometers to about 5 micrometers.

[133] The method of [131], wherein the thickness of the optical stack is from about 50 nanometers to about 500 nanometers.

[134] The method of any one of [130]-[133], wherein the optical stack comprises a scratch resistant layer, and wherein the scratch resistant layer has a thickness from 0.05 micrometers to 3 micrometers.

[135] The method of any one of [130]-[134], wherein the coated article including the optical stack and the surface-modifying layer exhibits a hardness of 8 GigaPascals or greater measured by a Berkovich Indenter Hardness test.

[136] The method of [135], wherein the coated article including the optical stack and the surface-modifying layer exhibits the hardness of 12 GigaPascals or greater measured by the Berkovich Indenter Hardness test.

[137] The method of any one of [130]-[136], wherein the optical stack comprises one or more of a silicon-containing oxide, a silicon-containing nitride, a silicon-containing oxynitride, and $Nb_2O_5$.

[138] The method of any one of [123]-[130], wherein the optical stack comprises two or more layers with different refractive indices including at least a first low refractive index (low RI) layer and a second high refractive index (high RI) layer, an absolute value of a difference between the first low RI layer and the second high RI layer is 0.2 or more, and further wherein the optical stack comprises one or more of a silicon-containing oxide, a silicon-containing nitride, a silicon-containing oxynitride, and $Nb_2O$.

[139] The method of any one of [116]-[122], wherein the substrate is a textured substrate.

[140] The method of [139], wherein the coated article further comprises an anti-reflective coating or a gradient coating positioned between the anti-fingerprint coating and the textured substrate.

[141] The method of any one of [116]-[140], wherein the substrate comprises a glass-based material, a glass-ceramic material, or a ceramic-based material.

[142] The method according to [141], wherein the glass-based material, the glass-ceramic material, or the ceramic-based material is transparent, colored transparent, opaque, colored opaque, translucent, or colored translucent.

**Claims**

1. A coated article comprising:

   a substrate comprising a first major surface;
   a partial silica-like network disposed on the first major surface, the partial silica network having:

   a molar ratio of hydrogen to silicon of about 0.2 or more as determined by secondary-ion mass spectroscopy (SIMS); and
   a hydroxyl ratio of about 0.005 or more as determined using IR spectroscopy.

2. The coated article of claim 1, wherein the partial silica network has a hydroxyl ratio from about 0.005 to about 0.07 as determined using IR spectroscopy.

3. The coated article of any one of claims 1-2, wherein the partial silica network has a molar ratio of hydrogen to silicon from about 0.2 to about 0.45 as determined by secondary-ion mass spectroscopy (SIMS).

4. The coated article of any one of claims 1-3, wherein the substrate comprises a glass-based material, a glass-ceramic material, or a ceramic-based material.

5. The coated article of any one of claims 1-4, wherein the partial silica-like network is part of an anti-fingerprint coating comprising an exterior surface of the coated article, the anti-fingerprint coating comprising a thickness from about 10 nanometers to about 600 nanometers, the anti-fingerprint coating is fluorine-free, and the anti-fingerprint coating further comprises an alkyl silane at the exterior surface, wherein the alkyl silane comprises a $C_4$-$C_{34}$ alkyl group, and wherein the anti-fingerprint coating exhibits a water contact angle of about 100° or more.

6. The coated article of claim 5, wherein the anti-fingerprint coating exhibits an abraded water contact angle of about 90° after being abraded for 3,500 cycles in a Steel Wool Abrasion Test.

7. The coated article of any one of claims 5-6, wherein the anti-fingerprint coating exhibits a cheesecloth-abraded water contact angle of about 90° or more after being subjected to 200,000 cycles in a Cheesecloth Abrasion Test.

8. The coated article of any one of claims 5-7, wherein the anti-fingerprint coating exhibits a rubber abrasion water contact angle of about 100° or more after being subjected to 5,000 cycles in a Rubber Abrasion Test.

9. The coated article of any one of claims 5-8, wherein the exterior surface exhibits a coefficient of friction of 0.25 or less.

10. The coated article of any one of claims 5-9, further comprising a gradient coating comprising a refractive index gradient positioned between the anti-fingerprint coating and the substrate.

11. The coated article of any one of claims 5-9, further comprising an optical stack positioned between the anti-fingerprint coating and the substrate, wherein the optical stack comprises an anti-reflective coating, a band-pass filter coating, an edge neutral mirror, a beam splitter coating, a multi-layer high-reflectance coating, or an edge filter coating.

12. The coated article of any one of claims 1-4, wherein the partial silica-like network is part of a surface-modifying layer comprising an exterior surface of the coated article, the surface-modifying layer comprising a thickness from about 10 nanometers to about 600 nanometers, and wherein the surface-modifying layer further comprises an alkyl silane at the exterior surface.

13. The coated article of claim 12, wherein the surface-modifying layer is a fluorinated easy-to-clean coating or a fluorinated anti-fingerprint coating.

14. The coated article of claim 12, wherein the surface-modifying layer is a fluorine-free easy-to-clean coating or a fluorine-free anti-fingerprint coating.

15. A method of forming a coated article comprising:

disposing a solution over a first major surface of a substrate, the solution comprising a polysilazane or a polyhedral oligomeric silsesquioxane;
heating the solution at a temperature from about 150°C to about 400°C for a period of time from about 5 minutes to about 120 minutes; and
reacting material at the first major surface of the substrate with an alkyl silane to form an surface-modifying layer, the alkyl silane comprising 4 or more carbons.

FIG. 1

FIG. 2A

## FIG. 2B

## FIG. 2C

FIG. 3

FIG. 4

FIG. 5

FIG. 6

FIG. 8

FIG. 7

FIG. 9

EP 4 778 899 A2

FIG. 10

FIG. 11

FIG. 12

FIG. 13

FIG. 14

FIG. 15

EP 4 778 899 A2

FIG. 16

EP 4 778 899 A2

FIG. 17

EP 4 778 899 A2

FIG. 18

FIG. 20

FIG. 19

FIG. 21

FIG. 22

FIG. 23

FIG. 24

FIG. 25

FIG. 26

FIG. 27

FIG. 28

FIG. 29

FIG. 30

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63598993
- US 63431065
- US 8854623 B
- US 10948629 B
- US 20220011468 A
- WO 2022125846 A
- US 9328016 B
- US 9684097 B
- US 9703011 B
- US 9079802 B
- US 9726786 B
- US 10416352 B

**Non-patent literature cited in the description**

- **CHARLES KITTEL**. Introduction to Solid State Physics. John Wiley & Sons, Inc., 1996, 611-627
- **SMART** ; **MOORE**. Solid State Chemistry. Chapman & Hall University and Professional Division, 1992, 136-151
- **JAMES F. SHACKELFORD**. Introduction to Materials Science for Engineers. Pearson Prentice Hall, 2005, 404-418
- **C. LI** ; **T. ISHIKAWA**. Effective Surface Treatment on the Cover Glass for Auto-Interior Applications. *SID Symposium Digest of Technical Papers*, 2016, vol. 1 (36.4), 467
- **J. GOLLIER** ; **G.A. PIECH** ; **S.D. HART** ; **J.A. WEST** ; **H. HOVAGIMIAN** ; **E.M. KOSIK WILLIAMS** ; **A. STILLWELL** ; **J. FERWERDA**. Display Sparkle Measurement and Human Response. *SID Symposium Digest of Technical Papers*, 2013, vol. 44 (1)
- **J. FERWERDA** ; **A. STILLWELL** ; **H. HOVAGIMIAN** ; **E.M. KOSIK WILLIAMS**. Perception of sparkle in anti-glare display screen. *Journal of the SID*, 2014, vol. 22 (2)
- **OLIVER, W.C.** ; **PHARR, G. M.** An improved technique for determining hardness and elastic modulus using load and displacement sensing indentation experiments. *J. Mater. Res.*, 1992, vol. 7 (6), 1564-1583
- **OLIVER, W.C.** ; **PHARR, G.M.** Measurement of Hardness and Elastic Modulus by Instrument Indentation: Advances in Understanding and Refinements to Methodology. *J. Mater. Res.*, 2004, vol. 19 (1), 3-20
- **FISCHER-CRIPPS, A.C.** Critical Review of Analysis and Interpretation of Nanoindentation Test Data. *Surface & Coatings Technology*, 2006, vol. 200, 4153-4165
- **HAY, J.** ; **AGEE, P** ; **HERBERT, E.** *Continuous Stiffness measurement During Instrumented Indentation Testing, Experimental Techniques*, 2010, vol. 34 (3), 86-94
- **DEVINE**. *J. Non. Cryst. Sol.*, 1993, vol. 152, 50-58